# EUROPEAN PATENT APPLICATION

(11) **EP 1 804 251 A2**
(43) Date of publication of application: **04.07.2007**
(21) Application number: 07003530.8
(22) Date of filing: 29.06.1999
(51) Int. Cl.: G11C 27/00, G11C 16/04, G11C 11/56

(54) **Techniques for analog and mutilevel storage using integrated circuit technology**

(30) Priority: 30.06.1998 US 91326 P; 22.01.1999 US 116760 P
(62) Divisional of application: 99930821.6
(71) Applicant: SanDisk Corporation, Sunnyvale, CA 94089 (US)
(72) Inventor: Haeberli, Andreas M., 8623 Wetzikon (CH); Wong, Sau C., Hillsborough, CA 94010 (US); So, Hock C., Redwood City, CA 94065 (US); Wang, Cheng-Yuan Michael, San Jose, CA 95131 (US); Wong, Leon Sea Jiunn, Sunnyvale, CA 94086 (US); Werner, Carl W., San Jose, CA 95125 (US)
(74) Representative: Hitchcock, Esmond Antony

(57) **Abstract**

Information is provided in analog (402) or digital (DI) form and is stored in the memory cells (412) of an integrated circuit (400). The memory cells of the integrated circuit are non-volatile memory cells capable of analog or multilevel storage. The integrated circuit samples (230) the analog information and stores the samples in the memory cells (250) in an analog form. Typically, one cell holds one sample of the analog information. The sampling rate (625) is user-selectable, and an indication of the user's selection of the sampling stored within (661) the integrated circuit. Circuitry on the integrated circuit including charge pumps (3610, 3615, 3620) are adjusted (3423) to operate more effectively or efficiently depending on the supply voltage level (Vext). Level shifter circuitry (1810, 1815, 2430) on the integrated circuit is programmably adjustable. An internal signal path of the integrated circuit can be fully differential.

## Description

This application claims the benefit of U.S. provisional application number 60/091,326, filed June 30, 1998, and U.S. provisional application number 60/116,760, filed January 22, 1999, which are incorporated by reference.

### BACKGROUND OF THE INVENTION

The present invention relates to the field of information storage and retrieval using integrated circuit technology. More specifically, the present invention relates to techniques for storing (and retrieving) analog or digital data, or both, within an integrated circuit using multilevel nonvolatile cells.

Among the most important and pioneering innovations in history are devices, techniques, and mediums that have been devised to record and playback sights, sounds, actions, and other information. Many of these innovations have led to the rise and growth of the media and entertainment industries, and also the personal and consumer electronics industries.

For example, among the most notable inventions are Thomas Alva Edison's phonograph and record with which Edison recorded and played his first recording "Mary Had a Little Lamb." Other achievements in this field are the audio tape recorder, cassette tape recorder, motion picture, talking motion picture ("talkies"), video cassette recorder (VCR), compact disc (CD and CD-ROM), video disc, digital video disc (DVD), and many, many more of such innovations. In the present day, full-length motion pictures with stereo sound may be contained on a single optical disk.

Although these technologies have met with substantial success, there is a continuing desire to improve on the techniques, devices, mediums used to record information. For example, there is a need to provide techniques that provide dense storage of information. Denser storage facilitates storing information in a compact area, and provides a relatively long recording time.

There is a need to provide reliable and robust techniques. The stored reproduction should be a faithful reproduction of the original information. Despite repeated use, the stored reproduction should retain its original form, and also not degrade over time. Furthermore, the techniques should be compatible with and interface easily with present and emerging technologies in electronics and with devices facilitating electronic commerce (such as the Internet and World Wide Web).

Integrated circuit technology has been used to implement many electronic devices including computers, video recorders, digital cameras, microprocessors, DRAMs, SRAMs, Flash memory, and many others. As integrated technology continues to improve, it becomes practical to use this technology to record and playback sights, sounds, actions, and other information.

Data has typically been stored within integrated circuits using a digital or binary format. For applications where the input is analog, however, this requires conversion of signals to digital format, generally by an analog-to-digital (A/D) converter or similar means. And playback of analog signal from a digital storage format may require a digital-to-analog (D/A) converter or similar means: As can be appreciated, these conversions add complexity and extra expense to the entire procedure. Further, a conversion of the signal to digital form quantizes the signal and will lead to quantization noise in the reproduced signal.

Information such as sounds and voices, stereo and multichannel sounds, pictures, video, and others requires many bits of data storage. Storage of data in digital format may be inefficient because one bit (i.e., two different levels) of data is stored in a single memory cell. Further, it may be desirable to store an input signal using a sampling rate the user selects.

Therefore, techniques are needed for compactly storing (and retrieving) analog and digital information including sights, sounds, and actions using integrated circuit technology.

### SUMMARY OF THE INVENTION

The present invention provides techniques for the storage of information in a medium such as the memory cells of an integrated circuit, and also retrieval of information from the medium. In a particular embodiment, the present invention provides an integrated circuit with nonvolatile memory cells capable of multilevel or analog voltage level storage. The integrated circuit may store or record analog or digital information, or both.

An input signal or other data to be stored in the integrated circuit may be sampled at various sampling rates that are user selectable or user controllable. The sampling rate or sampling frequency may also be dynamically changed while operating the integrated circuit to allow a user to optimize for maximum recording duration or improved recording sound quality, as desired. This sampling frequency may be changed by configuring the integrated circuit. Some of the techniques of the present invention include a series of commands to the integrated circuit (e.g., by way of serial bits or an SPI interface to the integrated circuit); configuring memory cells, registers, combinatorial or sequential logic, or logic gates within the integrated circuit; or many other techniques to permit a user to select a sampling frequency and store the user's selection on the integrated circuit. This aspect of the present invention permits changing the sampling frequency while the integrated circuit is operating or resident on a system board, without the need to change components external to the integrated circuit (e.g., without the need of changing an external resistor). This feature of the present invention provides greater flexibility in the operation of the integrated circuit.

A plurality of digital bits may be stored in a single multilevel memory cell. Since more than one bit is stored in a memory cell, techniques of the present invention permit denser and more compact storage of digital data.

Further, real world information such as in the form of voices, sounds, images, videos, or actions, and combinations of these, may be converted to electrical signal equivalents using a transducer or other similar device. The resulting analog signal may be stored using the techniques of the present invention directly in the analog memory cells of the integrated circuit. The analog data may be stored without the need for an analog-to-digital (A/D) conversion. And, the present invention also provides techniques for playback or re-creation of the original signal from the stored data. The analog data may be retrieved without the need for a digital-to-analog (D/A) conversion.

In a specific embodiment, a technique of storing data in the integrated circuit includes filtering the input signal and sampling the input signal to obtain data samples. Each data sample is stored or programmed in a memory cell. The sampling rate may be user-selected to allow flexibility in the storage of information. For example, a slower sampling rate may be selected to obtain a lower quality copy of the original signal, but also permits storage of a longer duration of the original signal. On the other hand, if desirable, the sampling rate can be increased to obtain a greater fidelity reproduction, or to store a higher frequency analog signal. The signal path for the analog signal within the integrated signal may also be fully differential to allow for storage of a more precise copy of the original signal.

The present invention provides techniques for storing and retrieving analog or digital information from memory cells. In a specific embodiment, the memory cells are nonvolatile cells capable of analog or multilevel storage. Analog data and analog voltage levels are stored in the cells directly without the need for a conversion to digital form. Analog data is stored by altering a threshold voltage (VT) level of a memory cell to have a unique value representative of the analog data. A memory cell can also be used to store digital data. One or more digital bits can be stored in a single memory cell using a scheme consistent with the analog data storage.

Various different voltage levels are used to configure the memory cells. These voltage levels include high voltages, some of which may be at a level above the highest supply voltage for the integrated circuit. Some of these programming voltages are generated by a charge pump. These voltages are also shifted to a desired voltage level as needed to configure the memory cell to have a particular stored VT representative of the input data. The precision with which these programming voltages is obtained is important. Precise programming voltages are needed to ensure the memory cells are properly written, enhance the reliability and service life of the memory cells, and improve the yield of good die.

The data sample is programmed into a memory cell, for example, by adjusting the threshold voltage of a floating gate transistor such as a Flash or EEPROM transistor. The programming technique may use high voltages and level shifting circuitry. The data sample will be level shifted into a voltage range to facilitate programming of the memory cell. For an embodiment of the present invention, the level shifter circuitry is trimmable to allow for adjustments in the output voltage.

A technique of retrieving data stored in the memory cells of the present invention is an inverse of the storage technique. A voltage ramp circuit and sense amplifier is be used to evaluate and determine the threshold voltage of a memory cell. This threshold voltage is then shifted back to the voltage range of the original signal for playback. By playing back the level-shifted threshold voltages for a plurality of memory cells at the original sampling rate, the original signal is re-created.

An analog or digital signal can be stored in an integrated circuit using the techniques of the present invention. Information is more densely stored in an analog or multilevel memory cell. A/D and D/A conversion circuitry is not required, which saves board space and integrated circuit area. When data is stored in digital form, digital compression is used to obtain denser storage. However, because these digital compression techniques (e.g., lossy compression) do not allow an accurate reproduction of the original, there can be artifacts in the playback signal that are not present when stored in analog form. Thus, storing the data in analog form permits greater fidelity in playback, especially without the artifacts due to digital compression.

If even more compact storage of data is desirable, however, the techniques of the present invention can be combined with analog or digital compression techniques to provide for even more storage of information. Digital compression techniques can be used with the multilevel storage scheme of the present invention to provide even denser storage. For example, MP3 format data can be stored using multilevel memory cells of the present invention. MP3 format refers to digitally compressed data stored in an MPEG 1 layer 3 format. MP3 is a popular format for storing and transferring audio and music files, especially over the Internet.

In a specific embodiment of the present invention, the present invention provides a fully integrated single-chip recording and playback device with a long recording duration. Analog signals are directly stored in the integrated circuit without the need for an analog-to-digital conversion. In a specific application of voice recording, it is desirable to have good sound quality in the reproduced signal. A flexible architecture is provided, so recording quality and recording duration may be adjusted as a user desires. The integrated recording device also retains its recorded information indefinitely, even when power is removed from the integrated circuit. The form factor of the present invention is compact and can be used in many applications where other devices or techniques are not suitable.

Level shifter circuits of the present invention are used to generate an output voltage that is above the input voltage by an offset voltage value. The magnitude of this offset voltage or the relationship between the input and output voltages of the level shifter circuit is adjustable or programmably selectable. Adjustment can be made after the integrated circuits is fabricated and packaged. One technique of making adjustments is to configure bits of data in the integrated circuit to indicate the offset voltage or other parameters. For example, these configuration bits can be implemented using latches, flip-flops, registers, memory cells, and other type of storage elements.

In another embodiment, present invention is an integrated circuit including a programmable level shifter circuit receiving a sample of an analog signal input to the integrated circuit. The level shifter circuit generates a level shifter voltage output above a voltage of the sample by an offset voltage, where the offset voltage is programmably selectable. The integrated circuit further includes an array of analog memory cells. The level shifter voltage output is connected to a memory cell to configure the memory cell to store the sample.

In a further embodiment, an integrated circuit of the present invention includes a programmable level shifter with an operational amplifier generating a level shifter output. An offset voltage between the level shifter output and an analog input depends on a value of capacitance connected between the analog input and an operational amplifier input. The value of the capacitance is programmably selectable. The integrated circuit includes an array of memory cells. The level shifter output is connected to configure a memory cell to store the analog input.

Moreover, the present invention includes a method of operating an integrated circuit. An analog signal input is provided. A sample of the analog signal input is taken. A first voltage above the sample input by a first offset value is generated. A second voltage above the sample by a second offset value is generated. A node of a memory cell is pulsed using the first voltage. A threshold voltage of the memory cell is evaluated using the second voltage, where the second voltage is connected to a control electrode of the memory cell. The memory cell is pulsed and evaluated until the threshold voltage of the memory cell is at a target value.

Another method of the present invention includes determining a stored threshold voltage of a memory cell by varying a voltage at a control electrode of the memory cell until the memory cell changes from conducting a first state to a second state. A playback output voltage, which is below the stored threshold voltage by an offset value, is generated by the using the stored threshold voltage.

Changes in supply voltage or other parameters may affect the programming circuits and the voltage levels that are generated. In an embodiment of the present invention, the integrated circuit detects the voltage level of the supply voltage to the integrated circuit. Circuity on the integrated circuit such as the charge pump circuity adjusts to operate more effectively or efficiently at the voltage level of the supply voltage.

In an embodiment, a technique of the present invention includes detecting an external voltage to the integrated circuit to determine whether the external voltage is above or below a threshold value. When the external voltage is below the threshold value, a programming voltage is generated using a first number of charge pump stages. When the external voltage is above the threshold value, the programming voltage is generated using a second number of charge pump stages, where the second number of charge pump stages is less than the first number of charge pump stages.

In another embodiment, a technique of the present invention includes detecting an external voltage to the integrated circuit to determine whether the external voltage is above or below a first threshold level and above or below a second threshold level, where the second threshold level is above the first threshold level. When the external voltage is below the first threshold level, a programming voltage is generated using a first number of charge pump stages. When the external voltage is above the first threshold level and below the second threshold level, the programming voltage is generated using a second number of charge pump stages. When the external voltage is above the second threshold level, the programming voltage is generated using a third number of charge pump stages, where the first number of charge pump stages is greater than the second number of charge pump stages, and the second number of charge pump stages is greater than the third number of charge pump stages.

The present invention includes an integrated circuit with a first voltage detect circuit of a first threshold level, a second voltage detect circuit of a second threshold level, and a third voltage detect circuit of a third threshold level. A logic circuit, connected to outputs of the first, second, and third voltage detect circuits, generates a number of enable outputs. A charge pump circuit includes a number of stages, and based on the enable outputs, a number of stages of the charge pump are enabled.

In a specific embodiment, a voltage detect circuit includes a first transistor connected between a first voltage detect output node and first terminals of a first and a second capacitor. A control electrode of the first transistor is connected to a clock signal. A second transistor is connected between the first voltage detect output node and the first terminals of the first and second capacitors. A control electrode of the second transistor is connected to the clock signal. A first switch circuit connected between an external voltage input and a second terminal of the first capacitor. A second switch circuit is connected between a reference voltage input and a second terminal of the second capacitor.

In an embodiment, the integrated circuit memory has an internal signal path that is differential. This enhances the precision with which the signal is stored in the memory cells. Among other advantages a fully differential signal pass has inherently an improved common-mode noise rejection. Furthermore, the dynamic range is doubled which may lead to a higher signal to noise ratio and is suitable for low voltage applications. To store analog information the analog input to the integrated circuit has a positive (+) and negative (-) input. The analog input is connected to a preamplifier to amplify the input signal. The preamplifier is fully differential and has a positive and negative output. The preamplifier output is connected to a low pass filter. The filter has positive and negative outputs. These positive and negative outputs are connected to level shifter circuitry. The level shifter performs a sample and hold operation, an amplification, a voltage shift, and a differential to single ended conversion.

The stored analog information is retrieved by means of a slow ramp circuit. The playback level shifter takes the single-ended output of the slow ramp circuit and performs a voltage shift, an attenuation, and a single ended to fully differential conversion. The differential playback level shifter output is connected to a low pass filter, which is fully differential. The low pass filter has positive and negative outputs. These are connected to an output buffer or amplifier to amplify the signal. The output amplifier is also fully differential and provides positive and negative outputs.

The integrated circuit has a master-slave biasing scheme. A master bias generator generates a master bias voltage that is connected to a number of slave bias generators. This master bias voltage may be based on a bandgap voltage reference. The slave bias generators use the master bias voltage to generate a number of slave bias voltages. These slave bias voltages are connected to the various components of the integrated circuit. This scheme of connecting different slave bias generators to different components improve the isolation of the bias voltages among the components. It is less likely that components which couple noise into its slave bias generator will affect the other components connected to different slave bias generators. Also, if a component of the integrated circuit is not being used, its slave bias generator can be disabled to save power.

The integrated circuit has a squelch circuit to attenuate its output signal when an input to the squelch circuit is below threshold level. The squelch circuit essentially greatly attenuates background noise. In effect, there will be a greater signal to noise ratio at the output of the integrated circuit.

In an embodiment, the invention is an integrated circuit including an analog data differential input and a preamplifier circuit. The preamplifier circuit is connected to amplify an analog signal at the analog data differential input with a first gain, where an amplified output signal is provided at a first differential output of the preamplifier circuit. A low pass filter circuit is connected to the preamplifier differential output. The low pass filter circuit provides samples of the analog signal at a second differential output. A first level shifter circuit is connected to the second differential output, where the first level shifter circuit provides a first level shifter output signal at a first offset voltage above a level of a sample at the second differential output. The first level shifter output is connected to an array of analog memory cells.

In another embodiment, the invention is an integrated circuit including an array of analog memory cells and a ramp circuit connected to a memory cell of the array. The ramp circuit determines a stored threshold voltage of the memory cell. A playback level shifter is connected to a ramp output of the ramp circuit, where the playback level shifter provides a first differential output coupled to an output of the integrated circuit.

The present invention provides techniques to implement an integrated circuit memory for storing digital and analog data. Analog information is provided at an analog input and sampled. Each analog sample is stored in one or more memory cells in analog form. The memory cells of the present invention provide analog or multilevel storage of data. These memory cells may be floating gate memory cells, which are nonvolatile. The sampling frequency can be fixed or user-selectable. Digital data is provided at an digital input and stored into the memory cells of the integrated circuit. The same memory cell used for analog information storage on one occasion may be used for digital information storage on another occasion. Analog data may be retrieved from the memory cells and output at an analog output. Digital information may be received from the memory cells and output at a digital output.

In one embodiment, the invention is a method of storing information in a memory. An analog signal is provided at an analog signal input. A digital data is provided at a digital signal input. The analog signal input is sampled at a sampling frequency. This sampling frequency can be fixed by the design on the integrated circuit or user-selectable. The user can select the sampling frequency by changing an external device to the integrated circuit, such as a resistor or capacitor, or by loading into the device an indication (e.g., a series of bits) of the desired frequency. Samples of the analog signal are stored in an array of memory cells, where a memory cell holds one sample of the analog signal. The digital data is stored in the array of memory cells, wherein a memory cell holds at least one bit of the digital data. Each memory cell may store two, three, four, five, six, seven, eight, or more digital bits of data. The invention provides a consistent scheme for storing both analog and digital data.

In another embodiment, the invention is an integrated circuit including an array of memory cells and a write circuit to store information provided at an analog input and a digital input of the integrated circuit into the memory cells. The information provided at the analog input is in an analog form and at the digital input is in digital form. A multiplexer selectively couples the analog or the digital input to a common write circuit, to convert the input to a precise threshold voltage and store into one memory cell.

A further embodiment of the present invention is an integrated circuit including a plurality of memory cells and a write circuit connected to the memory cells. A read circuit will determine a threshold voltage stored in individual memory cells, and will provide an analog equivalent of the stored threshold voltage at an analog output or will provide a digital equivalent of the stored threshold voltage at a digital output. Individual memory cells are configured using the common write circuit to store a precise threshold voltage level based on the sampled input level. In a specific implementation, the read circuit determines whether a threshold voltage stored in a memory cell is above or below a reference level, and provides to the digital output a first logic level when the stored threshold voltage is below the reference level and a second logic level when the stored threshold voltage is above the reference level.

In a further embodiment, the present invention is an integrated circuit including an array of multilevel memory cells and a write circuit connected to store data in the array of multilevel memory cells. A digital reference generator receives digital data and converts the digital data into an analog equivalent form. The analog equivalent form is provided to the write circuit. In a specific implementation, the digital reference generator includes a bias voltage generator generating a number of bias voltages. The digital reference generator also includes a digital data input circuit to generate the analog equivalent form of the digital data by selecting combinations of the bias voltages.

The invention also includes a method of storing information in a memory including providing an analog signal at an analog signal input and providing digital data at a digital signal input. The analog signal input is sampled at a sampling frequency, where may be user-selectable. Samples of the analog signal are stored in an array of memory cells, where a memory cell holds at least one sample of the analog signal. The digital data is stored in the array of memory cells, where a memory cell holds at least a bit of the digital data. The digital data is stored by first erasing a sector of memory cells and then writing the digital data in the sector of memory cells. A digital value is written in each memory cell of the sector not written with the digital data. This ensures memory cells do not subject to an overerase condition. A sector, sometimes called page, of memory cells may be any number of memory cell (e.g., 3K cells). The memory cells in a sector will usually have a common source line, or erase node, in order to erase the contents of the whole sector of cells together.

In another aspect, the present invention includes the use of an integrated circuit to store both analog signals and digital data in the same analog or multilevel memory cells of the integrated circuit, where the sampling frequency used to sample the analog signals can be user-selectable. The invention includes the use of requiring writing of every memory cell in a sector of an integrated circuit with a value in order to prevent overerase of the memory cells in the sector. The invention also includes the use of a digital reference generator to generate a analog equivalent to a digital quantity to be stored, and storing this analog equivalent into memory cells of an integrated circuit. In a further aspect of the invention, the use of an analog memory integrated circuit as a nonvolatile multilevel digital memory.

Other objects, features, and advantages of the present invention will become apparent upon consideration of the following detailed description and the accompanying drawings, in which like reference designations represent like features throughout the figures.

### BRIEF DESCRIPTION OF THE DRAWINGS

Figure 1 shows an electronic system in which techniques according to the present invention may be used;
Figure 2 shows an overall flow diagram of a technique for storing or "recording" an analog signal input into a memory cell;
Figure 3 shows a flow diagram of a technique for reproducing or "playing back" an analog signal stored in a memory cell;
Figure 4 shows a diagram of an overall block diagram of an integrated circuit of the present invention;
Figure 5 shows a diagram of an integrated circuit of the present invention incorporating digital-to-analog converter and analog-to-digital converter circuits;
Figure 6 shows a block diagram of circuitry for implementing a user selectable sampling frequency;
Figure 7 shows a diagram of clock generation circuitry;
Figure 8 shows a circuit diagram for a prescaler circuit;
Figure 9 shows a circuit diagram for internal clock divider circuitry;
Figure 10 shows a delay locked loop (DLL) circuit for clock generation;
Figure 11 shows waveforms for a delay locked loop circuit;
Figure 12 shows a circuit diagram for a phase detector for a DLL;
Figure 13 shows a circuit diagram of a charge pump for a DLL;
Figure 14 shows a number of delay cells arranged in series;
Figure 15 shows a circuitry for one delay cell;
Figure 16 shows circuitry for the first stage of the combinatorial logic circuit;
Figure 17 shows circuitry for the second stage of the combinatorial logic circuit;
Figure 18 shows a feedback multiplexer;
Figure 19 shows a phase locked loop circuit for the clock generation circuitry of the present invention;
Figure 20 shows a specific implementation of a preamplifier;
Figure 21 shows a more detailed diagram of the preamplifier of Figure 20;
Figure 22 shows a block diagram of a low pass filter;
Figure 23 shows a more detailed diagram of a low pass filter;
Figure 24 shows an implementation of a clock buffer;
Figure 25 shows an implementation of a switch;
Figure 26 shows a diagram of an arrangement of a master-slave biasing scheme;
Figure 27 shows circuitry that may be used to implement the master bias voltage or other bias voltages for an integrated circuit of the present invention;
Figure 28 shows a more detailed diagram of a slave bias circuit;
Figure 29 shows a diagram of a memory array;
Figure 30 shows a diagram of an organization of a memory array;
Figure 31 shows a plurality of memory cells sharing a common source line;
Figure 32 shows circuitry for writing information in a memory cell;
Figure 33 shows a waveform of the programming voltage during programming;
Figure 34 shows a timing diagram illustrating the operation of the write circuitry;
Figure 35 shows a simplified schematic of a combination voltage level shifter and sample and hold circuit of the present invention;
Figure 36 shows a timing diagram of clocks for use with the circuitry in Figure 35;
Figure 37 shows a graph of the relationship between the programming and target VT voltage from a level shifter circuit;
Figure 38 shows an implementation for a trimmable level shifter circuit;
Figure 39 shows a more detailed circuit diagram for a switch for a trimmable capacitor of the present invention;
Figure 40 shows a simplified schematic of circuitry for retrieving information from the memory cells;
Figure 41 shows a timing diagram illustrating the operation of the read circuitry;
Figure 42 shows a schematic of an implementation of a playback level shifter circuit;
Figure 43 shows a simplified schematic of an implementation of the playback level shifter circuit, also including sample and hold circuitry;
Figure 44 shows circuitry for producing the playback signal, including a squelch circuit, at an output of an integrated circuit;
Figure 45 shows a diagram of an implementation of squelch circuit;
Figure 46 shows a signal diagram of an operation of the squelch circuit of Figure 45;
Figure 47 shows a diagram of an implementation of circuitry a power supply level detection;
Figure 48 shows a state diagram of some operational modes of the present invention.
Figure 49 shows a diagram of a power supply level detection circuit;
Figure 50 shows a diagram of a charge pump circuit;
Figure 51 shows a diagram of an implementation of a stage of a charge pump;
Figure 52 shows a plurality of trim bits;
Figure 53 shows a sensing and latch circuitry for a trim bit;
Figure 54 shows a multiplexer circuit for a trim bit;
Figure 55 shows a diagram of inputs and outputs to the integrated circuit;
Figure 56 shows a diagram of the analog and digital storage and retrieval circuitry;
Figure 57 shows an implementation of a digital storage input path;
Figure 58 shows another implementation of the digital storage input path;
Figure 59 shows an implementation of a digital storage output path;
Figure 60 shows another implementation of a digital storage output path;
Figure 61 shows a digital reference generator circuit; and
Figure 62 shows a common mode feedback circuit for digital reference generator;
Figure 63 shows an implementation of a digital reference generator circuit for n digital data bits; and
Figure 64 shows another implementation of a digital reference generator circuit.

### DETAILED DESCRIPTION

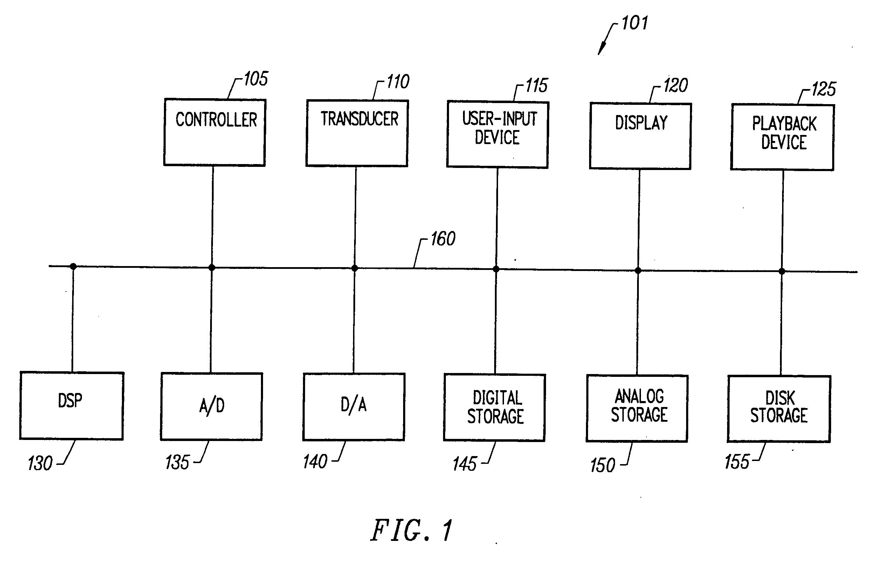

Figure 1 shows an electronic system in which techniques according to the present invention may be used. An integrated circuit according to the present invention may be used in many market segments including, to name a few, the communications market, medical market, consumer market, and industrial market. Some applications of such devices include cellular phones, telephone answer machines, mobile radios, telephone announcement systems, pagers and voice pagers, medical monitoring equipment, cash registers, bar code readers, vending machines, security systems, instrumentations, automobiles, interactive media, cameras, calculators, pocket recorders, recordable postcards and greeting cards, toys and games, watches and clocks, consumer recording media, video players and recorders, imaging, personal digital assistants (PDAs), palm-sized PC, desktop and notebook computers, portable electronic commerce devices, internet appliances, electronic information storage media, and many other applications.

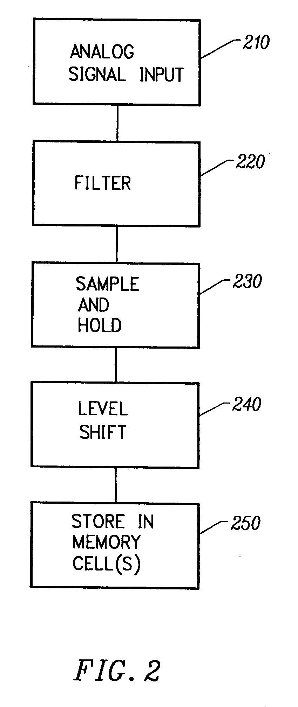

Figure 2 shows an overall flow diagram of a technique for storing or "recording" an analog signal input into a memory cell. An analog signal input 210 is provided. This analog signal may be amplified or otherwise processed, if desired or needed. In step 220, the signal is filtered using a low pass or bandpass filter to filter out or eliminate components of the signal which are not of interest. This can help prevent aliasing. Multiple stages of filtering can be used.

In step 230, the signal is sampled. Sampling the signal breaks the signal into a series of discrete analog values or samples. In order to prevent aliasing, the signal should be sampled at a rate sufficient to prevent aliasing errors. According to Nyquist's Sampling Theorem, the signal should be sampled at a rate at least twice the highest frequency component of the signal output from the filter to allow for a faithful reproduction of the original signal. Further, it is desirable to sample the signal at a much higher rate in order to obtain better bandwidth, and hence, a better quality reproduction.

A sampled data point is "held" for sufficient time to process this data point. The sampled data point may also be held while determining the next sampled data point. In a step 240, for each sampled data point, the analog value is level shifted into a voltage range suitable to facilitate storage of the information in a memory cell. For example, an analog input in the range from about 0 volts to about 2.5 volts may be shifted to a range from about 3 volts to about 5.5 volts.

In a step 250, the sampled data point is stored into a memory cell.

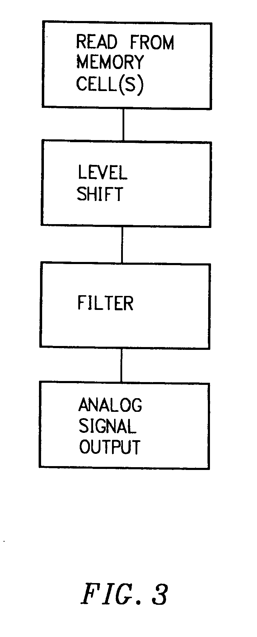

Figure 3 shows a flow diagram of a technique for reproducing or "playing back" an analog signal stored in a memory cell. The playback process is essentially an inverse of the recording process. There may also be amplification or other processing of the output signal.

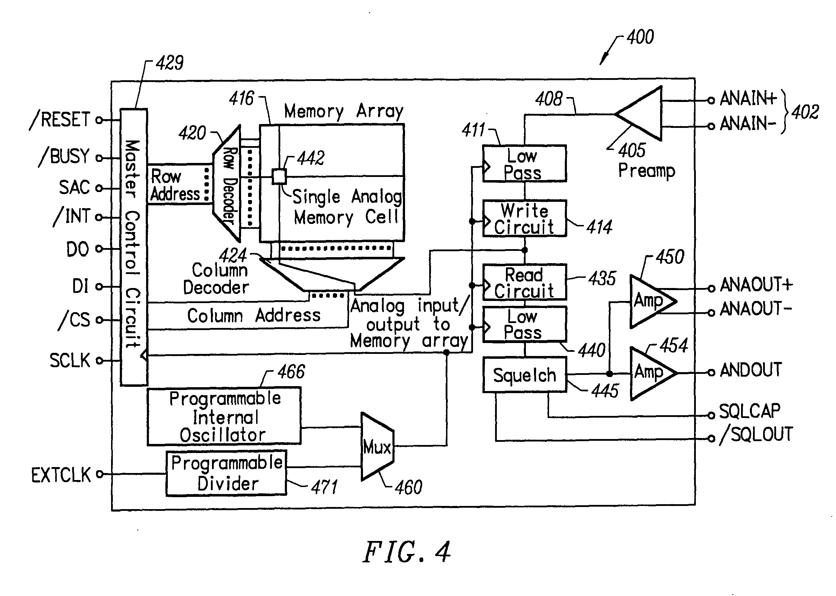

Figure 4A shows a diagram of an overall block diagram of an integrated circuit 400 of the present invention. This integrated circuit stores information in the analog or multilevel memory cells of the integrated circuit. The information may be provided in analog or digital form. An analog signal 402 to be stored is differentially input at ANAIN+ and ANAIN- inputs. Other embodiments may have a single-ended input instead of a differential input. A differential input provides greater accuracy when recording the signal. The input signal is amplified using a preamplifier 405. For example, in one implementation, the preamplifier has a gain of about 25 decibels. The gain can be user-selected so the user can match the preamplification needed or desired for a particular input signal.

An output 408 of preamplifier 405 is also fully differential. A single-ended output can also be provided in addition or instead of the differential output. Output 408 is passed to a low pass filter 411. Low pass filter 411 can be implemented using a sampled data filter, where the output of filter 411 will be the samples of the input signal.

Using a write circuit 414, each sampled data point is stored in a memory cell 412. Memory cells such as DRAM, SRAM, EEPROM, EPROM, and Flash cells typically only store or can represent two possible logic levels. In a digital system, these levels would represent a logic low or a logic high. To store a sampled data point in a digital memory cell, the sampled data point is converted into a binary or digital representation. For example, if the sampled data point were converted to a value having 256 different discrete levels, then 8 binary memory cells (i.e., 2⁸) are required. However, storing a sampled data signal is inefficient because numerous memory cells are used to store only one sample.

In the present invention, however, the sampled data point is stored in a single analog or multilevel memory cell. This permits much greater density of storage compared to the binary memory cell. Using the memory cell techniques of the present invention, integrated circuits can be designed to store data more compactly than integrated circuits using binary memory cells. Techniques of the present invention are also applicable to allow a single digital memory cell to store multiple digital bits by using multilevel storage.

The memory cell of the present invention may be referred as an analog or multilevel memory cell since the memory cell can store a relatively large range of analog and digital values. The analog values can be thought of as having discrete steps such as, for example, 10 millivolt steps. In other embodiments, the analog values are essentially continuous. Although an analog memory cell can store an analog (or digital value), a degree of precision for such a memory cell can be quantified by the number of discrete steps the memory cell can store. Higher resolutions for an individual memory cell are limited by the process technology. Such factors including memory cell's charge, the charge on an electron, leakage to and from the memory cell, and accuracy of other support circuitry are important considerations.

Analog and digital storage of data is described in U.S. patents 5,694,356, 5,680,341, 5,745,409, 5,748,534, 5,748,533, 5,818,757, and U.S. patent application 09/324,902, filed June 2, 1999, which are all incorporated by reference.

In a specific embodiment of the present invention, the analog or multilevel memory cells are implemented using Flash or EEPROM cells. Flash or EEPROM cells are memory transistors with a floating gate, and may be referred to as a floating gate device. Flash and EEPROM cells are nonvolatile. Once programmed or configured, these floating gate devices will hold their data even when power is removed. The Flash or EEPROM transistor can be n-channel or p-channel; n-channel floating gate devices are presently more widely available.

Flash and EEPROM cells are configured or programmed by altering a threshold voltage or VT of the device. Floating gate devices can have a range of stored VTs. This range of stored VTs is used to provide analog or multilevel storage. Flash and EEPROM cells can also be erased; the VTs are returned to an initialized state.

In an embodiment of the invention, the degree of precision for storing information in a memory cell is selected by the design to be appropriate for a particular application. The degree of precision can be a user-selectable option. For example, when storing voice signals, relatively less precision is needed since the human voice is understandable and recognizable when less resolution is employed. For human voice, the memory cell can be designed to store about 2⁸ or 256 levels. For some applications, such as high-resolution color images, photographs, and video, greater precision is typically needed for an accurate reproduction. The memory cell or multiple memory cells used in conjunction with another can be designed to store effectively 2²⁴ or 16,777,216 levels in order to produce the colors accurately. The memory cell or cells will effectively store 2¹⁶ or 65,536 levels if less color accuracy is acceptable.

In short, the memory cell or multiple memory cells of the present invention can be designed to store any number of data levels, for example, 2⁸, 2¹⁰, and 2¹² or more levels. Other numbers of levels are also possible. A greater number of levels permits greater compression of data into a fewer number of memory cells. The greater number of levels each memory cell is capable of storing, the more data that can be stored in an array of these memory cells. The ultimate precision of the memory cell available with the analog memory cell depends on many factors such as the process technology used and stability and speed of the circuitry used to store and resolve the different levels.

Using present technology, it is practical to implement an integrated circuit according to the present invention having memory cells, each capable of storing about 2⁸ levels. A memory cell with 8 bits of resolution is readily manufacturable and can be easily interfaced with and processed using the circuitry of the present invention. Further, a memory cell with 8-bit resolution provides adequate resolution for recording and playback of voice data with a relatively high fidelity. As technology further improves, the present invention may be used to provide an interface with memory cells having greater than 8-bit resolution.

Furthermore, instead of storing a data sample of the input signal into a single cell, multiple cells of the present invention can be combined to increase the resolution. Additional cells are added until the desired resolution is achieved. Generally the relationship for providing greater resolution by using multiple cells is given by 2^{n*m}, where n is the number of memory cells and m is the bit resolution per cell. For example, three cells having 10-bit resolution each can be combined to have an effective resolution of 30 bits. The number of bits resolution for multiple 10-bit cells is given by the following relationship, 2 ^{n*10}, where n is the number of cells. As a further example, for three cells each having 8-bit resolution, the combined effective resolution is 24 bits (i.e., 2^{n*8} where n is 3). This particular implementation may be useful for imaging applications, where each cell corresponds to the intensity of one of the red (R), green (G), and blue (B) parameters.

Although sometimes referred to as an analog memory cell, the memory cell of the present invention can also be used for applications other than analog applications. For analog applications, analog values are stored into the memory cell without the need for an analog-to-digital converter. The memory cell can also be used in digital applications. The analog memory cell capable of storing multiple or continuous levels is equally well suited for digital and analog applications. For digital applications, the techniques of the present invention will permit much more compact storage of digital data. For example, the present invention can be used to implement nonvolatile mass storage PCMCIA or PC Cards. This permits an analog memory integrated circuit to be relatively compact. For digital applications, discrete levels may be stored, and an A/D and D/A converter may be utilized. Other techniques for storing and retrieving data from analog memory cells are described in U.S. patents 5,638,320, 5,687,115, 5,694,356, and 5,748,533, which are incorporated by reference.

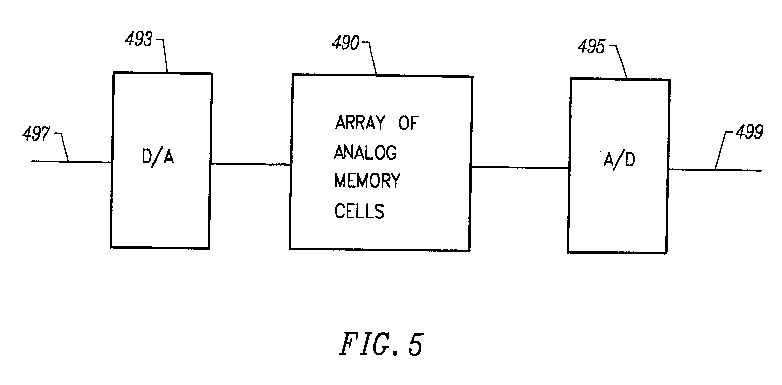

Figure 5 shows an example of a portion of an integrated circuit of the present invention for storing digital information. The circuitry of the integrated circuitry is similar to what is shown in Figure 4. In addition to an array 490 of analog memory cells for storing digital or analog information, there is a D/A converter 493 and A/D converter 495. To store digital data, D/A converter 493 takes digital information on input 497 and converts this to multilevel or analog information for storage in array 490. To retrieve digital data, A/D converter 495 takes the multilevel or analog information stored in array 490 and converts it to digital data on output 499. Input 497 may be in the form of parallel or serial bits of data. Output 499 can be in the form of parallel or serial bits of data.

Returning to Figure 4, memory cells are organized in an array 416 of memory cells having rows and columns. In a specific embodiment, there are about 1.92 million analog or multilevel memory cells. With 1.92 million memory cells, this will store about eight minutes of voice data at a 4 kilohertz sampling frequency. An integrated circuit embodiment with 1.92 million memory cells is a practical implementation of the present invention using present technology. Clearly, an integrated circuit having fewer than 1.92 million memory cells is also be easily manufacturable. For example, a reduced-size version of the present invention having 960K memory cells provides half the data storage capacity. Given the size of the memory cell of the present invention and the desire to provide a large amount of storage at reasonable cost, an integrated circuit with 1.92 million analog memory cells (e.g., fabricated using Flash technology) is practical. As technology improves and memory transistor sizes decrease, it will become possible, and practical, to manufacture integrated circuits having greater than 1.92 million memory cells. Rows and columns are addressable by row and column addresses and a row decoder 420 and column decoder 424. A master control circuit 429 controls operation of the integrated circuit. External or off-chip connections to the master control circuit are made via pins /RESET, BUSY, SAC, /INT, DO, DI, /CS, and SCLK.

Operation of the integrated circuit is controlled by the master control circuit. Commands or instructions are input to the master control circuit, which will then perform the desired function. Some of the functions the integrated circuit provides includes record, playback, cue, and erase. In this implementation, the command and data for the command is clocked into the device in serial form using the DI and SCLK pins. If there is output data, it is clocked out, also in serial form, through DO. The command interface to the integrated circuit is referred to as a serial port interface (SPI). The commands are referred to as SPI commands. More details of the SPI interface may be found in U.S. provisional application 60/091,326.

Information stored in array 416 is read or played back using a read circuit 435. Read circuit 435 is functionally the inverse of write circuit 414. An output of the read circuit has a one-to-one correspondence to the original analog value that was stored in the memory cell using the write circuit. The output is passed through a low pass filter 440 to reconstruct the original waveform. If recording and playback do not occur at the same time, low pass filter 440 and low pass filter 411 may be implemented using the same on-chip circuit to reduce die size. Multiplexers will select whether the low pass filter is coupled to the recording or the playback circuitry. This reduces the die size since the same circuitry is used for these two purposes. Another benefit of using the same filter is there will be better matching of the electrical characteristics for both recording and playback.

In the particular embodiment of Figure 4, there is a squelch circuit 445 before an AUDOUT pin or differential ANAOUT+ and ANAOUT- pins. The squelch circuit will give the user an impression of a greater signal-to-noise ratio at the output, much like the squelch function of radio receivers or some two-way radios. The user sets a particular delay by placing a particular size of capacitor at a SQLCAP input. When the signal input to the squelch circuit is above a certain threshold level which is set by squelch circuit 445, the stored signal is output at AUDOUT or ANAOUT+ and ANAOUT-. However, if the signal drops below this squelch threshold level for a period of time set by the value of the capacitor, the output is a greatly attenuated version of the originally stored signal. The squelch feature can be used to reduce undesirable background noise from the output. Although a squelch feature is provided in Figure 4, other embodiments of the invention may not include this squelch feature and the associated circuitry.

An output amplifier 450 is connected to provide an amplified differential output of the stored signal at ANAOUT+ and ANAOUT- pins. An output amplifier 454 provides a single-ended output of the stored signal at an AUDOUT pin. In a specific embodiment, when a signal is being recorded at inputs ANAIN+ and ANAIN-, the signal may be monitored at ANAOUT+ and ANAOUT- and AUDOUT pins. This monitor feature can be used by a user to ensure the circuitry is operating properly.

A clock for low pass filter 411, write circuit 414, read circuit 435, and low pass filter 440, is selected using a multiplexer 460. The clock is either internally generated or provided by an external source. This clock provides the sampling frequency at which the analog input is sampled. The clock is supplied from a programmable internal oscillator 466 or a programmable divider 471, which is connected to an external clock source EXTCLK. The SCLK input may also be selected to provide the clock during operations such as testing. In a specific embodiment, programmable internal clock 466 is implemented using a relaxation oscillator and a delay locked loop (DLL) frequency synthesizer. However, there are many other techniques to implement the programmable internal clock including a delay, a phase locked loop (PLL), phase frequency loop (PFL), crystal oscillator, and frequency synthesizer.

The clock from multiplexer 460 is used to control the sampling frequency of the input waveform. Internal oscillator 466 generates a range of clock frequencies. For example, internal oscillator may be used to generate a clock frequency from about 4 kilohertz to about 8 kilohertz. Depending on the desired application, the frequency ranges may vary. The internal oscillator may generate frequencies from the hundreds of kilohertz to the megahertz ranges. The user can select the frequency of the internal oscillator. To permit even greater flexibility, an external clock source input through the EXTCLK pin can be used instead of the internal oscillator. This external clock source is frequency divided using programmable divider 471. The user can change the divider ratio to change the frequency of the clock without changing the EXTCLK.

Therefore, in the present invention, the user can select the sampling frequency. In a specific embodiment of the present invention, the user can select a 4 kilohertz, 5.3 kilohertz, 6.4 kilohertz, or 8 kilohertz sampling frequency. The internal oscillator is programmable to provide a range of sampling frequencies. And, an even greater range of sampling frequencies is available by having the user supply an external clock. This permits the user to control the bandwidth of the signal that is recorded. If the user desires greater bandwidth, the user will select a higher sampling frequency. A higher sampling frequency also means there will be a greater number of sampled data points, which will require a greater number of memory cells for storage for a given duration of a signal.

The programmable internal frequency generator and provision for an external clock source are features of the present invention. The user can vary the sampling rate as desired, and as can be appreciated, this provides greater flexibility than a integrated circuit having a fixed sampling frequency. In an integrated circuit that only provides a fixed sampling frequency, when different sampling frequencies are desired by customers, there would have to be different versions of the same integrated circuit. The user-selectable sampling rate permits the same integrated circuit to be used in various applications. The manufacturer of the integrated circuit does not need to fabricate different parts for different customers and applications. And, the customer or user does not need to stock different parts having different sampling frequencies.

An aspect of the present invention is that as the sampling is increased, the integrated circuit will record at a higher bandwidth, but the maximum duration of the recording will be less. If the user selects a sampling rate of 2000 samples per second, this gives a recording time of about 960 seconds or 16 minutes of recording time for 1.92 million cells. If the user selects a sampling rate of 8000 samples per second, this results in about 240 seconds or 4 minutes of recording time. Using a sampling rate of 8 kilohertz will provide a higher quality recording of the original signal than the case when using a 4 kilohertz sampling rate. See table B below for more examples.

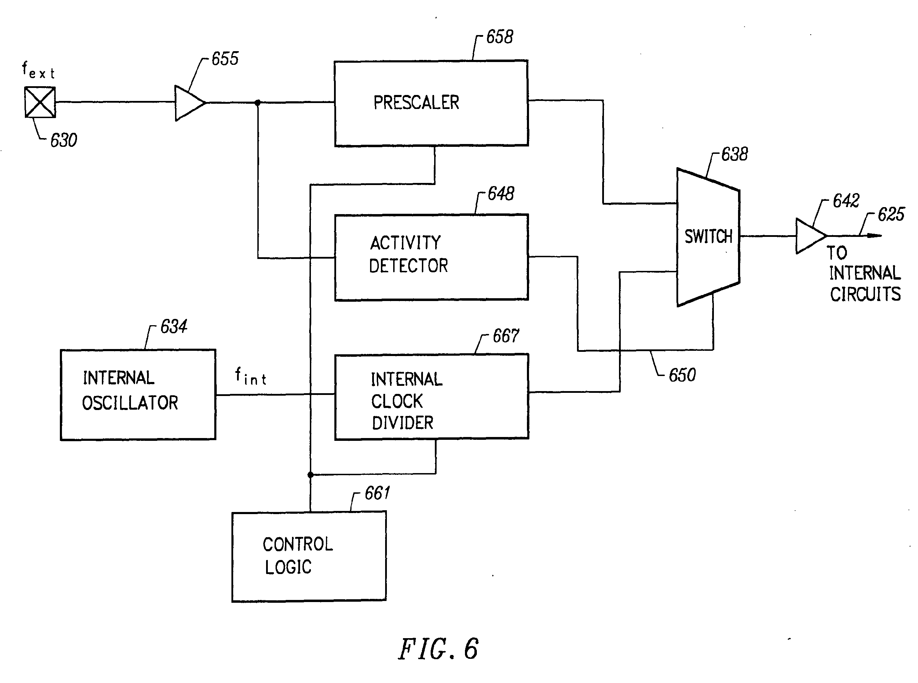

Figure 6 shows a block diagram of circuitry for implementing a user-selectable sampling frequency feature of the present invention. A feature of the present invention is to provide a user-selectable or user-controllable sampling frequency that can be dynamically changed. The sampling frequency can be changed while the integrated circuit is operating. The user-selected sampling frequency will be used for recording or playback, or both. The sampling frequency may be dynamically changed during the recording or playback operation. The sampling frequency can be changed while the memory integrated circuit remains resident on a printed circuit board. The user's selection of the sampling frequency is stored internally in the integrated circuit: there is no need to change external components such as the value of an external resistor or capacitor to change the sampling frequency. The user configures the analog memory integrated circuit to use the user-selected sampling frequency. This selection can be held in logic, volatile, or nonvolatile storage circuitry on the integrated circuit. As discussed above, a sampling clock output 625 is provided to internal circuits on the integrated circuit such as the read and write circuitry. The source of this sampling clock output may be from an external clock input pad 630, where the user provides an external clock frequency fₑₓₜ. Or, the source may be from an internal oscillator 634, providing an internal sampling frequency fᵢₙₜ. In a specific embodiment of the present invention, fᵢₙₜ is 4096 kilohertz, although other frequencies may be used.

Although the Figure 6 implementation provides both internal and external frequencies, in other embodiments, only the internal or external frequencies are provided. For example, the integrated circuit can include only a programmable internal oscillator and not provide for input of an external clock frequency, or vice versa.

The internal sampling clock fᵢₙₜ or external sampling frequency fₑₓₜ is selected by a switch 638 to be passed to sampling clock output 625. An output from switch 638 can be further amplified using a buffer 642, if desired or needed. Switch 638 can be implemented using one of the many techniques to design a switch on an electronic device. For example, switch 638 can be a multiplexer implemented with pass gates or logic gates. An alternative to a multiplexer is a summing amplifier, where the unselected signal is set to zero.

The control 650 of switch 638 can come from various sources. The switch may be controlled by user-programmed cells such as Flash, EEPROM, EPROM, antifuses, SRAM, DRAM, laser trimmable bits, and other similar technologies. For example, the user can specify the use of the internal or external clock through the SPI interface. In the embodiment of Figure 6, an activity detector 648 controls switch 638. Activity detector 648 is coupled to pad 630 and provides an output 650 to switch 638 to detect and indicate whether there is activity at pad 630. If no clock frequency is detected at pad 630, switch 638 will select the internal oscillator path. No clock frequency is detected at pad 630 when, for example, pad 630 is set at ground, VDD, or another voltage. However, if a clock frequency is detected at pad 630, switch 638 will select the external clock path. This feature of the present invention allows a user to use an external sampling frequency without the need to additionally configure special bits to so indicate.

The external sampling frequency is provided at pad 630. This signal may be amplified by a buffer 655 (if desired or needed). Then, fₑₓₜ is coupled to a prescaler circuit 658 that adjusts fₑₓₜ based on a control logic circuit 661. For example, the prescaler circuit frequency divides the fₑₓₜ frequency by an amount the user desires. The user provides information on how much to frequency divide to the control logic circuit. This information may be provided by using the SPI interface discussed in a section of U.S. provisional application 60/091,326, filed June 30, 1998. In a specific embodiment, an output of the prescaler circuit is a sampling frequency that is 128 times the user-desired or user-selected sampling frequency fₛₐₘₚ.

Internal oscillator 634 is coupled to an internal clock divider 667 that frequency divides fᵢₙₜ. Similar as to the case for prescaler 658, the amount of frequency division for internal clock divider 667 is user-selectable and controlled by control logic circuit 661. The user can select the divider ratio through the SPI interface. Also, in a specific embodiment of the invention, an output of internal clock divider 667 will be 128 times the user-desired sampling frequency.

The user's selection of the internal sampling frequency is stored internally in the integrated circuit. This selection can be stored, for example, in a register, flip-flop, latch, or other storage or logic circuits. The user's selection can also be stored into memory cells such as Flash, EEPROM, EPROM, SRAM, DRAM, laser programmable fuse, fuse, antifuse, and other technologies on the integrated circuit. For example, there may be trim bits on the integrated circuits that specifically control and determine the internal sampling frequency. Trim bits are bits within the integrated circuit that are used to configure characteristics and operating parameters of the integrated circuit. The trim bits may be implemented using any memory technology including Flash, EEPROM, analog Flash or EEPROM, or multilevel Flash or EEPROM. When the user's selection for the sampling frequency is stored internally using Flash technology, since this is a nonvolatile storage technology, the user's selection for the sampling frequency will be retained even after power is removed from the integrated circuit. In this case, the user does not need to configure the integrated circuit with the selected sampling frequency again upon power up. When not using a nonvolatile technology, the user needs to input the desired sampling frequency before reading or writing to the memory.

Since the user's sampling frequency selection is stored internally on the integrated circuit, this selection may also be changed or adjusted during the operation of the integrated circuit. Therefore, the sampling frequency can be dynamically changed. No components external to the integrated circuit such as an external register need to be changed or adjusted. For example, the user may change (e.g., via the SPI interface) the value stored in a register or latch, one or more memory cells, or other storage circuit to dynamically change the sampling frequency. In a specific embodiment, the user value to select the sampling frequency is a digital value (e.g., a binary number). However, in other implementations, this value may be an analog value.

In one implementation, clock output 625 of the circuitry in Figure 6 provides a clock that will be 128 times the user-desired sampling frequency (i.e., 128 * fₛₐₘₚ). This specific multiple of the sampling frequency was selected to permit greater ease in logical manipulation of the signal by on-chip circuitry to generate derivative clock signals. In particular, 128 * fₛₐₘₚ is the highest common frequency of the clock signals needed for a particular embodiment of the present invention.

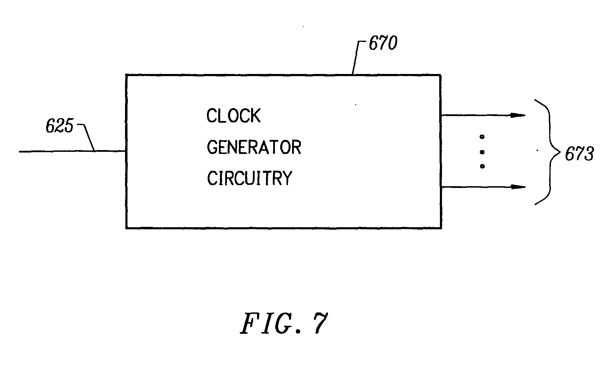

Figure 7 shows clock generation circuitry 670 that uses clock output 625 to generate a number of clock outputs 673. Clock generation circuitry 670 generates clock signals for other circuitry on the integrated circuit. Clock signals 673 can include one or more higher frequency clocks (i.e., higher than fₛₐₘₚ) used, for example, by charge pump circuitry. Clock signals 673 can include one or more lower frequency clocks (i.e., equal to or lower than fₛₐₘₚ) used by the write and read circuits. For example, a clock at the sampling frequency is used by the write circuit. Clock signals 673 can also include one or more clocks that are at a lower or high frequency that may have a desired duty cycle for operating the on-chip circuitry.

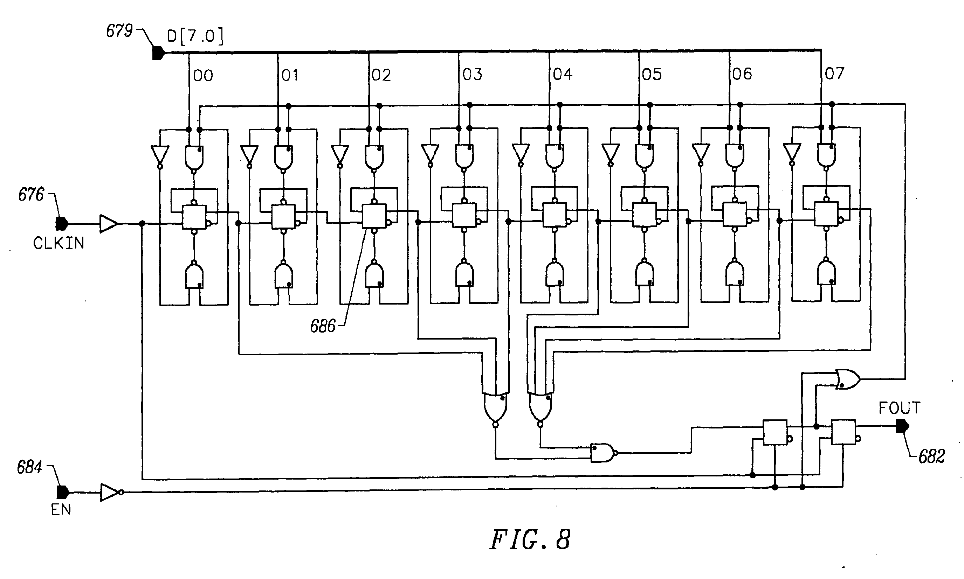

Figure 8 shows a circuit schematic for a specific implementation of prescaler 658. The external clock fₑₓₜ is input at 676 and an 8-bit binary number is input at 679. The external clock frequency is divided by a value represented by the 8-bit binary number to obtain 128 * fₛₐₘₚ at an FOUT output 682. This circuitry has an enable input EN 684 to enable or disable FOUT 682. This circuitry includes a number of flip-flop circuits 686 similarly arranged in parallel. Output of flip-flop circuits 686 are coupled into NOR gates and then an AND gate for generating FOUT 682. The output frequency at FOUT 682 will be the fₑₓₜ frequency divided by d, where d is the value represented by the 8-bit binary number.

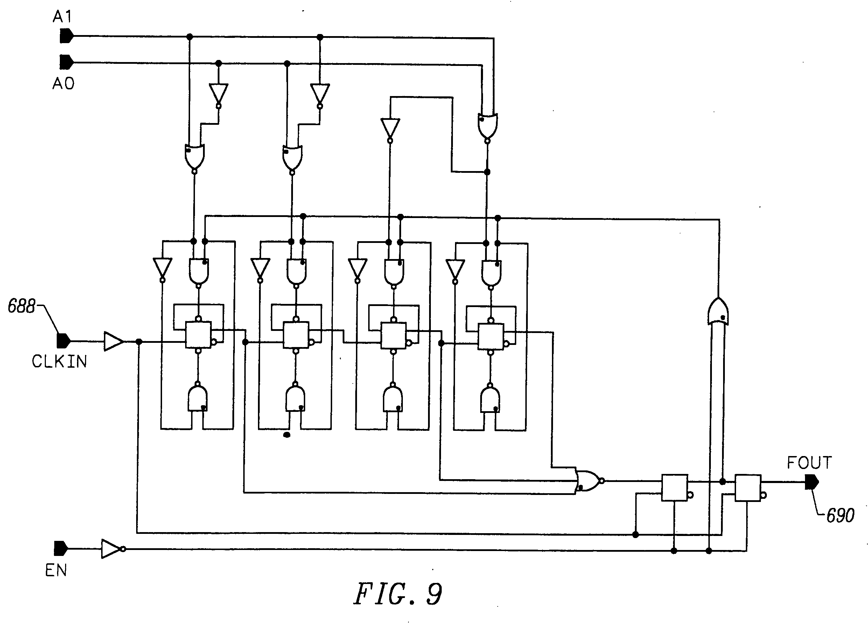

Figure 9 shows a circuit schematic for internal clock divider 667. However, the internal clock divider 667 performs a similar function as the prescaler 658. Therefore, the specific circuit implementation in Figure 8 or a variation may also be used to implement clock divider 667. The circuitry in Figure 9 or its variation may also be used for prescaler 658. In the Figure 9 implementation, the internal clock divider uses a decoding-style technique for generating different output frequencies. The internal clock frequency fᵢₙₜ is input at 688, and the 128 * fₛₐₘₚ output is taken at an F_{OUT} output 690. A 2-bit value is input using A1 and A0 to divide the clock into four possible output frequencies. The following table A provides a listing of the F_{OUT} outputs for the A0 and A1 inputs based on an input frequency of 4.096 MHz. Based on A0 and A1, the input frequency is divided to obtain the output frequency.

**Table A**

| A0 | A1 | F_{OUT} 690 | fₛₐₘₚ |
|---|---|---|---|
| 0 | 0 | 512kHz | 4 kHz |
| 0 | 1 | 682 kHz | 5.3 kHz |
| 1 | 0 | 819 kHz | 6.4 kHz |
| 1 | 1 | 1024 kHz | 8 kHz |

As the table shows, this specific embodiment of the present invention provides four possible internal sampling frequencies 4 kilohertz, 5.3 kilohertz, 6.4 kilohertz, or 8 kilohertz. This circuitry is merely an example of the circuitry that may be used in the present invention. Similar circuitry may also be used to provide other specific frequencies. The user can also be given choice of more frequencies or a range of frequencies. For example, there may be eight or more different frequencies to choose from. By providing a greater number of inputs An, the sampling frequency may be essentially any frequency within a desired frequency range.

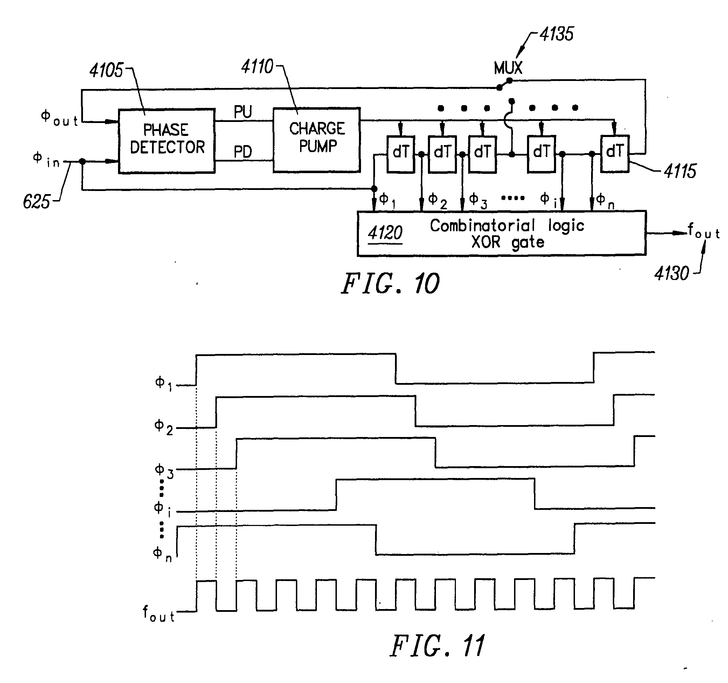

Figure 10 shows a block diagram of delay locked loop (DLL) circuitry that is used for clock generation circuit 670. Other circuitry besides a DLL may be used to perform frequency multiplication. For example, a phase locked loop (PLL) circuity may also be used. Figure 10 shows a DLL circuit including a phase detector 41 OS that is coupled in clock output 625. The phase detector generates PU (pull-up) and PD (pull-down) outputs that are coupled to a charge pump 4110. The charge pump is coupled to a number of delay cells 4115, which may be in a simple embodiment, inverting buffers. Each delay cell generates a phase output PHI1 to PHIN. Phase output PHI1 is coupled to clock output 625. The phase outputs are logically combined using combinatorial logic 4120 such as a XOR gate or another type of logic gate to generate f_{OUT} 4130. Figure 11 1 shows a timing diagram of phases of the clock, øi to øn, and the resulting f_{OUT}. Signal four 4130 is generated from the øi to on waveforms by using XOR gate 4120. Signal f_{OUT} will be high only when one and only one of the clock phases is high.

In Figure 10, to obtain the desired four 4130 output frequency, a multiplexer or switch 4135 is selectively connected at various points in the delay chain to feedback an output of one of the delay cells 4115 to phase detector 4105. Depending on which point of the delay chain is fed back to the phase detector, a higher or lower frequency four 4130 is derived. Switch 4135 essentially shortens or lengthens the delay chain. This will change the frequency.

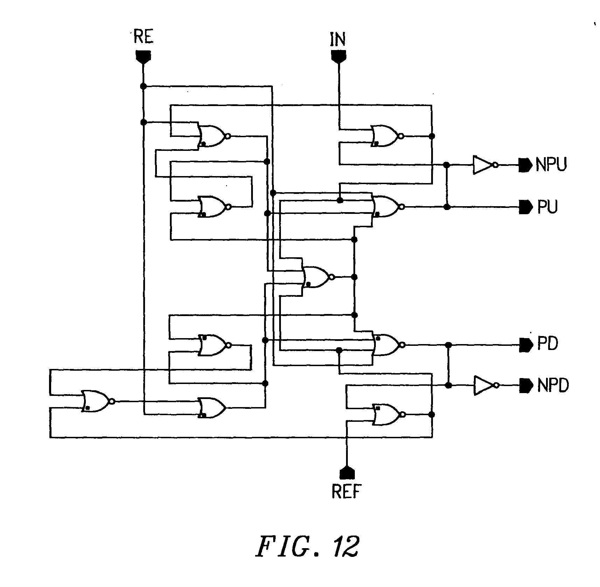

Figure 12 shows a schematic of a phase detector circuit 4105. Clock ØIN is input at IN and clock Ø_{OUT} is input at REF. The outputs are pull-up (PU), /pull-up (NPU), pull-down (PD), and /pull-down (NPD). RE is an active high signal that goes low with the rising edge of REF. When RE is high, PU and PD will be low. The phase detector is implemented with NOR logic gates. Other types of logic gates may also be used.

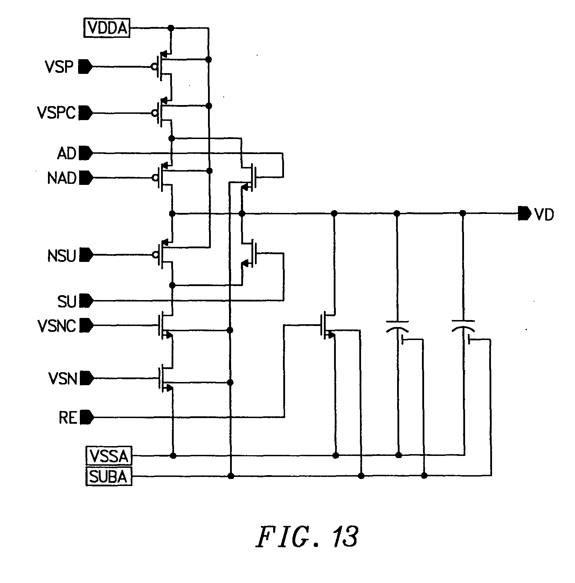

Figure 13 shows a schematic of a charge pump circuit 4110. From the phase detector, PU is connected to AD. NPU is connected to NAD. PD is connected to SU. NPD is connected to NSU. VSP, VSPC, VSNC, and VSN are bias voltages from a bias voltage generator. This bias voltage may be from a slave bias generator of a master-slave biasing scheme discussed later. An output of the charge pump is VD.

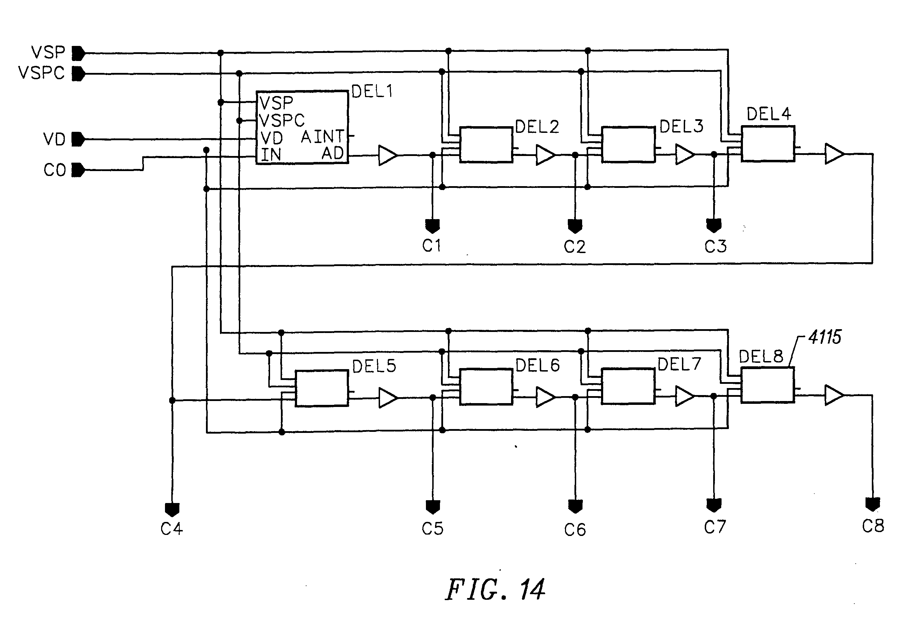

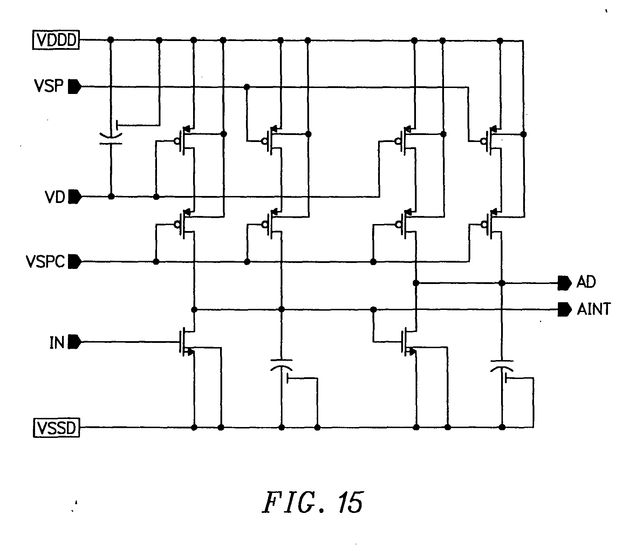

Figure 14 shows a schematic of a number of delays cells 4115 coupled in series. Figure 15 shows a schematic of a single delay cell 4115. VD from the charge pump is connected to each of the delay cells. VSP and VSPC are bias voltages as described above. C1 and C8 are the different output phases from each of the delay cells.

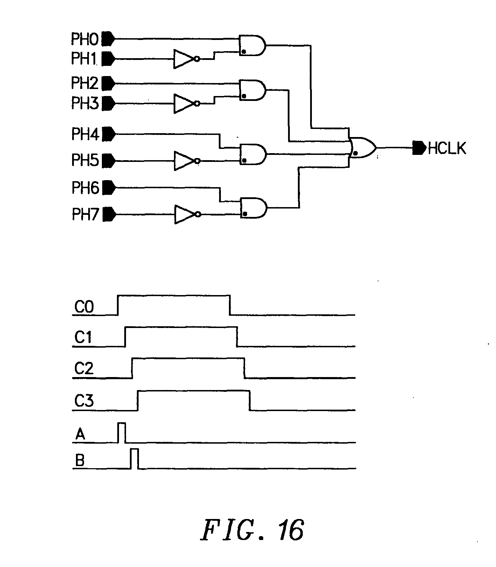

Figure 16 shows a more detailed schematic of a first stage of combinatorial logic 4120. Each of the phases of the clock C1 to C8 is connected to PH0 to PH7, respectively.

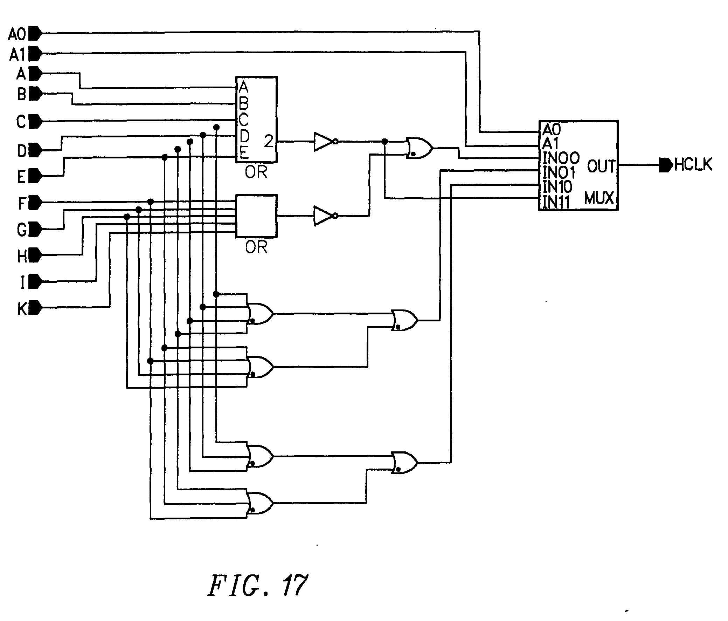

Figure 17 shows a second stage of combinatorial logic 4120 that takes input from the first stage of combinatorial logic and synthesizes the final clock output.

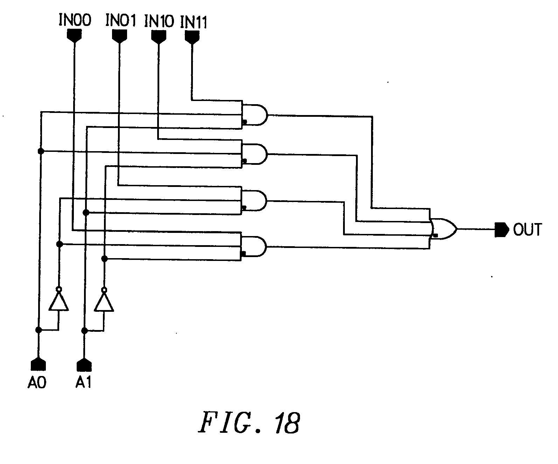

Figure 18 shows a schematic of the feedback multiplexer 4135. Based on A0 and A1, this multiplexer connects an output of a delay cell input at IN00, IN01, IN10, and IN11 to an OUT. OUT is connected to ØOUT of the phase detector.

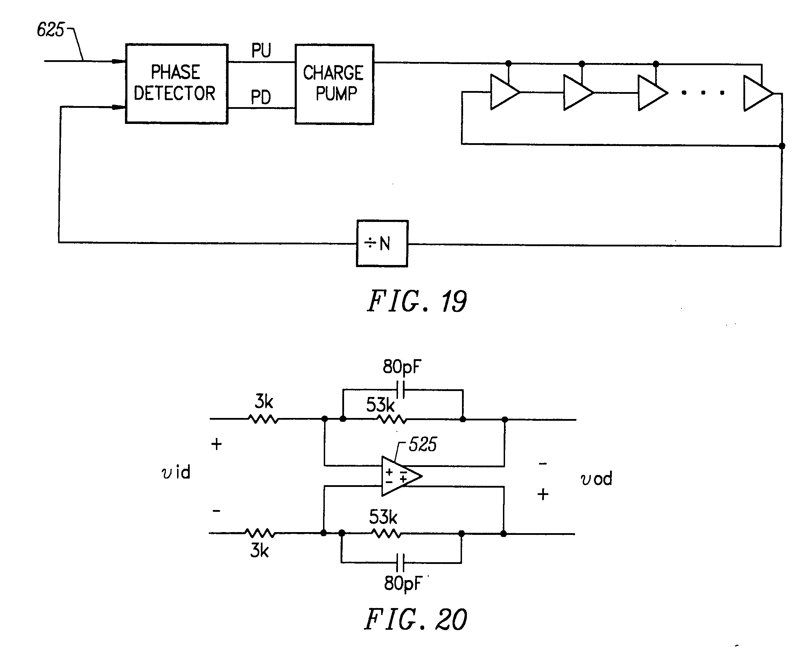

Figure 19 shows a schematic of a frequency multiplier using PLL circuit arrangement. Clock 625 is input to a phase detector. The phase detector generates PU and PD signals for a charge pump. An output of the charge pump is coupled to a number of delay cells arranged in a ring oscillator arrangement. An output from one of the delay cells is fed back through a frequency divider (÷N) circuit to the phase detector.

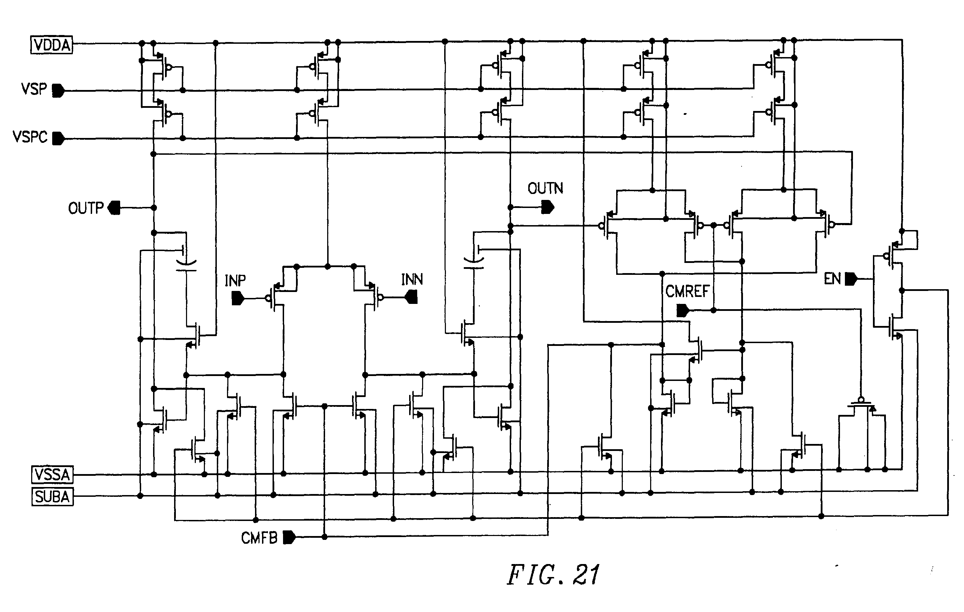

Figure 20 shows a specific implementation of preamplifier 405 of Figure 4. The circuitry uses a fully differential operational amplifier 525 connected with common mode feedback. ANAIN+ and ANAIN- are input at Vid+ and Vid-, respectively. A differential output is taken at Vod+ and Vod-. The gain of this preamplifier 405 is about 17.667 or about 25 decibels (dB). The gain of the preamplifier may range from about 20 to 30 decibels. For example, the gain may be about 23 decibels. Figure 21 shows a circuit schematic of the differential operational amplifier circuitry of Figure 20. This design uses MOS transistors. The inputs are INP and INN. Output is taken from OUTP and OUTN.

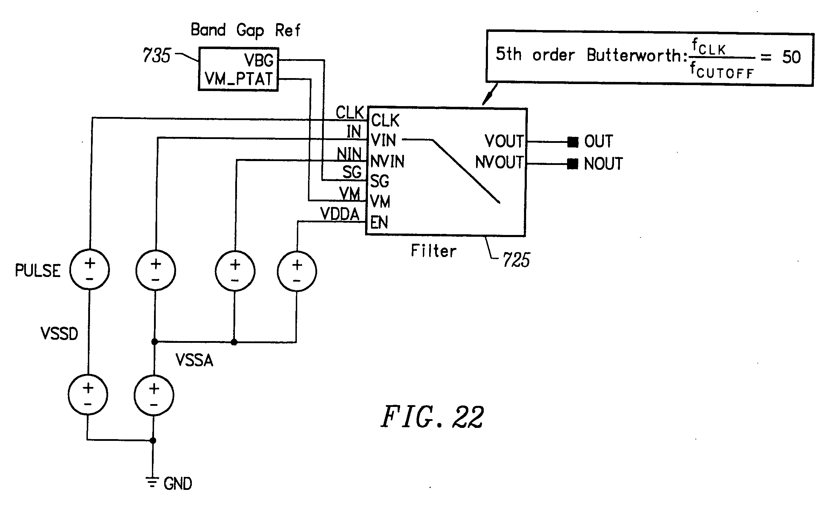

Figure 22 shows a block diagram of low pass filter 411 of Figure 4. In this implementation, a filter 725 is a fifth-order Butterworth filter where f_{CLK}/f_{CUTOFF} is at least 50. In further embodiments of the present invention, the f_{CLK}/f_{CUTOFF} is 75 or greater. Moreover, the filter may have an f_{CLK}/f_{CUTOFF} in a range from about 50 to about 100. This filter is sampled data filter that provides sampled data at its differential outputs, OUT and NOUT. A bandgap reference 735 generates a bias voltage reference for filter 725. Other types of sampled data filters may also be used. These include Chebychev, Bessel, elliptic, polynomial, and various implementations of switched capacitor filters, among others. The filter used may also be a continuous time filter, where the data is sampled in a different manner.

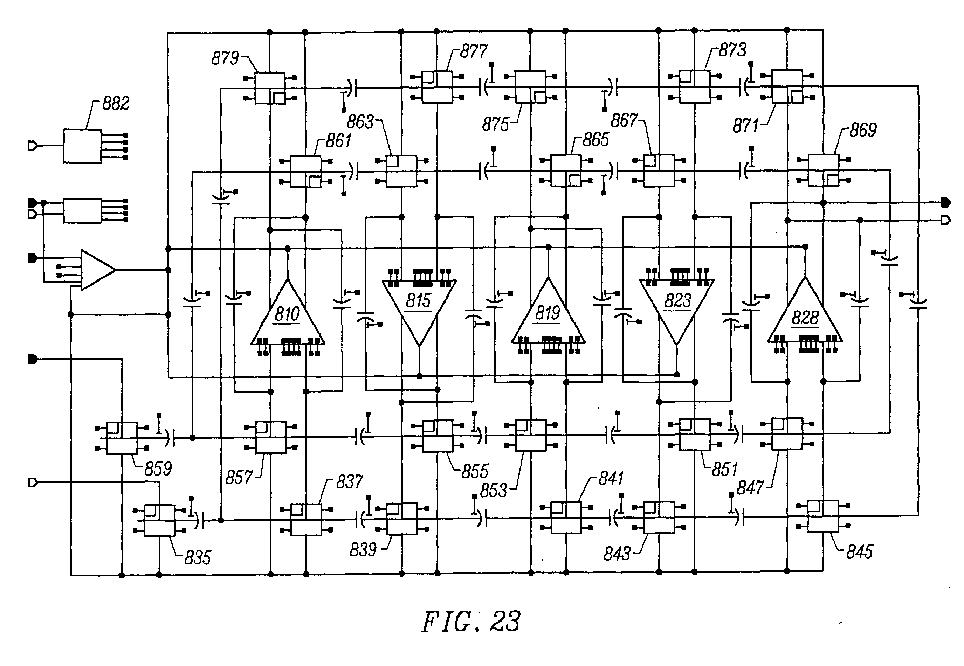

Figure 23 shows a more detailed diagram of the sampled data Butterworth filter of Figure 22. The circuitry includes five operational amplifiers 810, 81 S, 819, 823, and 828. A number of switches 835, 837, 839, 841, 843, 845, 847, 851, 853, 855, 857, 859, 861, 863, 865, 867, 869, 871, 873, 875, 877, and 879 are coupled to the amplifiers. The switches are coupled to clocks generated by a nonoverlapping clock buffer 882. The switches are AC switches of the type used to implement switched capacitor circuitry.

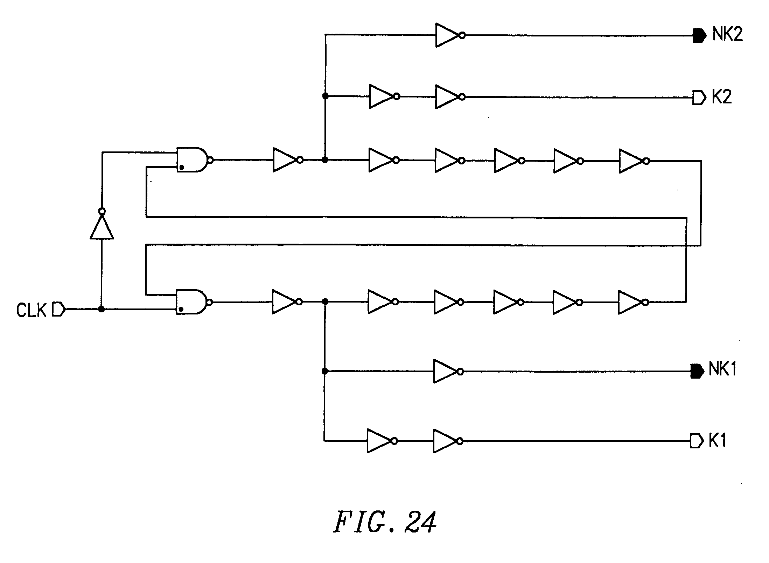

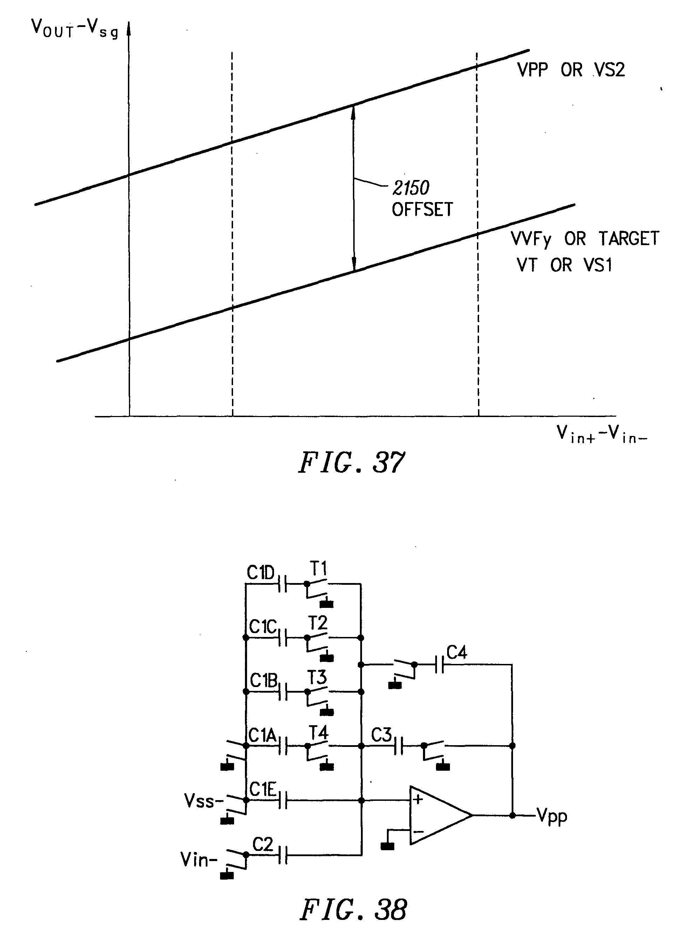

Figure 24 shows an implementation of nonoverlapping clock buffer 882. A clock signal is input at CLK. The resulting complementary pairs of clock signals are K1 and NK1, and K2 and NK2. These clock signals are input to the AC switches and are nonoverlapping. Nonoverlapping means the active phase K1 is terminated before the next active phase K2. In other words, only one of the complementary clock signals is high, or low, at a time. Figure 36 shows an example of nonoverlapping clock signals CLK1 and CLK2.

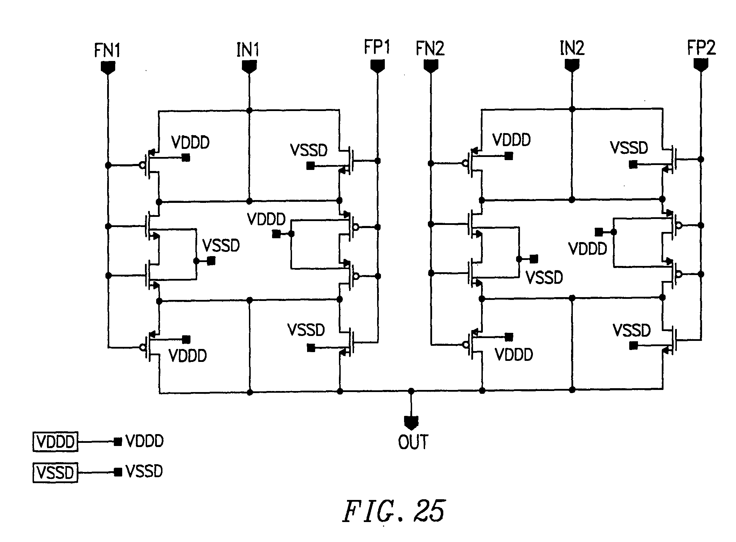

Figure 25 shows an embodiment of a switch circuit. Many of such switches are used to implement the filter in Figure 23. Such switches are also used to implement the other AC switches on the integrated circuit. IN1 and IN2 are the inputs. OUT is the output. FN1 and FP1 are complementary, nonoverlapping clock signals. FN2 and FP2 are also complementary, nonoverlapping clock signals. When FN1 and FP2 are high and FP1 and FN2 are low, OUT will be IN1. When FN1 and FP2 are low and FP1 and FN2 are high, OUT will be IN2.

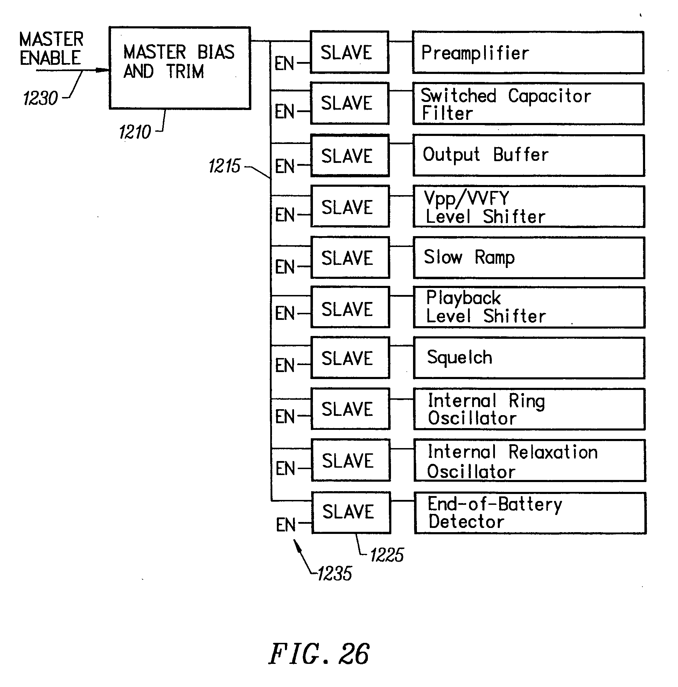

Figure 26 shows a diagram of a master-slave bias arrangement of the present invention. The master bias generator 1210 generates a bias voltage 1215 for a number of slave bias circuits 1225. There is typically only one master bias generator. The master bias generator has a master enable input 1230 to control whether the master bias generator is enabled. When enabled or on, the master bias generator generates the bias voltage or bias voltages. When on, the master bias generator consumes power. When disabled or off, the master bias generator does not generate the bias voltage or bias voltages and does not consume power. It is desirable to have only one or very few master bias generators on the chip in order to provide uniform bias voltages and reduce power consumption.

The master bias generator is connected to a number of slave bias circuits, each of which outputs a bias voltage derived or based on the master bias generator. Each slave bias circuit 1225 also has a local enable (EN) input 1235. The local enable input is used in the same way as the master enable input. When the local enable is off, the slave bias circuit will not output a bias voltage and does not consume power. When the local enable is on, the slave bias circuit output the bias voltage and consumes power.

By using the master-slave bias arrangement of the present invention, local circuits receiving the bias voltage through one slave bias circuit are isolated from other local circuits receiving the bias voltage through a different slave bias circuit. Thus, noise and other artifacts generated at a particular location are less likely to be coupled back to the master bias generator, and through other slave bias circuits, to circuits in another location. This is especially important in facilitating a stable bias reference voltage. Furthermore, individual slave bias circuits 1225 have individual local enable pins 1235. This allows power to be saved since the slave circuit can be turned off when particular circuits do not require the bias voltage. For example, a particular portion of the circuitry may be used only during the testing of the device. To conserve power, the slave bias circuit for that portion of the circuitry will be turned off for operations other than testing.

Figure 26 also shows circuit or functional blocks of the integrated circuit that are connected to individual slave bias circuits. The preamplifier, switch capacitor filter or low pass filter, output buffer, VPP and VVFY level shifter, squelch circuit, internal ring oscillator (to run the charge pumps), internal relaxation oscillator (to generate the sampling frequency), and end-of-battery detector are connected to individual slave circuits. The functionality of these blocks is described in more detail elsewhere in this specification.

While operating the integrated circuit, certain functional blocks are not used when other functional blocks are being used. For example, the VPP and VVFY level shifters are not typically used at the same time as the playback level shifter. This is because the memory cells are generally not written to and read from at the same time. In cases such as this, the slave bias circuit for the unused or nonoperated circuitry can be turned off. This will save power and also further enhance the isolation between the bias voltage output lines of the slave bias circuits.

Further, it is desirable to have separate slave bias circuits for the circuit blocks where isolation of the bias output lines is important. For example, the slave bias circuit for the internal ring oscillator is separate from that for the internal relaxation oscillator. This will help prevent noise or other effects of one oscillator from affecting the other oscillator. Another example of where separate slave bias circuits are desirable is for the digital and analog circuitry. The analog circuit will be connected to different slave bias circuits from the digital circuits.

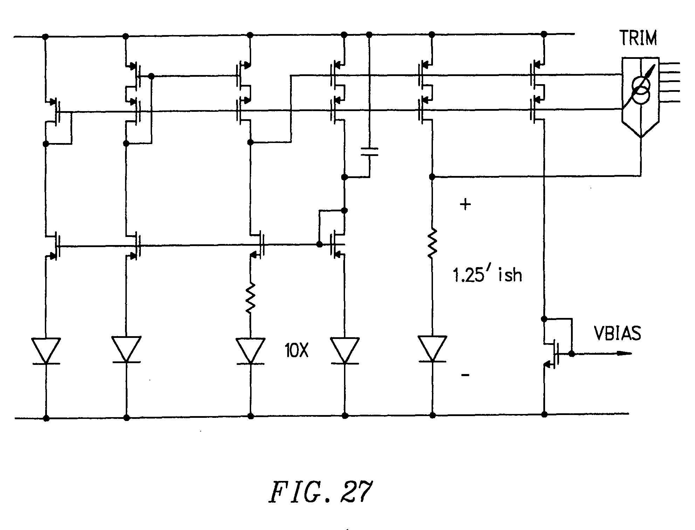

Figure 27 shows a diagram of circuitry that may be used to implement the master bias voltage or other bias voltages. The particular circuitry shown in Figure 27 is for a bandgap reference voltage generator. The bandgap reference voltage provides a stable, constant voltage reference relative to changes in power supply voltages, temperature, and pressure, among other factors. Other circuitry, other than a bandgap reference, may be used to generate a reference voltage. These may also be used to implement the master bias voltage.

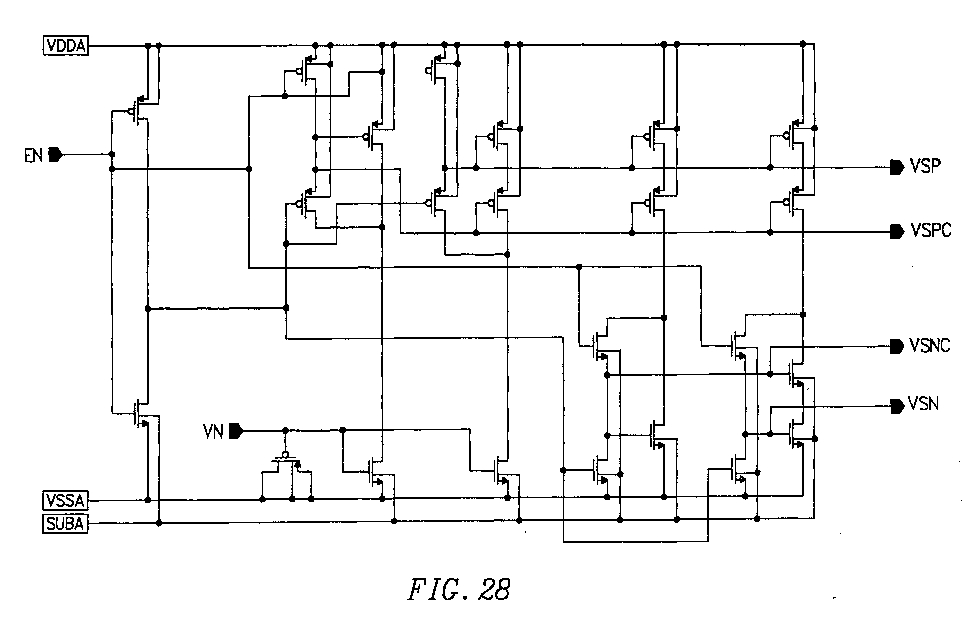

Figure 28 shows a more detailed diagram of a slave bias circuit. This specific configuration has an enable input EN to control whether bias voltages are generated at outputs VSP, VSPC, VSNC, and VSN. When EN is a logic high, bias voltages are generated. When EN is a logic low, the slave circuit will not generate bias voltages, and the circuitry will consume essentially zero power. A VM input is a bias voltage input used to generate the bias voltages. VM is connected to the master bias generator. The slave bias circuit used VM to generate multiple bias voltages. VSP will be about a VT below VDD. VSPC will be about 2*VT below VDD. VSNC will be about 2*VT above ground. VSN will be about a VT above ground.

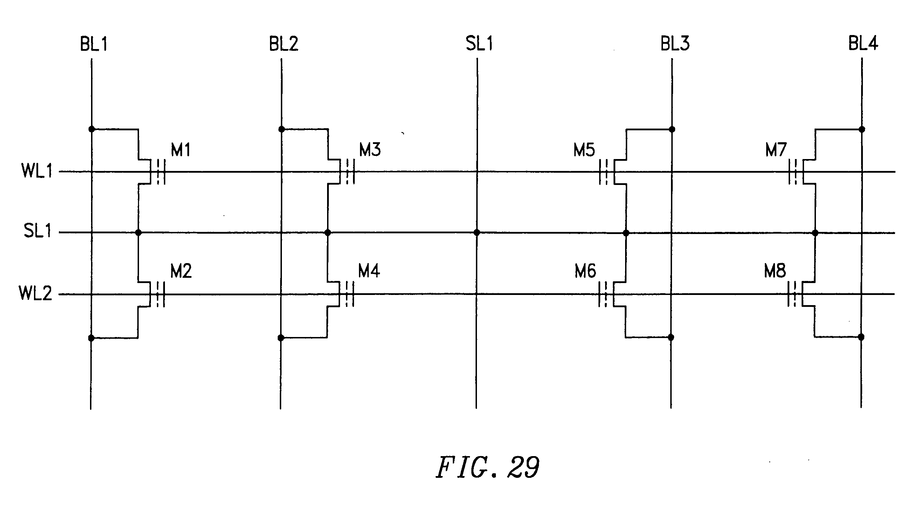

Figure 29 shows a diagram of a portion of a memory array of the present invention. Individual memory cells are arranged in rows and columns. Figure 15 shows eight memory cells M1, M2, M3, M4, M5, M6, M7, and M8. The memory-transistors are floating gate memory cells such as EEPROM or Flash. As many memory cells as desired may be added to the array by repeating or mirroring this structure. Word lines WL1 and WL2 coupled to the control electrodes or gates for two different rows of memory cells. Bit lines BL1, BL2, BL3, and BL4 coupled to four different columns of memory cells. These memory cells share a common source line SL1. Moreover, for example, an array may have 1K, 10K, 100K, 500K, 1M, 2M, 4M, 6M, 8M, 10M, 12M, 16M, 20M, 32M, 64M cells or more. As discussed previously, a practical implementation of the present invention using present technology has about 1.92 million or less memory cells. As technology advances, it will undoubtedly be possible to have more memory cells on the integrated circuit. For example, a chip twice the size will have 3.84 million memory cells. This "double sized" memory will store approximately sixteen minutes of voice data when using a 4 kilohertz sampling frequency. The cells are organized by rows and columns.

Figure 29 shows a sector or page of memory cells. Since the memory cells have a common source line, all the memory cells in the sector are erased at the same time. Memory cells in one sector will have a different source line from memory cells in other sectors. The memory is organized in sectors to allow a group of memory cells to be more easily erased. It is undesirable to use too large a sector size or else too much data is erased at one time. Then, it is likely much of the data will need to be rewritten into the memory.

In a specific embodiment, the nonvolatile analog memory cells are fabricated using Flash technology. Flash technology provides reprogrammable, nonvolatile memory cells. Flash transistor may be written, erased, and rewritten an indefinite number of times. In this written description, writing the Flash memory cells may also be referred to as "programming" the cells. And, programming the cells means a stored threshold voltage (VT) of the memory cells will be increased. For example, Flash transistor may be operated for about 300,000 or more erase and write cycles. Also, Flash transistors retain their stored value even when power is removed from the integrated circuit. It is expected the data retention time is better than 100 years.

A memory cell may be a single Flash transistor having a floating gate. Electrons are transferred to and from the floating gate. The quantity of electrons stored on the floating gate will be representative of the memory cell's stored value. The quantity of electronics stored on the floating gate, and hence the cell's stored value is determined by finding a threshold voltage (VT) of the transistor. For example, the threshold voltages for a Flash transistor typically range from about 3 volts to about 5.5 volts. The voltages or stored VTs in this range are used to represent the different stored values. The range for VT is technology dependent and will vary. The threshold voltage for the Flash transistor may also be negative in some applications of the present invention. For EEPROM cells, the VT range will be from about -2 volts to about 3 volts.

A Flash transistor is programmed or written by placing electrons on the floating gate. Programming can be accomplished by generating a programming current through the transistor sufficient to generate hot electrons. The programming current through a Flash transistor may range from about 200 microamps to about 3 milliamps, or more. A typical programming current would be about 0.5 milliamps to about 2 milliamps. For some Flash transistors, programming currents of less than 200 microamps are used. For example, some Flash transistor are programmed with about 10 microamps. Some hot electrons will jump the potential barrier and become embedded in the floating gate of the Flash transistor. Flash transistors are erased by removing electrons from the floating gate using such mechanisms as Fowler-Nordheim tunneling. Essentially, electrons are attracted out of the floating gate by placing a relatively large positive voltage on the source line.

Many other technologies may also be used to implement the memory cells of the present invention. For example, EEPROM or EPROM technology may also be used instead of, or in combination with, Flash technology. For EEPROM technology, the EEPROM transistors having a floating gate can be programmed using Fowler-Nordheim tunneling. Analog memory cells may be implemented using other technologies including dynamic RAM (DRAM) cells by controlling the amount of charge stored on the capacitor; ferroelectric RAM (FRAM) cells by controlling the electric polarization of the ferroelectric material; and antifuses by controlling the resistance or other electrical property of the antifuse link. Other technologies may include charge-coupled devices (CCDs) and fuses, among others.

Flash transistor technology provides certain advantages compared to EEPROM technology. The time for hot electron programming of Flash cells is much shorter than the programming time of EEPROM cells. Typically, Flash cells may be programmed about 100 times faster than EEPROM cells. The programming time for Flash cells is typically about 125 microseconds, although less time (e.g., 63 microseconds) is often sufficient. Since the programming time is shorter with Flash cells, an integrated circuit with Flash technology can be operated with a higher sampling frequency because less time is needed before taking the next sample. Furthermore, the samples are "fresher" since less time has elapsed between the time the sample was taken and the sampled data is stored. "Fresher samples" refers to samples that are free of sample and hold "droop" errors, which can be caused by charge loss or leakage during the hold mode. By using fresher samples, this results in less distortion. Flash cells are also smaller than EEPROM cells, so larger numbers of Flash cells may be fabricated on the same integrated circuit area. The circuitry overhead for interfacing with and configuring Flash transistors is also comparatively less than for EEPROM transistors. Generally, there are many benefits to using Flash technology as compared to other floating gate technologies including EEPROM technology.

In other embodiments of the present invention, the memory cells or a portion of the memory cells may be one-time programmable (OTP) instead of reprogrammable. The OTP cells can be used for setting options on the integrated circuit. An example of another use of OTP memory is to store prerecorded sound, music, video, or pictures. OTP integrated circuits of the present invention may be sold much like prerecorded cassettes, CDs, minidiscs, videotapes, videodiscs, and DVDs. OTP cells can be implemented using the same technology used to implement the reprogrammable cells. However, OTP cells cannot be erased because the circuitry is designed not to allow erasure.

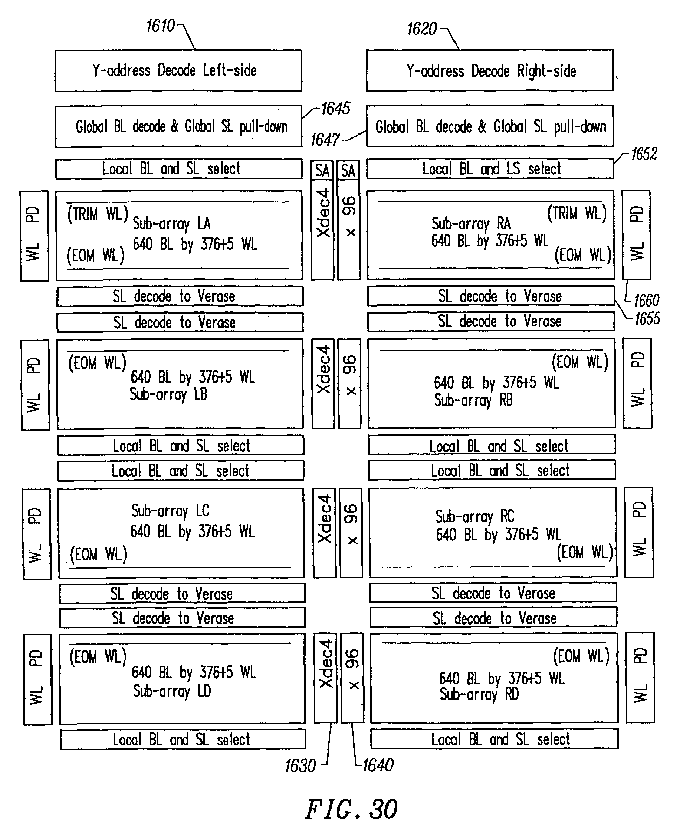

Figure 30 shows a diagram of an organization of a memory array of the present invention. There are many possible arrangements for memory cells in an integrated circuit of the present invention. Figure 30 shows one specific example where the memory cells are organized in subarrays. Subarrays on a left side are labeled LA, LB, LC, and LD. Subarrays on a right side are labeled RA, RB, RC, and RD. A subarray has row or word lines (WLs) and column or bit lines (BLs). The subarray is further segmented in sectors. A sector of memory cells can have different bit lines, but these memory cells share the same source line (SL). As discussed above, this permits the erasure of a sector of memory cells at one time.

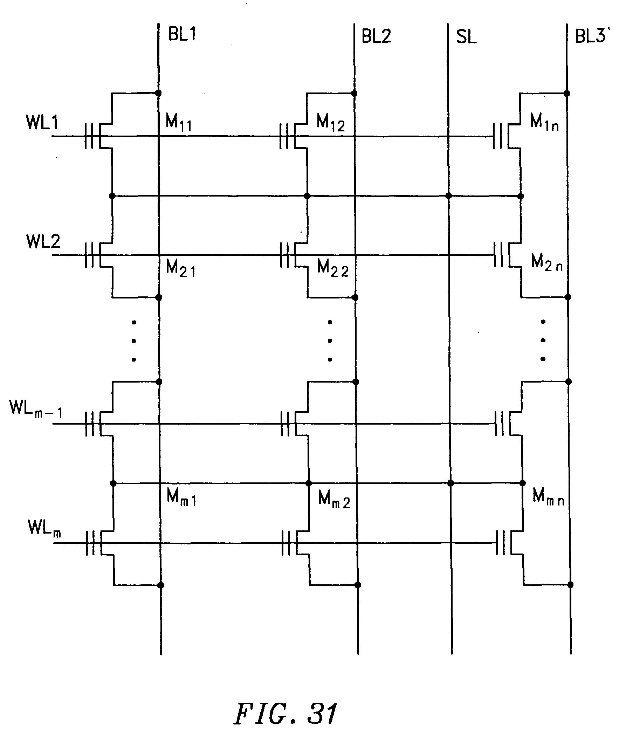

Another example of a configuration for a sector of memory cells is shown in Figure 31. In Figure 31, there are a number of memory cells M11 to Mmn having a source line SL connected in common for the cells. The memory cells have word lines WL1 to WLm and bit lines BL1 to BLn. Other configurations for sectors of memory cells may share one or more word lines, or one or more bit lines. There may be any number of cells in a sector. For example, in one embodiment, there are 1504 cells in a single sector that is organized as 4 bit lines and 376 word lines.

Figure 30 shows circuitry for a Y-address decoder 1610 for the subarrays on left side, and for a Y-address decoder 1620 for the right side. Further, there are X-address decoders 1630 and 1640 for the each of the subarrays. The X-address decoders are located between the subarrays. There are global bit line decoders 1645 and 1647 for left and right subarrays, respectively. The subarrays have local bit line and source line select circuitry 1652 and source decode to Vₑᵣₐₛₑ circuitry 1655. Also, there is a word line decoder 1660 for each of the subarrays. The decoders are divided into pull-up and pull-down decoders. All decoders may be on one side, either the pull-up or pull-down side. In a specific embodiment of the present invention, decoders 1640 are pull-up decoders while decoders 1660 are pull-down decoders.

Within each subarray, one word line is designated as an end of message (EOM) word line (i.e., EOM WL) that is used to gate memory cells to indicate whether a message ends within a sector. Also, there is a trim word line (i.e., TRIM WL) in one or more of the subarrays. The trim word line includes memory cells that are configured to enable or disable options for the integrated circuit. The memory cells along the trim word line may be one-time programmable.

In a specific layout of the cells in Figure 31, in the vertical direction, the bit lines of the memory cells are run in diffusion and metal-1. There will be polysilicon-1 stripes. Source lines are run in metal-1. To allow signals to pass, two global bit lines are in metal-2, one global source line is in metal-2, and two passing source lines are in metal-1. In the horizontal direction, word lines are run in polysilicon-2. And, a common source diffusion is shared by the bit lines.

U.S. provisional application 60/091,326 provides a further description of the memory array. In brief, in a specific example of an integrated circuit of the present invention, there are a total of 1.92 million bits of Flash cells for user voice or digital data storage. The cells are segmented into eight subarrays of about 240K bits. A subarray is arranged to have 640 bit lines by 376 word lines. The actual physical layout for each subarray will typically have more bit lines and word lines. For example, there are 648 bit lines and 384 word lines. The additional bit lines and word lines are used for end of message, trim, and array-edge protection purposes. Global bit lines and global source lines are run in metal-2 above or on top of the subarrays. These global lines are subsequently coupled to local bit lines and local source lines in order to address each cell individually.

Furthermore, each of the subarrays is further divided into 160 bit-line-based sectors. Each bit-line-based sector contains four bit lines that can be erased together through one common source line shared by the four bit lines. Each sector is made of 1504 user cells (4 rows * 376 cells/row). A user sector includes a sector located within a left subarray and a sector located within a right subarray. There are 3008 cells per user sector, and each user sector may be selected by using a unique address. There are 640 (4 * 160) user-addressable sectors on a single chip.

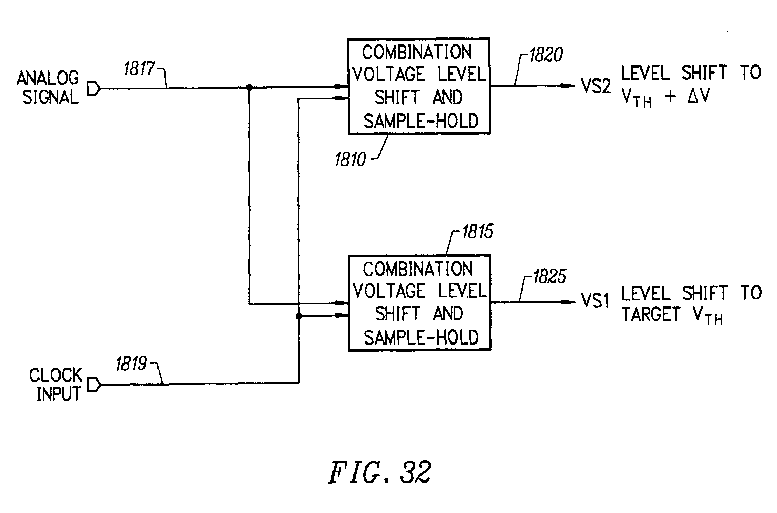

There are many different techniques of implementing circuitry for writing or programming information into the memory array. Some techniques are discussed in U.S. patent number 5,694,356, which is incorporated by reference. Figure 32 shows an example of a specific implementation of the write circuit 414 of Figure 4. Circuit blocks 1810 and 1815 each contain a combination of voltage level shifter and sample and hold (S/H) amplifier circuit. The level shifter and S/H circuit may also be implemented in separate or different circuit blocks. For example, the S/H circuit can be part of the low pass filter circuitry 411 of Figure 4. This circuitry holds the data and generates voltage levels for storing the sampled data into a memory cell. The S/H circuit samples when the clock runs and holds when the clock is stopped on a low phase.

Inputs to the circuit blocks are a signal 1817 (which is typically analog) to be stored or recorded and clock inputs 1819. The analog signal comes from an antialiasing filter, such as low pass filter 411 or the Butterworth filter of Figure 23. The clock inputs are from a nonoverlapping clock buffer such as shown in Figure 24. Level shifter circuit block 1810 provides an output 1820. This level shifter can be referred to as a programming voltage or VPP level shifter circuit. Level shifter circuit 1815 provides an output 1825. This level shifter can be referred to as a target or verify (VVFY) voltage level shifter circuit. Output 1825 provides a level shifted voltage VS1 (or VVFY) corresponding to the target threshold voltage (VT) to be programmed into the memory cell. For typical Flash memory cells, the range of target VTs will be from about 2.5 volts to about 6 volts. Output 1820 provides a level shifted voltage VS2, which is the target VT plus an offset. During programming, VS2 is coupled to the control electrode or control gate of the memory cell so the memory will be programmed to the desired or target VT. In a specific embodiment, the offset voltage is about 5 volts. In this case, if the desired VT is 3.5 volts and the offset is 5 volts, the VS2 voltage will be 8.5 volts. Using two level shifters provides the advantage that the two level shifters may be independently adjusted in order to program memory cells more precisely.

The voltages generated and provided by the level shifters may be above the supply voltages for the integrated circuit. These high voltages are used to program and verify the memory cells. In order for the level shifters to provide these high voltages, high voltages can be generated on-chip using charge pump circuitry (discussed below). These high voltages are connected to the amplifiers of level shifters. Specifically, the generated high voltages are connected to the supply rails of level shifter circuitry. The level shifter will be able to generate a range of output voltages up to its supply voltage.

The writing techniques of the present invention use two level shifter circuits 1810 and 1815. By having the two level shifters, each may be adjusted independently from another to allow for proper and more precise programming of memory cells. Other programming methodologies may use a single level shifter or more than two level shifters. In a particular embodiment, in order to program multiple memory cells at one time, a number of level shifters are used in conjunction with another at the same time.

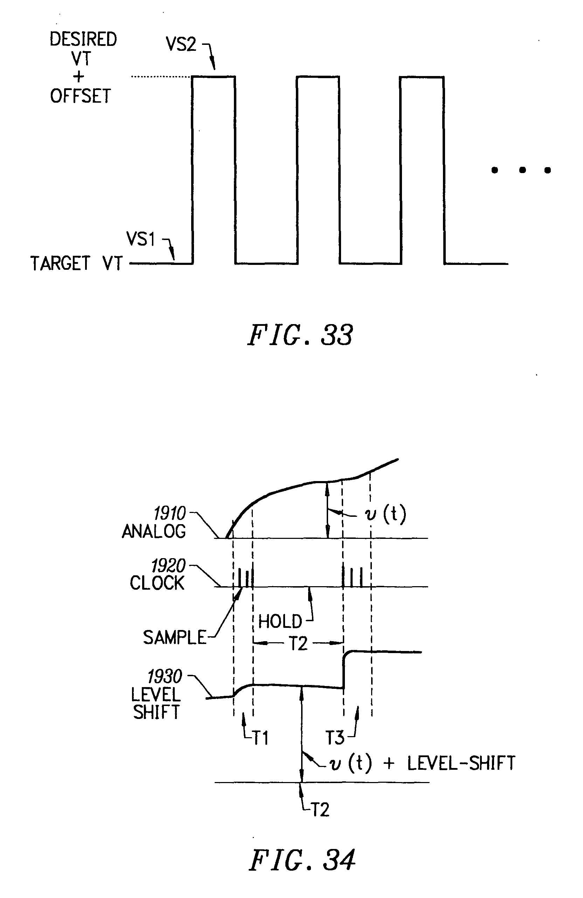

In a technique of programming the analog memory cell according to the present invention, VS 1 and VS2 are coupled alternatively to the control electrode or word line of the Flash cell. Typically, VS 1 will be in a range from about 2 volts to about 7 volts. VS2 will be in a range from about 5 volts to about 13 volts. As shown in Figure 33, at the control gate, there will be pulses between a target or desired VT level (VS I level) and a desired VT level plus an offset voltage level (VS2 level). When VS1 is coupled to the control gate of the memory cell, the memory cell is evaluated whether or not it conducts current. Programming is completed when the memory cell no longer conducts. When VS2 is coupled to the control gate of the memory cell, the memory cell is being programmed. And, after repeated pulses of this VS2 voltage, the VT of the memory will eventually reach the desired VT level. The larger the offset voltage, the faster the memory cell will program.

The VS2 voltage is pulsed at the control electrode until the VT of the memory cell reaches the desired or target VT value. Figure 33 shows a diagram of a waveform at the control gate of the Flash cell. A memory cell will be programmed using anywhere from a single pulse to about forty pulses, or more. Pulsing of VS2 continues until current stops flowing through the memory cell when VS1 is applied to its control electrode. At the point the memory cell no longer conducts current with VS 1 at its gate, the memory cell's VT will be at the target VT level. As the analog signal varies, the VS1 I and VS2 levels will also track the variation. A higher voltage analog sample will result in higher VS1 and VS2 voltages.

By selecting the appropriate values for the VS1 and VS2 voltages, the resolution and programming time for the memory cells are also adjusted. In an embodiment of the present invention, level shifters 1810 and 1815 are trimmable to allow adjustment of the VS1 and VS2 voltages without mask changes. The VS1 and VS2 voltages can be adjusted during testing (before or after packaging, or both) of the integrated circuits to account for manufacturing and other variations. To provide better resolution, a technique of the present invention is to select the VS1 and VS2 voltages so that about fifty percent or more of the allowed time for programming is used. Better resolution is desirable because this results in the most precise storage representation of the original signal.

Generally, if fewer pulses are required to program a memory cell, this means the cell is programmed using coarser steps. However, the maximum amount of time available to program per sample is dictated by the sampling frequency, as shown in table B below.

**Table B**

| Sampling Frequency fₛₐₘₚ | Time Per Sample | Max Recording Time For 1.92M Cells |
|---|---|---|
| 2 kHz | 500 µs | 16 minutes |
| 4 kHz | 250 µs | 8 minutes |
| 5.3 kHZ | 188 µs | 6 minutes |
| 6.4 kHz | 156 µs | 5 minutes |
| 8 kHz | 125 µs | 4 minutes |
| 16 kHz | 63 µs | 2 minutes |
| 32 kHz | 31 µs | 1 minute |
| 44 kHz | 23 µs | 43 seconds |
| 128 kHz | 8 µs | 15 seconds |

A memory cell should be programmed before the next sample. Shorter programming times are desirable to facilitate higher sampling frequencies. Therefore, level shifters 1810 and 1815 should be designed to support the desired level of resolution and fidelity. By providing trimmable circuitry so the VS1 and VS2 voltages are easily adjusted, this permits greater flexibility in addressing manufacturing variations and "tuning" parts to provide an optimum level of resolution. Particular integrated circuits may also be adjusted to suit the intended application.

Figure 34 shows a timing diagram illustrating operation of the level shifter circuitry. An input signal 1910 is representative of a signal at signal input 1817. A clock signal 1920 is representative of a signal at clock input 1819. A level shift output 1930 is representative of an output of the level shifter circuit (e.g., either VS1 or VS2 outputs). In operation, the level shifter provides a level shifted output 1930 representative of input 1910. The sample and hold circuit, samples when the clock runs, and holds when the clock is stopped on a low phase. In particular, during a period T1, the input signal 1910 is sampled using the clock signal as a sampling clock. Note that during period T1, the output of the level shifter changes to become the level of the input signal v(t) plus a constant, which is the level-shifted value. By the beginning of a period T2, the level shifter output has become its target or final value (i.e., v(t) plus a constant). During period T2 when the clock is low, the value of the input 1910 which has been sampled is held. The output of the level shifter does not change. The level shifter output 1930 is used for programming the memory cell or other purposes. During period T2, the sampled value is stored into a single memory cell by pulsing the level shifter output 1930 at the control gate of the memory cell. After period T2, during a period T3, the analog value is again sampled, similarly as described for period T1 . This technique of sampling and holding is repeated as many times and for the duration desired to store the input signal into the memory cells. For example, to store one minute of an analog signal such as a voice, the process is repeated for the duration of one minute.

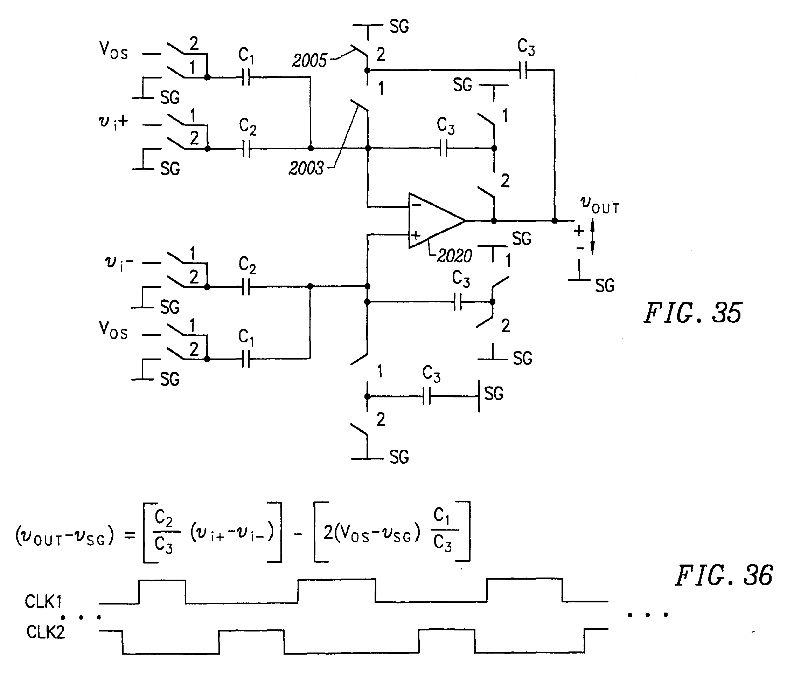

Figure 35 shows a more simplified schematic of a combination voltage level shifter and sample and hold circuit of the present invention. This circuitry can be used to implement level shifter circuit blocks 1810 or 1815 of Figure 32. The circuitry has a number of AC switches that are connected depending on a clock input CLK1 or CLK2, which are nonoverlapping clock signals. For example, the switching of a switch 2003 is controlled by CLK1, and the switching of a switch 2005 is controlled by a CLK2. Figure 36 shows a timing diagram for nonoverlapping clock signals CLK1 and CLK2. CLK1 and CLK2 are nonoverlapping because only CLK1 or CLK2 is high at the same time. A switch will be "closed" when the controlling clock signal is a high. Otherwise, the switch will be "open." For example, when CLK2 is high, and CLK1 is low, the circuitry in Figure 35 will be in a HOLD mode. Because CLK1 and CLK2 are nonoverlapping, a switch controlled by CLK1 and a switch controlled by CLK2 will not be closed at the same time.

The circuitry takes as input a fully differential input signal (e.g., input 1817 of Figure 32) at Vi+ and Vi-. An offset voltage is input at Vos. These inputs are coupled to an operational amplifier 2020. An output is provided at Vout. A signal ground (SG) potential is representative of a signal reference voltage. The circuitry provides a level-shifted output depending on the sizes of the capacitances C1, C2, and C3 according to the following equation: (Vout - Vsg) _ ( C2/C3 * ( Vi+ - Vi- )) - ( 2 * C1/C3 ( Vos - Vsg ) ).

The level shifter circuit also perfoms a differential input to single-ended output conversion. The level shifter output is single ended because the memory is single ended. The level shifter can be designed to have a fully differential output if a fully differential memory is used, but a fully differential memory would use about twice the integrated circuit area as a single-ended memory.

When implemented using the circuit in Figure 35, the VPP level shifter has a trimmable output voltage where (Vₒᵤₜ - V_{sg}) is adjusted by changing the sizes of capacitances C1, C2, and C3. Adjusting C1 adjusts the offset component of the equation. Figure 37 shows offset component 2150. Therefore, by adjusting C1, for a given target VT voltage, a desired value for VPP or VS2 can be obtained. The range of voltages for VS2 is technology dependent, varying depending on parameters such as oxide thickness and channel length. By adjusting C1, the yield of good die may be improved. In a specific embodiment, VS2 ranges from about 5 volts to about 13 volts. The offset voltage between VS1 and VS2 is programmably selectable by adjusting C1. This offset voltage is about 5 volts in a typical case.

The C2 capacitance can also be adjusted. This will adjust the signal component and vary the slope of the VS2 curve (see Figure 37). It is generally desirable for the VS1 and VS2 curves to be parallel because the offset voltage will be constant. In some cases, however, it may be desirable to have a relationship between VS1 and VS2 not having a constant offset voltage.

The C3 capacitance is also trimmable. Adjusting C3 will affect both the offset and signal components since it is a factor in both offset and signal components of the equation.

Figure 38 shows circuitry for implementing a trimmable capacitance that may be used for C1, C2, or C3 of the level shifter in Figure 20. In Figure 38, the size or capacitance for C1 may be programmably selected. A number of capacitors C1A, C1B, C1C, C1D, and C1E are programmably connected in parallel. By combining one or more of these capacitors with C1E, other capacitance values for C1 are obtainable. Capacitors C1A, C1B, C1C, and C1D may be combined or added together with C1E by closing the appropriate switches T1, T2, T3, or T4. In one embodiment, the sizes of capacitors C1A, C1B, C1C, and C1D are weighted in order to obtain a wider range of capacitance values for C1. For example, the capacitor sizes may be binary weighted. In other embodiments, the capacitors are each different sizes (giving different capacitance values), or are the same size (giving the same capacitance value). Capacitors C1A, C1B, C1C, C1D, and any others may be formed using MOS transistors, polysilicon-1 to polysilicon-2 coupling, or other techniques commonly used to form a capacitance on an integrated circuit.

Similar techniques may also be used to form variable sized capacitances for C2, C3, and C4, if desired. In a specific implementation of the circuitry in Figure 38, the VPP output voltage is about 9 volts when signal ground is applied to Vin. The VPP output voltage is programmably adjustable in about 0.13 volt steps.

Figure 38 shows a single-ended version of the level shifter. A fully differential version may be constructed similarly as shown in Figure 35. The programmably connectable capacitors would be connectable to both positive and negative inputs of the operational amplifier. To adjust the value of a particular capacitance, the capacitance value at both positive and negative inputs are charged at the same time. For example, in Figure 35, C1 on both positive and negative inputs is programmably adjustable and will have the same value after adjustment.

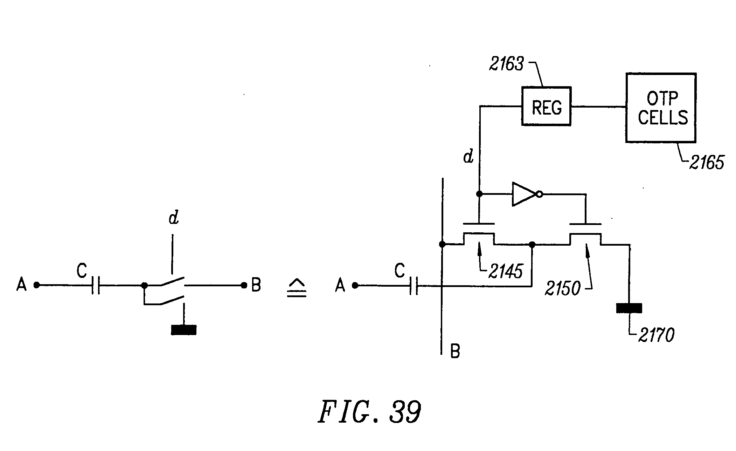

Figure 39 shows a specific embodiment of a switch and a capacitor C that may be used to make a trimmable capacitor of the present invention. In this embodiment, the switch is formed using an NMOS pass gate 2145 and an NMOS pass gate 2150. Other types of pass gates may be used instead; these include a fully complementary pass gate with an NMOS device and a PMOS device. In this embodiment, an on or off state of the pass gates are controlled by a bit stored in a register 2163. The register may be loaded based on information programmed into one-time programmable (OTP) cells 2165. Pass gates 2145 and 2150 receive complementary versions of the control signal from the register. Either pass gate 2145 or 2150 is on at one time. When pass gate 2145 is on, capacitor C is connected between points A and B. When pass gate 2150 is on, capacitor C is connected between A and a fixed potential voltage 2170, which is typically ground. This ensures there will be no problems during operation due to a "floating" capacitor.

Switches T1, T2, T3, and T4 of Figure 38 are static or DC switches. During normal operation, these switches will be in one state or another. However, the other switches in Figure 38 are AC switches that switch, based on a clock, during the normal operation of the circuitry. Figure 38 shows a switched capacitance version of the circuitry. An analogous timed continuous circuit can be implemented using impedances or resistances. In other words, an impedance may be substituted for the switch and capacitor.

The timed continuous implementation can also have a programmable offset. Using a similar technique as for capacitors, a number of resistances can be connected together in such a fashion to allow the total resistance value to be programmably variable. Also, a technique to implement a variable impedance such as in U.S. patent application 09/159,848, which is incorporated by reference, may be used.

There are many other possible implementations for a switch used to make a trimmable capacitor. For example, a switch may be controlled by way of Flash, EEPROM, EPROM, nonvolatile cell, floating gate cell, RAM, DRAM, antifuse, input from the SPI interface, or many other possible sources. Further, in some embodiments, the switches may be laser programmable or directly programmable memory cells coupled to the capacitor. The memory cells will be programmed by the user.

There are many other techniques of implementing a trimmable or variable capacitor, and these techniques may also be used in implementing the level shifter of the present invention.

The procedure to read information from a memory cell is essentially the reverse of the procedure described above to store information into the memory cell. A read circuit 435 (shown in Figure 4) is used to read data from the memory cells.

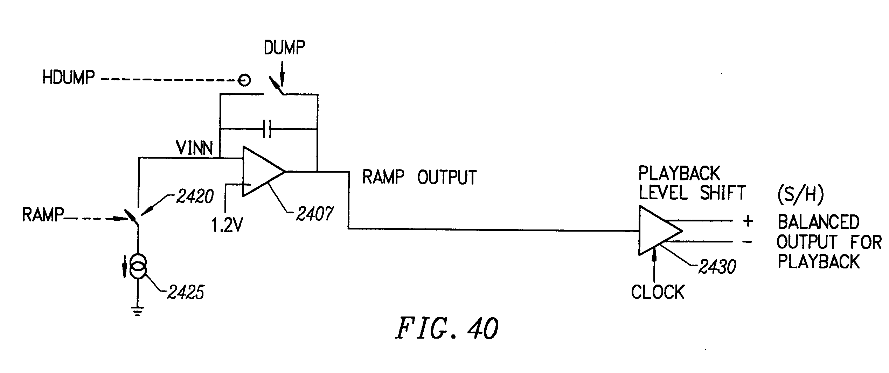

Figure 40 shows a simplified schematic of a ramp circuit and playback level shifter of the present invention. This circuitry is used in one implementation of read circuit 435. The ramp circuit determined the stored VT of a memory cell. The ramp circuitry includes an operational amplifier 2407 having a first input coupled to a VINV signal and a second input coupled to a reference voltage. This reference voltage is 1.2 volts and comes from the master bias generator or a slave bias generator. The first input is connected through a switch 2420, which is controlled by a signal RAMP, to a current source 2425. When RAMP is high, switch 2420 will be closed, coupling the current source to the first input of operational amplifier 2407. When RAMP is low, switch 2420 is open, decoupling the current source from the first input. Operational amplifier 2407 provides a RAMP OUTPUT. A HDUMP switch is coupled to discharge the ramp output based on a DUMP signal. The input to the ramp circuit is single ended because the memory is single ended. The output of the ramp circuit is single ended. A playback level shifter circuit 2430 receives the RAMP OUTPUT and provides a fully differential balanced output for playback. In an embodiment of the present invention, the playback level shifter may also include sample and hold circuitry, which is similar to the case for the record level shifters, VPP and VVFY level shifters, above.

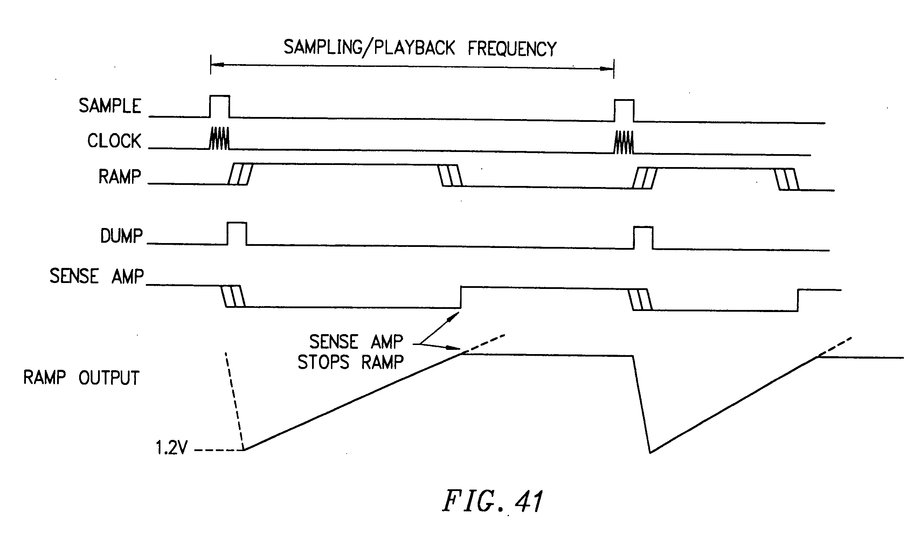

Figure 41 shows a timing diagram illustrating the operation of the read circuit or playback circuitry. This circuitry determines the VT of the memory cell to be read. The stored VT represents the stored information. The circuitry in Figure 40 is run at the sampling frequency used to store the data. The RAMP signal indicates that switch 2415 is closed to begin ramping the voltage at RAMP OUTPUT. As long as the switch is closed, the voltage at RAMP OUTPUT will continue to rise. The initial starting voltage at RAMP OUTPUT is 1.2 volts, which is the reference voltage. A DUMP signal closes the HDUMP switch to reset the circuit to the 1.2-volt level at RAMP OUTPUT. The initial starting voltage can be any voltage other than 1.2 volts, as long as it is below the minimum VT range of the memory cells. Instead of ramping up, the RAMP OUTPUT can ramp down from a predetermined high voltage, higher than the maximum VT range of the memory cells.

To determine the stored VT of a memory cell, the RAMP OUTPUT is connected to the gate of the memory cell. The memory cell is connected to a sense amplifier or other circuit to determine whether the memory cell is conducting or not conducting current. The ramp circuitry continues to ramp the voltage at the gate of the memory cell. The memory cell will not conduct when the control electrode voltage is below its stored VT. The memory cell will conduct when it is above its VT. And, the sense amplifier is low when the memory cell does not conduct, and high when the memory cell conducts, or vice versa. Therefore, the ramp circuitry ramps the control electrode until the output of the sense amplifier changes from low to high, or vice versa. The voltage at RAMP OUTPUT at the point in time when the sense amplifier toggles is representative of the stored VT of the memory cell. This value, representative of the stored VT, at RAMP OUTPUT is provided to the playback level shifter circuitry. The playback level shifter level shifts down this voltage back to the voltage level of the original signal. This is the reverse operation of the VPP and VVFY level shifter.

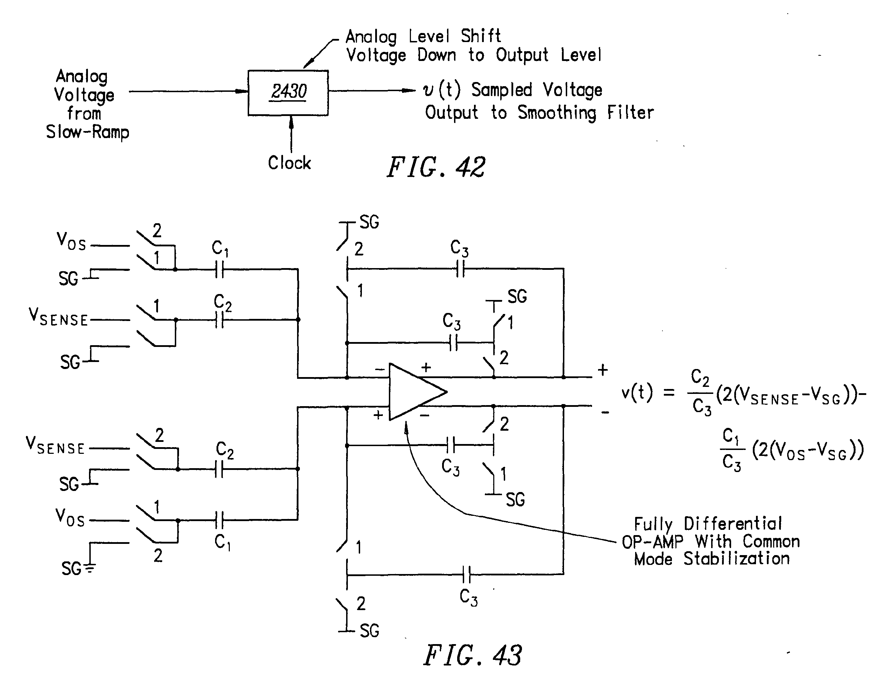

Figure 42 shows a diagram of a playback level shifter circuit 2430. The voltage from the ramp circuit and a clock signal is input to level shifter circuit 2430. An output of the level shifter circuit is a voltage which is level shifted down to the appropriate voltage for playback and re-creation of the originally stored signal.

The voltage ranges input to the ramp circuit and playback level shifter circuit may be above the supply voltage of the integrated circuit, depending on the stored VT of the memory cell. Therefore, similar to the case with the VPP and VVFY level shifters, supply rails for the ramp circuit and playback level shifter circuit are connected to a high voltage above the supply voltage for the integrated circuit. This high voltage can be generated by charge pumps on the integrated circuit.

Figure 43 shows a circuit diagram of an implementation of the playback level shifter circuit. This circuit includes a sample and hold circuit. This circuitry is similar to that described in Figure 36 above. The discussion for the record level shifter applies analogously to the playback level shifter. The playback level shifter also converts the single-ended input from the ramp circuit to a fully differential output. The voltage from the ramp circuit is input to Vsense. A v(t) output of the circuitry has the following relationship: v(t) = C2/C3 * ( 2 * (Vsense - Vsg)) - C1/C3 ( 2 * (Vos - Vsg) ). By varying the sizes of capacitors C1, C2, and C3, the amount of the level shifting is adjustable just as it is for the VPP and VVFY level shifters. In a specific embodiment, capacitor C1 is a programmably variable capacitance. By adjusting the size of capacitance C1, the offset between V(t) and (Vsense - Vsg) is changed. The circuitry to implement a programmable, variable capacitance was discussed above, and is especially applicable to this circuitry.

As shown in Figure 4, an output from the read circuit 435 is coupled to a low pass filter 440. This filter is sometimes referred to as a smoothing filter. This filter produces a continuous output for the playback signal. There are many possible implementations of low pass filter 440. A specific implementation is the low pass filter circuitry shown in Figures 22 and 23, and described above. In a specific embodiment of the present invention, the same on-chip circuitry is used for low pass filter 411 and low pass filter 440. This reduces overall die size. For example, when used for recording, the output of preamplifier is coupled to the low pass filter circuitry. When used for playback, the output of the read circuit is coupled to the same low pass filter circuitry. In other embodiments, separate circuitry is used for the low pass filter for record and playback.

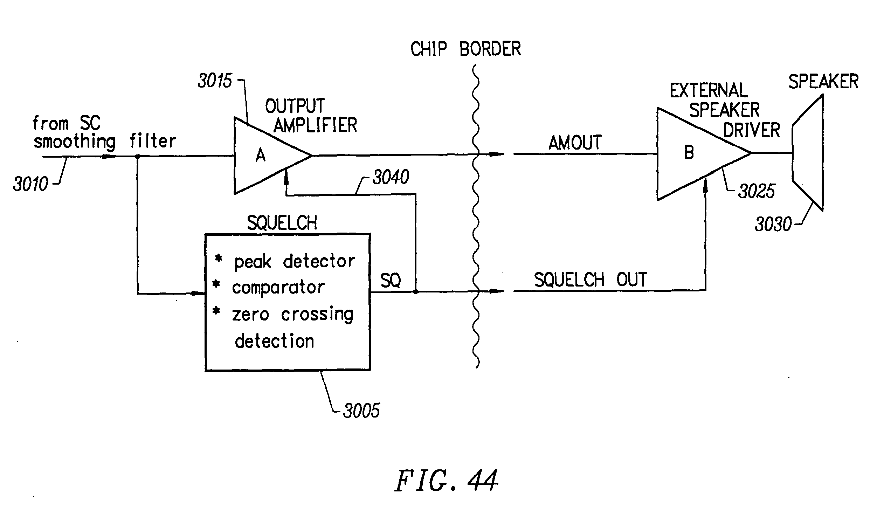

Figure 44 shows circuitry for producing the playback signal at an output of an integrated circuit. This particular implementation includes a squelch circuit 3005. Other implementations of the present invention may not include a squelch circuitry. This is one implementation of squelch circuit 445 of Figure 4. The squelch circuit of the present invention attenuates the output voltage by about six decibels when the input signal level stays below a defined threshold for a defined time. If the signal level is low for a certain time, the background noise is attenuated by this feature. The user can select the defined threshold and defined time, or these parameters may be set by the design. This circuitry is active when used during playback and inactive at other times in order to reduce power consumption.

An output 3010 from the low pass or smoothing filter is input to an output amplifier 3015 and squelch circuit 3005. Output amplifier 3015 has an ANOUT signal output that is representative of the information stored in the memory cells. For example, if voice or other sounds were stored in the memory cells, ANOUT can be used to drive an external speaker driver 3025 and speaker 3030. The voice or other sounds are then played out of the speaker. Output amplifier 3015 provides a gain A0.

Squelch circuit 3005 generates a SQ signal output 3040 to indicate whether the ANOUT signal should be attenuated. Output amplifier 3015 takes as an input the SQ signal 3040. When the SQ input is low, ANOUT will not be attenuated. Output amplifier 3015 provides a gain A0. However, when the SQ input is high, ANOUT will attenuated by the desired amount. Output amplifier 3015 provides a gain A0 of-6 decibels, which is less than in the normal case. The SQ signal can also be provided as an external signal SQUELCH OUT. SQUELCH OUT can be used, for example, to enable or disable the attenuation of external speaker driver 3025.

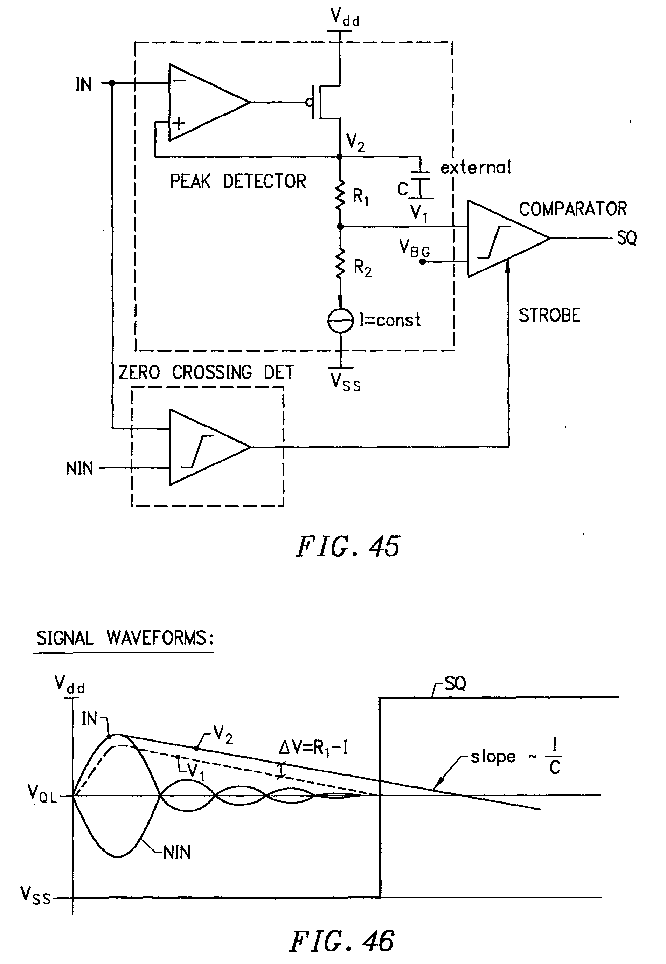

Figure 45 shows a diagram of an implementation of squelch circuit 3005. This implementation includes a peak detector, comparator, and zero-crossing detector. The circuitry operates as follows: The peak detector signal is level shifted by resistor R₁. The resulting signal V₁ is compared to the signal ground level which is equal to the bandgap reference voltage V_{BG}. If V₁ is smaller, squelch becomes active at the next crossing of the signals IN and NIN (i.e., the signal SQ becomes active). The time constant is set by capacitor C and the current I which discharges the node V₂ with the rate I/C.

IN is connected to a positive signal from the low pass or smoothing filter. In a specific embodiment, IN is a fully differential signal. NIN is connected to a negative signal from the low pass or smoothing filter. In a specific embodiment, NIN is also a fully differential signal. C is an external capacitor. R1 and R2 are internal resistors or resistances. I is a current source. STROBE is used to indicate a comparison between V₁ and V_{BG}. V_{BG} is the bandgap reference voltage. A value of (IN + NIN)/2 will be equal to V_{BG}, as set by a common mode feedback circuit in the low pass or smoothing filter.

Figure 46 shows a signal diagram illustrating the operation of the squelch circuit. When SQ is high, the signal is attenuated.

It is contemplated the integrated circuit of the present invention will operate in a relatively wide range of supply voltage conditions. For example, the integrated circuit may be battery powered. Different types of battery packs (e.g., air, lithium, nickel metal hydride, nickel cadmium, lead acid, gel cell, alkaline, zinc manganese) will provide different voltage levels. Furthermore, the voltage levels may also change depending on how much charge remains in the battery.

Depending on the voltage level of the power supply, certain on-chip circuitry may need to be adjusted to reflect this change in operating conditions. An example of such circuitry is the charge pump circuitry used to provide the voltages to program a memory cell. The charge pump voltages are used by the level shifter circuits. Since it is desirable to program multiple data levels in a single memory cell, it is important to maintain precise programming voltages in order to ensure information is properly stored. For example, when the power supply voltage level is relatively high, fewer charge pump stages may be needed compared to the case when the power voltage level is relatively low. By adjusting the charge pump output voltage levels to compensate for supply voltage variation, this allows the integrated circuit to store analog and digital data more precisely-effectively more bits of storage per memory cell.

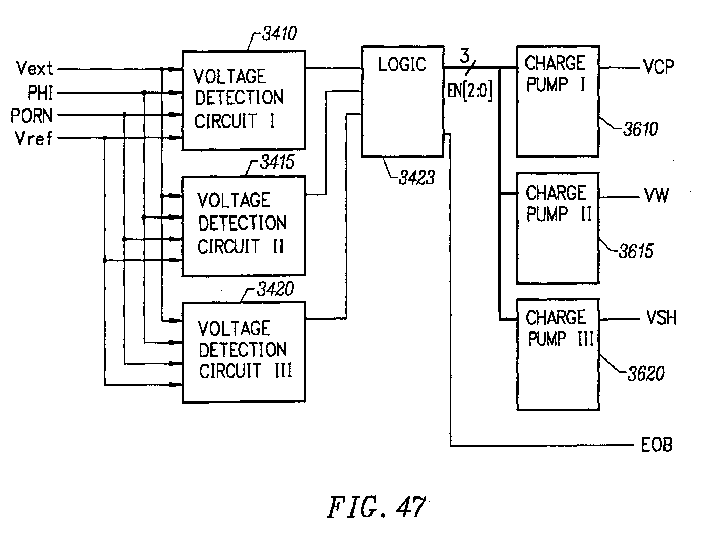

Figure 47 shows an embodiment of circuitry for power supply level detection and adjustment circuitry of the present invention. The circuitry includes three voltage detect circuits 3410, 3415, and 3420 to detect the voltage level of the supply voltage. A number of charge pumps 3610, 3615, and 3620 are adjusted based on the voltage level. If the voltage level is now too low, an EOB signal will indicate this situation. A low supply voltage may mean the battery is low. EOB stands for end of battery life. Each voltage detect circuit has an input for external voltage (Vₑₓₜ), logic signal to update voltage detection (PH1), /power-on reset (PORN), and internal reference voltage (VREF). When PH1 or PORN is asserted, the voltage level detect circuit makes a detection of the supply voltage level at Vₑₓₜ.

Vₑₓₜ is an external voltage. PH1 is a logic signal used to indicate that the voltage detect circuit will perform an updated check of the external voltage. PORN is a power-on reset signal. V_{ref} is an internal reference voltage. EN[2:0] are three enable signals used to enable respective ones of the charge pumps I, II, and III. VCP is an output of charge pump I. This voltage may be about 12 volts. VW is an output of charge pump II. This voltage may be about 6 volts. VSH is an output of charge pump III. This voltage may be about 8 volts. EOB is a logic signal used to indicate a low battery voltage or end-of-battery life.

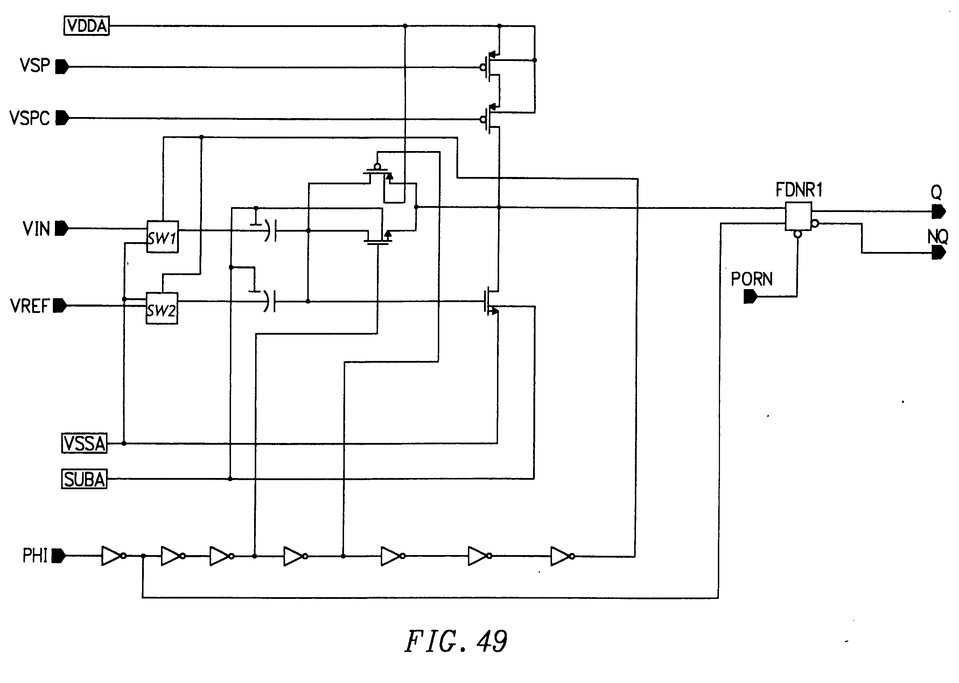

Figure 49 shows a more detailed schematic of a voltage detect circuit. This circuitry can be used to implement the voltage detect circuits 3410, 3415, and 3420 of Figure 47. The voltage detect circuit performs a comparison of a VIN voltage, connected to Vₑₓₜ, to a VREF voltage. The voltage detect circuit provides a high output at node Q when VIN/VREF is greater than C2/C1.

In Figure 47, three voltage detect circuits are coupled together to permit the detection of a number of power supply threshold levels. For example, in a specific embodiment of the present invention, a first level for the power supply may be set at 2.4 volts, a second threshold set at 2.7 volts, and a third threshold set at 3.1 volts. These threshold levels may be set, for example, by inputting the appropriate bias voltage to the VREF of voltage detect circuits 3420, 3410, and 3415, respectively. Another technique of setting the threshold levels is to appropriately select the sizes of capacitors C1 and C2 within the voltage detect circuit. Typical values are a C1 of about 1 picofarad and a C2 of about 2.2 picofarads, depending on the threshold level to be set.

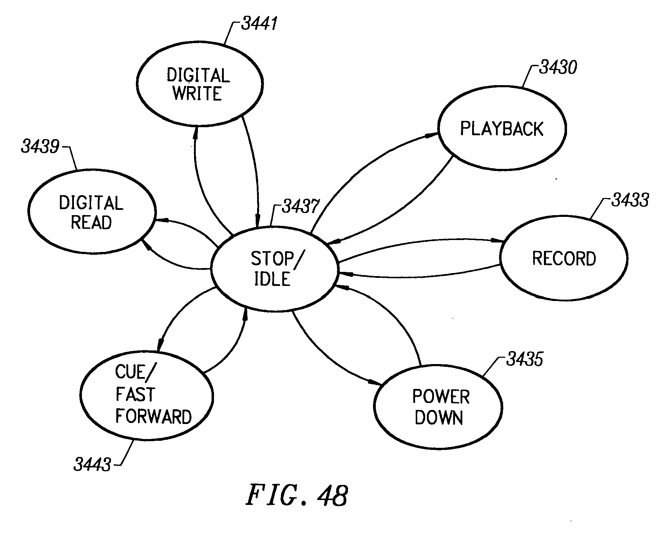

In operation, the circuitry in Figure 47 evaluates the power supply level once upon power-up of the integrated circuit. For example, after supplying power to the integrated circuit, the integrated circuit will be in a "power down" mode. A PWRUP command is input through the SPI interface to initialize the circuitry. Within about 100 microseconds of the PWRUP command, the VDD supply level is detected and any adjustments to the charge pump circuitry is made. The integrated circuit is ready for functional use. In other embodiments of the present invention, the circuitry periodically or continuously evaluates the power supply level. For example, in a specific implementation, the VDD supply voltage level is detected upon the entering of a different mode of operation. As shown in Figure 48, the analog memory integrated circuit has operation modes including playback 3430, record 3433, power down 3435, stop or idle 3437, digital read 3439, digital write 3441, and cue or fast forward 3443. Therefore, when switching from the idle node to playback, the supply voltage level is detected. The supply voltage is detected upon entering any of the modes shown in Figure 48.

Note that in the operational scheme shown in Figure 48, idle mode 3437 is an intermediate mode when switching from any of the other modes in the figure. In other words, there is, for example, no direct path between record and digital read; the idle mode must be entered before switching from record to digital read. This ensures the integrated circuit is operated properly.

Once the power supply level has been determined, this information may be passed to other circuitry on the integrated circuit. The operation of the other circuit can be altered to compensate or account for the power supply level. There may also be an external signal indicative of the power supply level. For example, if the power voltage level is below 2.4 volts, other circuitry on the integrated circuit will receive the EOB signal indicating a low battery condition. Such an EOB signal may also be used to warn the user of the low battery condition. The user can then replace or recharge the battery.

Although Figure 47 shows three voltage detect circuits, other embodiments of a power supply level detection circuit may have any number of voltage detect circuits depending on the number of desired threshold levels. For example, the circuitry will have a single voltage detect circuit if there will only be one voltage threshold level. The circuitry will have two voltage detect circuits if there will be two voltage threshold levels. And, the circuitry may have greater than three voltage detect circuits if it is desirable to have more then three voltage threshold levels.

The circuitry in Figure 47 includes three charge pump circuits: a VCP charge pump 3610, a VW charge pump 3615, and a VSH charge pump 3620. Other embodiments of the present invention include a single charge pump, two charge pumps, or more than three charge pumps. The charge pump circuits 3610, 3615, and 3620 are coupled to different circuitry on the integrated circuit. This permits the generation of various voltages for the operation of the circuitry. For example, VCP charge pump circuit 3610 outputs a VCP voltage that is connected to the supply lines of the VPP level shifter circuit for recording (e.g., level shifter circuit 1810 of Figure 32). VSH charge pump circuit 3620 outputs a VSH voltage that is connected to the target or VVFY level shifter circuit (e.g., level shifter circuit 1815 of Figure 32). VSH charge pump circuit 3620 is also connected to a shield or isolation device for the array. VSH charge pump circuit 3620 is also coupled to the playback level shifter and ramp circuit (see Figure 40). VW charge pump circuit 3615 outputs a VW voltage that is coupled to the drain or bit lines of the selected memory cells during programming.

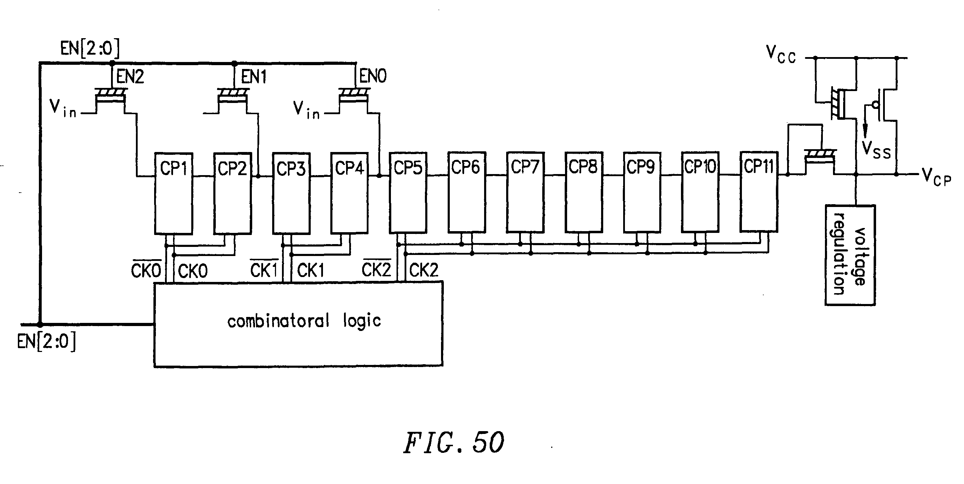

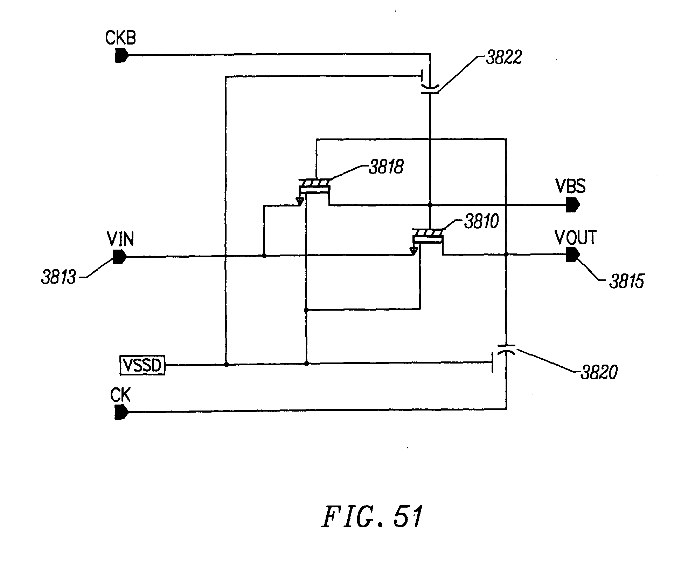

Figure 50 shows a circuit implementation of a charge pump circuit of Figure 47. EN[2:0] are the enable inputs from Figure 47 used to enable the charge pump. CK[2:0] are clock inputs to the individual charge pump stages. Vᵢₙ is an input voltage to the charge pump. V_{cp} is the charge pump output. This charge pump circuit has eleven stages. Circuitry for each of the stages is in Figure 51. The number of stages used in the charge pump depends many factors including the output voltage desired, the process technology used, size of the capacitors, and other considerations. A charge pump circuit of the present invention may have fewer than eleven stages, or more than eleven stages. In a specific embodiment, the VCP charge pump has at most eleven stages, the VW charge pump has at most five stages, and the VSH charge pump has at most six stages.

The number of stages used during the operation of the charge pump will vary depending on the operating conditions of the integrated circuit. The number of stages used will ensure generation of a proper voltage output despite variations in operating conditions such as changes in the voltage supply level. The voltage level of the power supply is possibly detected using the power supply level detection circuitry of Figure 47. Logic circuitry 3423 takes the information from the voltage level detect circuitry and adjusts the charge pump to use only a particular number of stages.

A general relationship is that the number of stages to be used will increase as the power supply voltage level decreases. Additional stages in the charge pump circuit provide an additional boost in the voltage level and current level at the output of the pump. For example, if the power supply voltage level is below about 2.7 volts, all eleven stages of the VCP charge pump are used. If the power supply voltage is between about 2.7 volts and about 3.3 volts, nine stages are used. And, if the power supply voltage is above about 3.3 volts, seven stages are used.

Similarly, for the VW charge pump, when VDD is below about 2.7 volts, all five stages are used. When VDD is between about 2.7 volts and about 3.3 volts, four stages are used. And if VDD is above about 3.3 volts, three stages are used. For the VSH charge pump, when VDD is below about 2.7 volts, all six stages are used. When VDD is between about 2.7 volts and about 3.3 volts, five stages are used. And when VDD is above about 3.3 volts, four stages are used.

The voltage range output of the charge pump circuit may be in any desired range. For example, the VCP charge pump circuitry generates a VCP voltage of about 12.8 volts to facilitate the program and erase of Flash memory cells. The VCP voltage will range from about 11.8 volts to about 13.8 volts. In other embodiments, voltages for programming the memory cells are in a range from about 5 volts to about 16 volts. The VW charge pump generates a VW voltage of about 6.4 volts, which can range from about 5.4 volts to about 7.4 volts. The VSH charge pump generates a VSH voltage of about 7.8 volts, which can range from about 6 volts to about 9 volts.

The charge pump circuitry may be adjusted by using metal options, trim bits, and other similar techniques. For example, the level of the output voltage of the charge pump is adjusted by programming one or more trim bits appropriately. By allowing for such adjustments in the charge pump circuitry, especially after the integrated circuit has been fabricated, this may increase the yield of good product die. The circuitry will be functional because the trim bits allow adjustments to account for skews in the process parameters.

Figure S shows an embodiment of a stage of a charge pump. A transistor 3810 is connected between an input 3813 and an output 3815. A transistor 3818 is connected between the gate of transistor 3810 and input 3813. A gate of transistor 3818 is connected to output 3815. A capacitor 3820 is connected between a clock signal and output 3815. A capacitor 3822 is connected between a /clock signal and the gate of transistor 3810. In a specific embodiment, transistors 3810 and 3818 are lower VT transistors than other transistors on the integrated circuit. These transistors may be native devices having a VT of from about 0.2 volts to about 0.4 volts. Although standard VT transistors may be used, native transistors will improve the efficiency of the pump stage.

In operation, when the clock is pulsing, transistor 3810 acts as a diode, passing charge from input 3813 to output 3815. Charge builds up at output 3815, and the voltage level increases. Transistor 3818 is used to bootstrap the gate of transistor 3810 to the VT plus the voltage level at input 3813 (passed from the previous stage). With multiple stages, charge is passed from stage to stage until the desired voltage level output level is obtained.

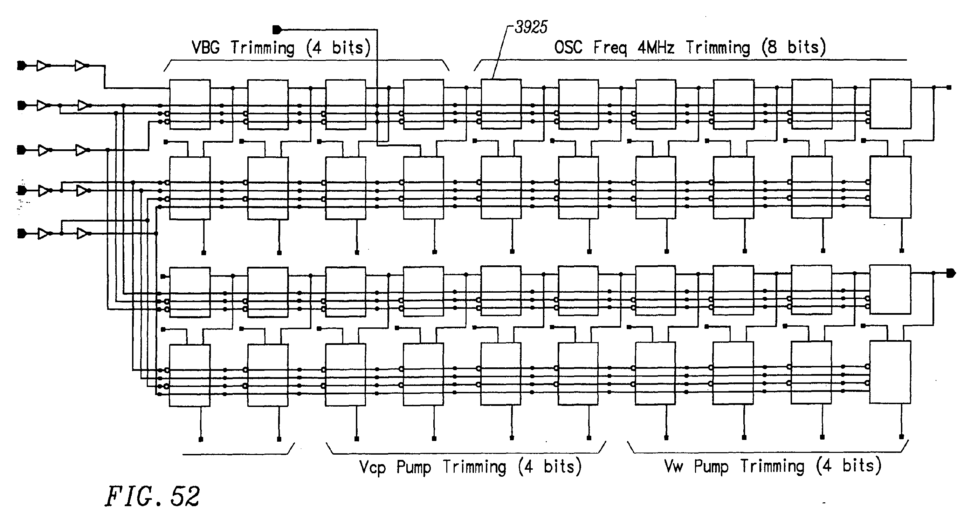

Figure 52 shows a plurality of trim bits 3925 of the present invention. In particular, trim bits are memory bits that are programmed to control the operation of the on-chip circuitry. There are many different ways to implement trim bits including using one-time programmable cells, digital memory cells, analog memory cells, fuses, antifuse, and many others. In a specific embodiment, the trim bits are implemented using one-time programmable cells which are formed within or nearby the analog array area of the integrated circuit. There may be any number of trim bits. For example, there may be four bits for controlling the bandgap voltage generator (VBG), eight bits for controlling the internal oscillator (OSC) clock frequency, four bits for controlling the charge pump generating the VCP voltage, and four bits for controlling the charge pump generating the VW voltage.

Each of the trim bits includes sense amplifier circuitry to sense a state of the trim bit. In a specific embodiment, the trim bit is sensed only once during power-up of the integrated circuit. A sense amplifier generally consumes power while the sense amplifier is actively sensing. Therefore, by turning off the sense amplifier after the state of the trim bit has been determined, this conserves power. The state of the trim bit is not expected to change during the normal operation of the device.

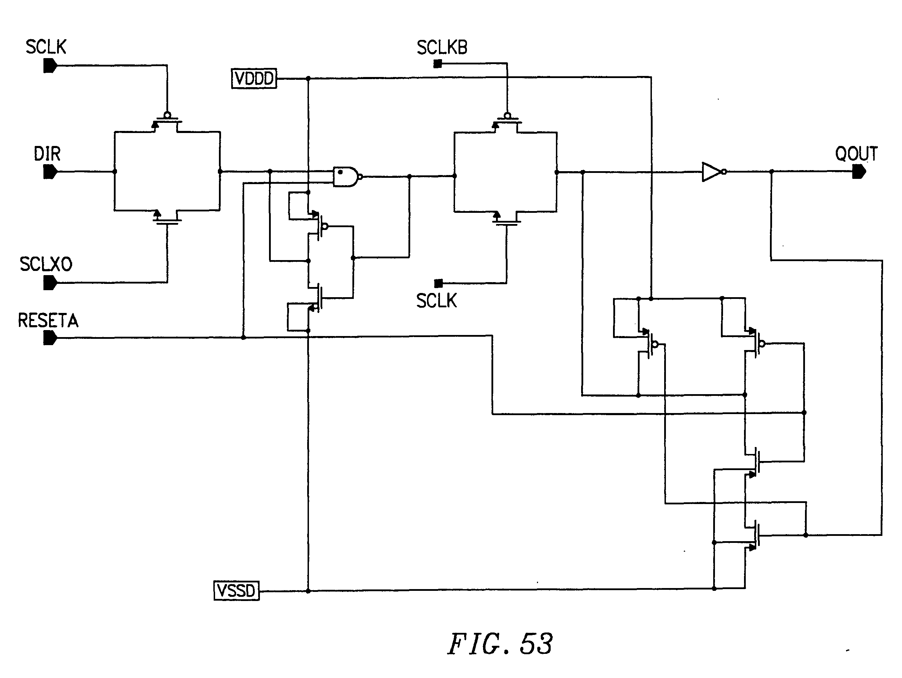

After sensing, the state of a trim bit is stored in a storage block such as a latch, flip-flop, register, or SRAM cell. Figure 53 shows an implementation of sensing and latch circuitry for a trim bit. This is one particular implementation, among others, of a latch circuit. The latch circuit holds the state or value of the trim bit after the trim has been sensed.

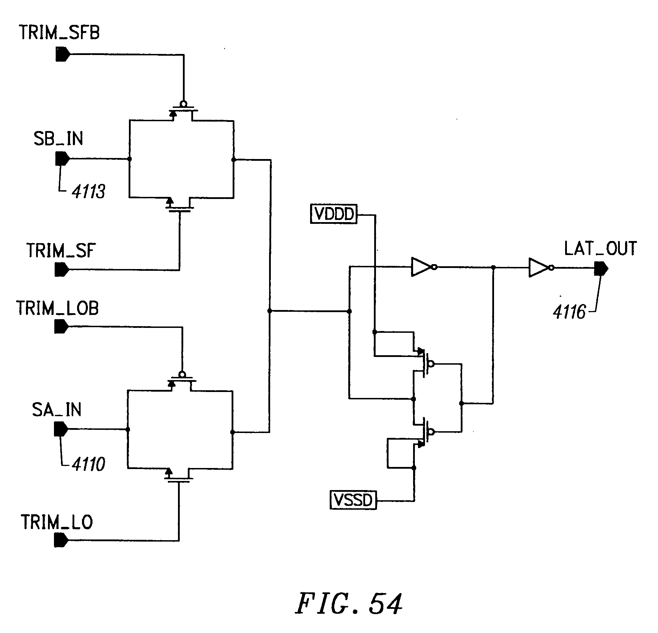

Figure 54 shows multiplexer and latch circuitry for selectively coupling either the trim bit 4110 or user-selected data 4113 to the circuitry to which the trim bit adjusts the operation of via output 4116. The multiplexer circuit allows the circuitry to be adjusted using user-selected data instead of what is stored in the trim bit. Under some cases such as testing, it is desirable to "override" the trim bit with user data. In particular, a user may input user-selected data into a register, shift register, or other storage block. The user data may input in parallel or in serial, such as through the SPI interface. Then, by appropriately configuring the multiplexer, the user-selected data will be used for testing or evaluation of the circuitry on the integrated circuit instead of the trim bit.

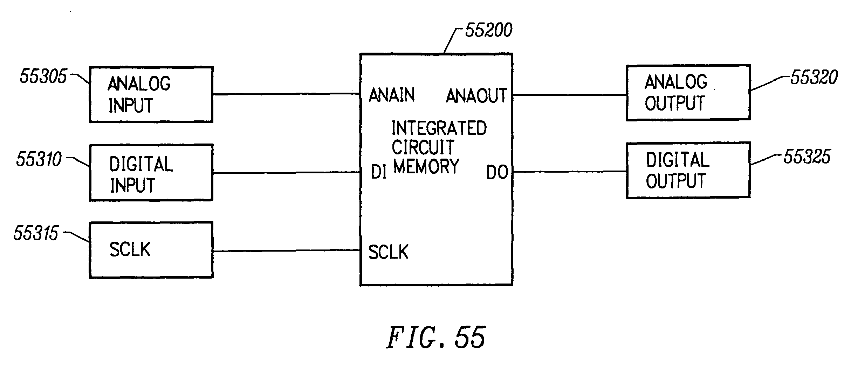

Figure 55 shows a simplified block diagram of the integrated circuit memory 55200 with analog or multilevel memory cells of the present invention. Data comes in both digital and analog forms. It is desirable to have a integrated memory device capable of storing both analog and digital data. Some applications where analog and digital data are frequently intermixed are electronic answering machines and voice recorders. Voice messages and notes will be in analog form. Dates, times, message numbers, telephone numbers will be in digital form. The integrated circuit of the present invention permits the storage and retrieval of data in analog and digital forms. An analog input 55305 is coupled to the ANAIN input (i.e., ANAIN+ and ANAIN- for a differential input signal). A digital input 55310 is coupled to DI. An shift clock or SCLK input 55315 is coupled to SCLK to clock in data at DI or clock data out at an output DO. An analog output 55325 is coupled to ANAOUT (i.e., ANAOUT+ and ANAOUT- for a differential output signal). A digital output 55325 is coupled to DO.

To store an analog signal, the signal is provided at the ANAIN input. The analog signal is sampled at a particular sampling frequency. These samples are stored in the memory cells of the integrated circuits. Typically, each memory cell will hold a single sample of the analog signal. However, in cases were greater precision is desired, two or more memory cells can be used in combination to hold a single sample. A procedure that is essentially the reverse of the storage procedure is used to retrieve and reconstruct the stored analog signal. In short, circuitry determines the analog signal equivalent for each stored sample, and these analog signal equivalents are streamed or "played back" at the originally stored sampling frequency. In an embodiment, the memory cells are nonvolatile cells such as Flash, EPROM, EEPROM, and other floating gate technologies. The present invention is also applicable to other memory cell technologies, both nonvolatile and volatile.

The sampling frequency used may be preset in the design of the integrated circuit. For example, the integrated circuit may sample using a sampling frequency such as 4 kilohertz, 5.3 kilohertz, 6.4 kilohertz, 8 kilohertz, or other frequencies. These frequencies may be selected at the fabrication facility by using the appropriate mask. However, once the chip is fabricated, the user cannot change its sampling frequency. In other embodiments, this sampling frequency is selected by the user. For example, the integrated circuit may use any one of the sampling frequencies such as 4 kilohertz, 5.3, kilohertz, 6.4 kilohertz, 8 kilohertz, or other frequencies that the user selects. One technique for a user to indicate the selected sampling frequency is by varying the size of an external resistor (or other component such as a capacitor or inductor) connected to an input of the integrated circuit. Another technique is for the user to configure or program storage locations or memory cells in the integrated circuit to indicate the use of a particular sampling frequency. A further discussion of this feature is found in U.S. provisional patent applications 60/091,366 and 60/116,760.

Using this approach, the sampling frequency can be dynamically changed during the operation of the integrated circuit. For example, two messages may be stored using different sampling frequencies within the same integrated circuit. The user may select a high sampling frequency for higher fidelity and a lower sampling frequency for lower fidelity. At a lower sampling frequency, a longer duration of a voice signal may be stored using the same memory capacity. This change in sampling frequency is made simply by electronic control and selection, without physically changing the circuit board.

A user can select the sampling frequency by inputting data to the integrated circuit. The data can be binary bits input in parallel or in series to indicate what sampling frequencies the user desires. This sampling frequency selection is stored on-chip in a register or other memory, and possibly in nonvolatile memory cells. In a specific implementation, the user-selectable sampling frequency is selected by using an SPI interface of the integrated circuit. The SPI interface and SPI commands are discussed further in U.S. provisional patent application 60/091,326. In this embodiment, the same pins (e.g., DI) used to input the digital data to be stored in the analog memory cells are also used to input the selection of the sampling frequency. For example, the user may input a serial string of bits, such as 001000000000000000010 at the DI input pin to indicate a sampling frequency of 8 kilohertz will be used. For writing of digital data, the digital data is input at DI.

The user-selectable sampling frequency feature in the present invention is implemented through an SPI "PWRUP" command, which is a power-up instruction. The first five bits "00100" in the SPI string is the op code for PWRUP. PWRUP resets the device to initial conditions and sets the sampling frequency and divider ratios. The op code is followed by a string of fifteen bits, A14 to A0. The A1 and A0 bits select the internal sampling frequency. For A1 and A0 of 00, respectively, a 6.4 kilohertz sample rate is selected. For 01, the sample rate is 4.0 kilohertz. For 10, the sample rate is 8.0 kilohertz. And for 11, the sample rate is 5.3 kilohertz.

To store digital data, the digital bits are input at DI and clocked into the memory cells using SCLK. The digital bits are stored in the memory cells of the integrated circuit. These memory cells are in the same memory array of the integrated circuit used for analog signal storage. Therefore, with 1.92 million cells, the integrated circuit will store a maximum of 1.92 million digital bits, and no memory cells will be left for analog storage. The total number of cells used for digital storage (DS) and the total number of cells use for analog storage (AS) should not exceed the total number of memory cells (TS), i.e., DS + AS ≤ TS.

Although only a single DI pin is shown, there may be any number pins for parallel digital input. For example, for parallel input of eight bits or a byte of data, the integrated circuit may have digital input pins DI0 through DI7. For sixteen bits, there will be pins DI0 through DI15. With a single DI pin, digital data is input one bit at a time or serially. In an embodiment of the present invention where there is a single digital input pin DI, the memory may be used like a serial memory. In particular, if the memory has nonvolatile cells such as Flash or EEPROM cells, the integrated circuit would handle digital data similarly to a serial EEPROM or serial EPROM. Also, the integrated circuit may be used like a first-in, first-out (FIFO) memory.

An application of an integrated circuit of the present invention is to serve as nonvolatile analog storage and also as nonvolatile digital data in an electronic system. For example, since volatile integrated circuits lose their stored data after power down, when these integrated circuits are powered up, they need to be reconfigured with the appropriate data. The analog memory integrated circuit may serve as a source of nonvolatile digital configuration data. This digital data is loaded from the analog memory into other devices of the system upon power-up of the system. These volatile memory devices (e.g., SRAMs, DRAMs, FPGAs, PLDs) may use SRAM, DRAM, or other volatile technologies. Therefore, another nonvolatile storage device such as an additional parallel of serial EPROM is not needed in the system. This saves valuable printed circuit board space.

Furthermore, the digital storage of the present invention can be used to store frequently used numbers, word, or sound bites. For example, information such as the days of the weeks (i.e., Sunday, Monday, Tuesday, Wednesday, Thursday, Friday, Saturday), ordinal numbers one through fifty-nine (e.g., one, two, three, four, and so forth), and DTMF sounds, may be digitally stored or stored in analog. These types of information will be retrieved and linked together as needed by the electronic system to provide information messages such as: "You have three new messages. Message one was received on Tuesday at 3:15 p.m." This sound bite or message linking scheme will greatly ease the re-use of the commonly used sound bites and reduce the amount of memory used.

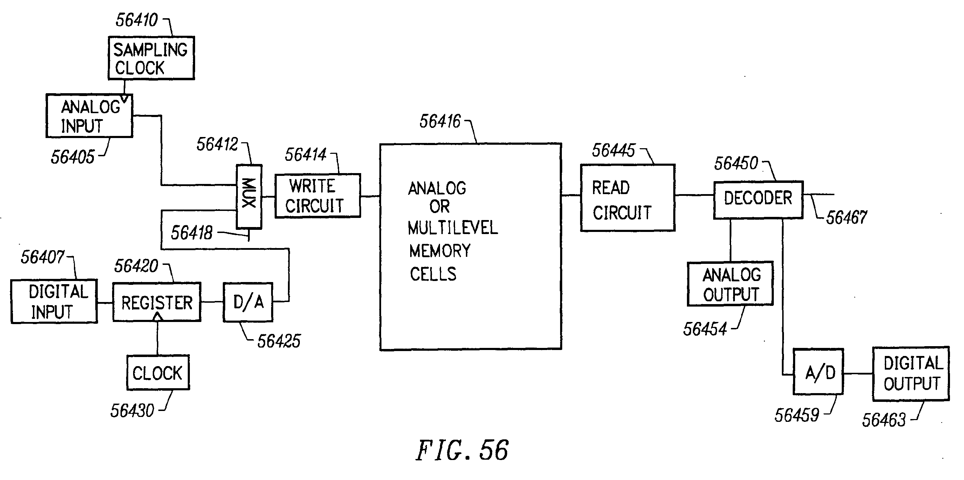

Figure 56 shows a block diagram of the circuitry for an embodiment of an integrated circuit of the present invention. There is an analog input 56405 and digital input 56407. The data at the analog input is sampled using a sampling clock 56410. As discussed above, this sampling clock may be an on-chip programmable oscillator allowing the user to select a desired sampling frequency. The digital and analog inputs are connected to a multiplexer 56412 to selectively pass the digital or analog data to a write circuit 56414. Write circuit 56414 is the circuitry that stores the digital or analog data into memory cells 56416. In the case of Flash or EEPROM cells, the write circuit 56414 will generate the high voltages needed to configure these cells. The write circuit includes circuitry to erase and program the memory cells. In some embodiments, the memory cells may need to be erased before storing new data.

In one embodiment, the write circuit includes a level shifter circuit. The level shifter circuit takes its analog input and generates a level shifter output voltage in a voltage range suitable for storing the analog level. The level shifter output voltage is the threshold voltage (VT) the nonvolatile memory cell will be configured to store. Some embodiments for the write circuitry are described in U.S. provisional patent applications 60/091,326 and 60/116,760 and also U.S. patents 5,694,356, 5,687,115, and 5,745,409, which are incorporated by reference.

Multiplexer 56412 is be implemented using one of the many techniques used to implement a multiplexing function to pass analog voltage levels in an integrated circuit. The multiplexer may be implemented using transmission gates with control signals connected to control nodes (e.g., gates) of the pass transistors. Another example of a multiplexing circuit is a summing amplifier, where the unselected input or inputs are set to zero.

A control input 56418 of multiplexer 56412 controls whether analog or digital data is connected or passed to write circuit 56414. There are many different techniques of controlling control input 56418. For example, control input 56418 may be controlled by an external input to the integrated circuit, such as commands given through a serial port interface (SPI). Further details of a SPI interface and SPI commands are described in U.S. provisional application 60/091,326. The signals provided through the SPI interface may be from an external device, such as a controller or microprocessor. Another technique to control multiplexer 56412 is to detect activity on the analog or digital input pin, and store digital or analog data depending on which pin has activity. In the case when both pins are active at the same time, priority may be given to the analog or digital input pin, and the other pin can be buffered. Alternatively, the integrated circuit can generate a "busy" signal to indicate it cannot accept data on the digital or analog input pin.

In a specific implementation of an SPI interface in present invention, to handle digital data, there are DIG_ERASE, DIG WRITE, and DIG_READ commands. The DIG_ERASE command (op code 01010) erases all data contained in the sector specified by a sector address of bits A14 to A0. The DIG_ERASE step is required to erase a sector before writing new data into the memory cells using DIG_WRITE command. However, to store new analog data, there is a built-in automatic "look-ahead-erase" step to erase the old analog data of the selected sector before writing the new analog data into the memory cells.

The DIG_WRITE command (op code 01011) stores 3K bits of digital data in the specified sector. Digital data is input at DI. In an implementation, all 3K bits of a sector must be written, and no partial usage of the sector is allowed. When digitally writing to the memory cells, all memory cells in a sector are written to, whether or not the user has enough digital data to occupy the entire sector. The "extra" memory cells in a sector are written with some digital value such as a 0 or 1. This technique of writing all the memory cells in a sector improves the reliability and increases the longevity of the memory cells. The reason is that a digital erase erases all the memory cells in a sector, and is performed before each digital write. Therefore, if only the sector is partially written during the digital write, and the other cells are left in the erased state, these other cells may become "overerased" if on many subsequent erase and write cycles these cells are never written. An overerase condition for the memory cells is undesirable because overerased memory cells may fail subsequently to read or write. Consequently, the technique of requiring every cell in a memory sector to be written will prevent the overerase condition from occurring. There are many variations of this technique to achieve the same purpose of preventing overerase.

The DIG_READ command (op code 01111) instructs the device to retrieve digital data that was previously written to the specified sector. The memory acts like a first-in first-out (FIFO) memory, where the first data bit shifted in will be the first data bit shifted out (at DO). The first bit shifted out is the first bit that was written. The last bit shifted out is the last bit that was written.

In an implementation, the SPI interface is used for both selection of the sampling frequency and providing the digital data. This provides a familiar and consistent user interface.

A sector of the present invention is a grouping of memory cells in the array. The sector can have any number of memory cells. In an embodiment of the present invention, a sector size is 3K cells. All the memory cells in a sector have a common source line (SL). By sharing a common source line, all the cells in one sector can be erased at one time.

In the digital data path, between digital input 56407 and multiplexer 56412 is circuitry including a register or storage device 56420 and a D/A converter 56425. This register or storage device can be implemented using flip-flops, memory cells, and other storage circuits. For example, register 56420 may be a FIFO or shift register. The register stores the digital data from the digital input. The digital data is clocked in using a clock input 56430 (e.g., SCLK). From the register, the data is output to D/A converter 56425 that generates an analog signal representation of the digital data. This analog signal representation will be passed through multiplexer 56412 to write circuit 56414 for storage into the memory cells. The same write circuitry used to store the analog data will also store the digital data.

By using the same write circuit for analog and digital writes, the digital data is stored in the memory array using a scheme that is consistent with analog data. Among the advantages of these scheme are that there does not need to be separate tuning or tweaking of separate write circuitries. Layout space is saved on the integrated circuit and power consumption is reduced.

The D/A converter may also be referred to as a digital reference generator. For each different digital value, the D/A converter will generate a unique, corresponding analog value equivalent. For example, for a single digital bit, the D/A converter may generate an analog voltage of about 6.5 volts for a logical 1 input and an analog voltage of about 3.5 volts for a logical 0 input. For a 2-bit digital value, the D/A converter will generate four different analog value equivalents. Therefore, for an n-bit digital value, the D/A converter will generate 2ⁿ different analog values. The exact analog voltages the D/A converter or digital reference generator generates depends in part on the range of analog voltage inputs into the integrated circuit and the range of voltage thresholds that can be programmed into a memory cell.

In an embodiment, this D/A converter is designed to provide a relatively large voltage margin between each of the analog voltage equivalents. This is analogous to having a D/A converter with a large step size. A large margin will improve the integrity of the stored data because it will be easier to distinguish between one digital value and another. This will improve noise immunity and also increase the longevity of the integrated circuit, characterizing or lessening the impact of changes or degradation of the characteristics of the memory cells over time. For the case of an analog floating gate memory cell, the cell is configurable to have a threshold voltage or VT in a range or band. For example, the memory cell may be configured to have a stored VT from about 3.5 volts to about 6.5 volts. When storing a single bit of data, the greatest amount of margin is obtained when the stored VTs for 0 and 1 are at the ends the range, for example, 3.5 volts and 6.5 volts. This will permit the greatest amount of margin. Generally, when storing n bits of data, the greatest amount of margin is obtained by evenly dividing the range into 2ⁿ different analog values. However, due to differences in possible memory disturb mechanisms or leakage of the stored charges, or both, associated with different VTs and different read and write conditions, the levels or step sizes can be nonuniform. The D/A converter generates the voltages for the write circuit so the digital data is stored in the memory cells to the appropriate VTs.

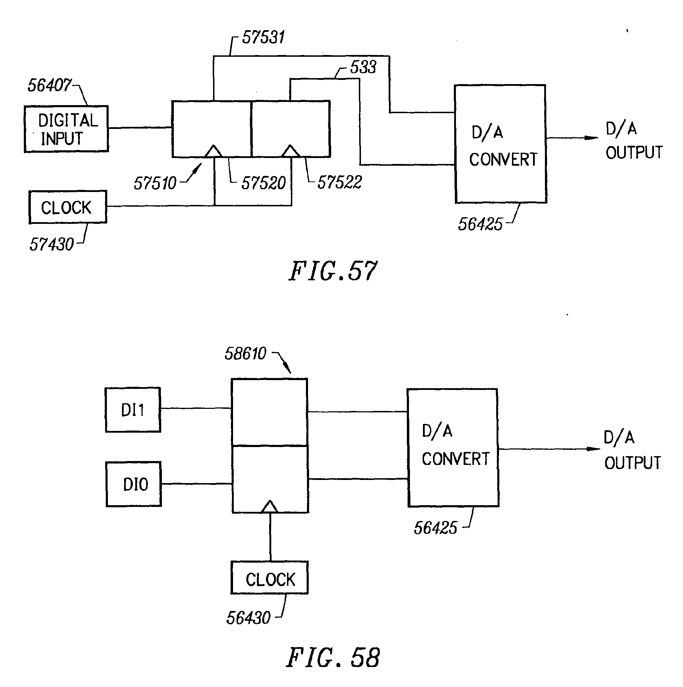

Figure 57 shows another more detailed diagram of an embodiment of the digital input path circuitry. Data from the digital input is clocked into a 2-bit shift register 57510 using clock input 56430. Shift register 57510 includes individual registers 57520 and 57522. Although Figure 57 only shows a 2-bit register, a larger shift register can be formed by connecting the output from one shift register into the input of another, and so forth. Data is serially shifted into the shift register from SPI input DI pin. The shift register is connected in parallel to D/A converter 56425 through lines 57531 and 57533. This permits input of parallel digital data to the D/A converter to more rapidly determine the corresponding analog equivalent value.

Figure 58 shows another embodiment of the digital input path circuitry. This embodiment illustrates parallel input of digital data onto the integrated circuit. There are two digital input pins DI0 and DI1. Digital data is clocked using clock input 56430 into a 2-bit register 58610. Register 58610 is connected to output the digital data in parallel to D/A converter 56425. A parallel connection to the D/A converter allows more rapid conversion of the digital data to an analog representation, since the conversion occurs by using many bits at one time.

The analog and digital data are stored in the memory cells. The same memory cell that is used to store analog data may also be used to store digital data on a different occasion. Each memory cell can store anywhere from a single bit of digital data to multiple bits of digital data. For example, the memory cell of the present invention can store two, three, four, five, six, seven, eight, or more bits of data. Similar considerations as discussed above for the storage of analog data in a memory cell also apply to the multilevel storage of digital data in a memory cell. As is expected, there will be greater noise margins if fewer bits are stored per memory cell. A single bit of storage per memory cell is easily implemented and provides the greatest noise immunity. Greater storage densities are desirable, and approximately six bits of digital storage per memory cell is feasible using the techniques and circuitry of the present invention. As technology improves, the techniques and circuitry of the present invention can be extended to eight, nine, ten, eleven, twelve, thirteen, fourteen, fifteen, sixteen, and more bits of storage per memory cell.

There are many possible arrangements for memory cells 56416 in an integrated circuit of the present invention. For example, the memory cells may be arrayed in rows and columns and divided into sectors.

Figure 56 further shows the circuitry in the integrated circuit for retrieving analog and digital data from the memory cells. A read circuit 56445 retrieves the information stored in the memory cells by determining stored VTs. Some embodiments for the write circuitry are described in U.S. provisional patent applications 60/091,326 and 60/116,760 and also U.S. patents 5,638,320, 5,751,635, 5,748,534, and 5,748,533, which are incorporated by reference.

The data stored in the memory cells will be analog or digital data. If analog data, a decoder 56450 will selectively pass the retrieved analog signal to an analog output 56454. The reconstructed analog signal will be played back at the analog output. The analog signal is played back at a playback frequency which is typically the same as the sampling frequency. As is the sampling frequency, the playback frequency is user selectable. If digital data, the decoder will selectively pass the data to an A/D converter 56459 to obtain the original digital value. This digital value is output at a digital output 56463. Furthermore, in an embodiment, by using control input 56467, the signal from the read circuit 56445 may be passed to both analog output 56445 and A/D converter 56459 at the same time. One of the uses of this simultaneous output feature is for testing purposes. Control of the decoder is by way of a control input 56467. Control input 56467 determines whether the output from read circuit 56445 is passed to the analog or digital output circuitry. Control input 56467 may be controlled through the SPI interface or through internal circuitry, such as an on-chip controller, that maps what type of data each memory cell is storing.

An external microcontroller may maintain a mapping table of which memory cells store analog data and which store digital data. However, in more highly integrated embodiments of the present invention, the memory integrated circuit includes the mapping circuitry or controller on-chip. For example, the memory integrated circuit of the present invention may also include an array of SRAM memory or registers that will be an address mapping table. This mapping table would control addresses of the nonvolatile memory where messages and data are stored and the length of the stored information. The mapping table also stores whether the information is analog or digital. The content of the SRAM table may be stored in the on-chip nonvolatile memory and load the data into volatile SRAM upon power-up.

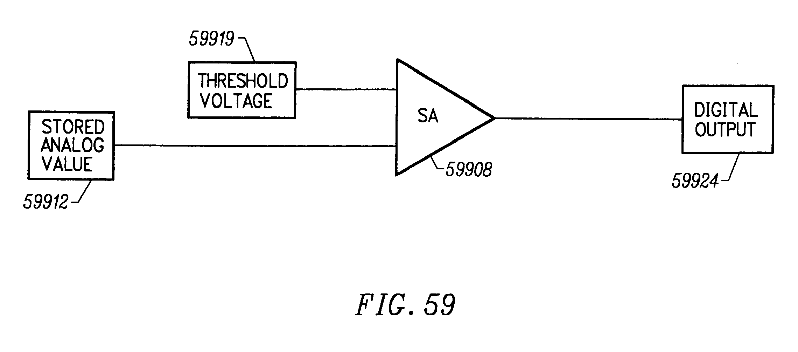

A/D converter 56459 determines the corresponding digital representation for an analog input value. Its function is essentially the reverse of that of D/A converter 56425. There are many different circuit embodiments for A/D converter 56459. Circuitry for one such embodiment is shown in Figure 59. When there is a single stored digital bit per cell, one technique is to use a sense amplifier 59908, or a comparator, to detect whether the stored analog value 59912 is above or below a reference voltage 59919. This reference voltage is selected to be in the middle between the analog voltages for a 1 and 0. For example, if a 1 is 6.5 volts and a 0 is 3.5 volts, the reference voltage should be about 5 volts. If the stored analog value is above this reference value, the digital output is a 1 at 59924. VDD or another appropriate voltage is provided at digital output 59924. If the stored analog value is below the reference voltage, the digital output is a 0. Ground or another appropriate voltage is provided to the digital output.

In the case n bits are stored per cell, a multilevel sense amplifier or sensing technique would determine which of the 2ⁿ digital values corresponds to the stored analog value. The circuitry may include a single sense amplifier or series of sense amplifier working together. When multiple sense amplifiers are used, the sense amplifiers can operate in series or in parallel. In a series implementation, the signal is connected through a number of sense amplifiers arranged serially. In a parallel implementation, the signal is connected to a number of sense amplifiers arranged in parallel. Of course, some circuit implementations of the sense amplifier may include both serial and parallel arrangements.

The sense amplifier or sense amplifiers detect multiple stored levels and generate the appropriate digital value. Circuitry such as the level detection circuitry used in the VCC voltage level detection circuitry of the present invention, discussed in U.S. provisional patent applications 60/091,326 and 60/116,760, may be adapted and used to retrieve the digital values stored in the analog memory array.

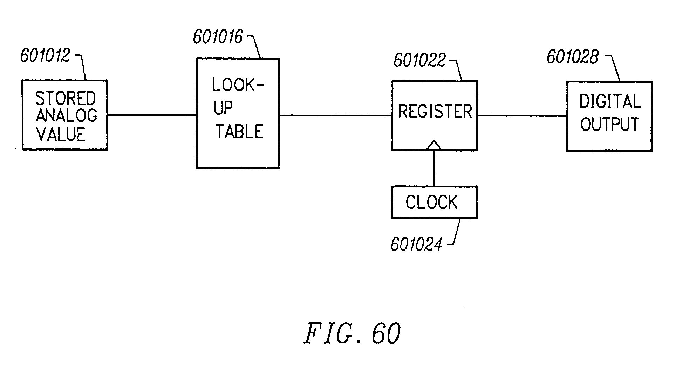

Figure 60 shows a further embodiment of circuitry for the digital output path. The stored analog value 601012 is input into a look-up table (LUT) circuit 601016. The look-up table circuitry provides an analog look-up table function. For each analog value in the table, there is a corresponding digital value. The look-up table outputs this digital value. In an embodiment, the look-up table may be implemented using sense amplifiers, arranged in parallel or series. For example, this may be a 4-bit digital value in the case four bits are stored in each memory cell. The digital value may be output to a register 601022 in parallel or serial. The digital data may be clocked out to a digital output 601028 using clock input 601024 in parallel or serial.

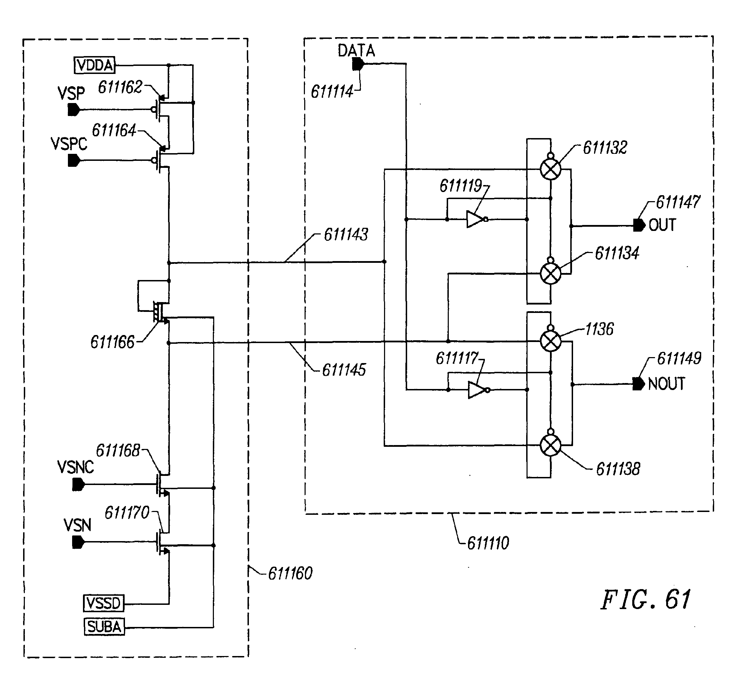

Figure 61 shows a circuit diagram of an implementation of a D/A converter or digital reference generator for analog memory storage. As discussed above, the digital reference generator permits storage of binary or digital data in the memory array using the same write and read circuits, and the digital scheme is consistent with the storage of analog data. This implementation of the digital reference generator generates analog equivalents for a single bit of digital data.

The digital reference generator includes a digital data input circuit 611110 and bias voltage generator circuit 611160. Digital data is input at a digital data input 611114. An analog output equivalent to the digital data is output at OUT 611147 and NOUT 611149. OUT and NOUT are differential outputs of the digital reference generator. A differential output signal for the digital reference generator is needed in the case when the analog signal path in the integrated circuit is differential. In a memory integrated circuit such as in Figure 4, OUT and NOUT are connected to write circuit 56414, and more specifically, a level shifter circuit.

Digital data input 611114 is connected to inverters 611117 and 611119. Digital data input 611114 and inverters 611117 and 611119 are connected to control four transmission gates 611132, 611134, 611136, and 611138. In a specific embodiment, each of the transmission gates is implemented using an n-channel or NMOS transistor and a p-channel or PMOS transistor connected in parallel. There are two control inputs to each transmission gates, one to the gate or control electrode of the NMOS transistor, and one to the gate or control electrode of the PMOS transistor.

Inputs of transmission gates 611132 and 611138 are connected to a first bias voltage line 611143. Inputs to transmission gates 611134 and 611136 are connected to a second bias voltage line 611145. Outputs of transmission gate 611132 and 611134 are connected to an OUT output 611147. Outputs of transmission gate 611136 and 611138 are connected to an NOUT output 611149. Digital data input 611114 control the transmission gates to pass the bias voltages as summarized in the following table C.

**Table C**

| Digital Data Input | OUT | NOUT |
|---|---|---|
| 0 | Second Bias Voltage | First Bias Voltage |
| 1 | First Bias Voltage I | Second Bias Voltage |

In a specific embodiment, the first bias voltage is about 0.2 volts above a reference voltage R and the second bias voltage is about R-0.2 volts. In this case, for a digital 0, the digital reference generator generates OUT and NOUT of R-0.2 volts and R+0.2 volts, respectively. For a digital 1, OUT and NOUT will be R+0.2 and R-0.2 volts, respectively. There will be a 0.4-volt difference OUT and NOUT. Reference voltage R will be in the middle, between the first and second bias voltages. These voltages at OUT and NOUT will correspond to, for example, the 3.5-volt and 6.5-volt stored threshold voltages for the memory cells. The write circuitry will perform the necessary level shifting to configure the memory cells properly.

For a differential analog signal path, the digital reference generator should provide a differential output consistent with this differential scheme. The OUT and NOUT outputs should be symmetrical about the reference voltage R, which is typically a signal ground. In a specific embodiment, the signal ground is about 1.23 volts, which may be generated using a bandgap reference generator. When a single-ended analog input is used, the digital reference generator circuitry may be appropriately modified to provide a single-ended output. For example, only an OUT or NOUT output will be provided.

Bias voltage generator circuit 611160 generates the first and second bias voltages 611143 and 611145. The circuitry includes transistors 611162, 611164, 611166, 611168, and 611170, connected in series between a positive supply voltage VDDA and a reference supply voltage VSSA. VDDA and VSSA are supply voltages for the analog circuits while VDDD and VSSD are supply voltages for the digital circuits. Typically, VDDA is about 3 volts and VSSA is ground. Separate digital and analog supply pins are provided to give some noise immunity between the digital and analog circuits. Noise from the digital circuits will not couple to the analog circuits, and vice versa. Transistors 611162 and 611164 are PMOS devices. Transistor 611162 has a gate connected to a VSP bias voltage and transistor 611164 has a gate connected to a VSPC bias voltage. Transistor 611166 is diode-connected NMOS device, connected between first bias voltage line 611143 and second bias voltage line 611145. Transistors 611168 and 611170 are NMOS devices. Transistor 611168 has a gate connected to a VSNC bias voltage and transistor 611170 has a gate connected to a VSN bias voltage.

In an implementation, transistor 611166 is a native type NMOS transistor, which means this device is not doped with a threshold adjust implant (or other implant) as are the other standard enhancement type NMOS transistors on the integrated circuit. The threshold voltage (VT) of a native NMOS device will be typically about 0.4 volts. In comparison, a standard NMOS device will have a VT typically about 0.7 volts. The VT of device 611166 provides the voltage difference between the output lines 611143 and 611145. A native device is used for transistor 611166 in order to obtain about a 0.4-volt difference between the two bias voltages 611143 and 611145. Depending on the particular implementation and the desired separation between the bias voltages, other types of devices, diodes, bias current level, and transistors with different VTs may be used in place of a native device. For example, if a 0.7-volt difference between bias voltages 611143 and 611145 were desired, a standard NMOS transistor may be used as a device 611166. Two or more transistors may be connected in series and placed between nodes 611143 and 611145 to give a greater voltage separation between the bias voltages. A 1.4-volt difference is obtained by using two standard NMOS transistors between nodes 611143 and 611145.

In an implementation, VSP will be about VDDA - VT, VSPC will be about VDD - 2*VT, VSNC will be about 2*VT above VSSA, and VSN will be about a VT above VSSA, where VT is the threshold voltage of an NMOS transistor. The VSP, VSPC, and VSNC voltages will be provided by a bias generator. This bias generator may be a slave bias generator in a master-slave bias voltage generating scheme, as discussed in U.S. provisional application 60/091,326. VSN may also be provided by a slave bias generator circuit.

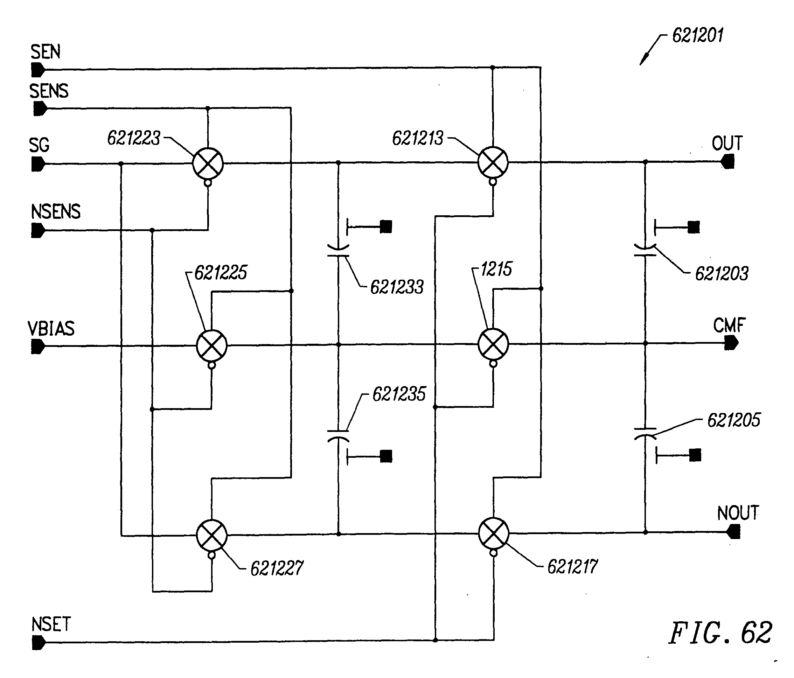

In an embodiment, the digital reference generator includes a common mode feedback (CMF) circuit 621201 such as shown in Figure 62. In such a case, VSN in Figure 61 is generated by the common mode feedback circuit. The common mode feedback circuit connects to OUT and NOUT of the digital data input circuit 611110 of Figure 61 as input to CMF circuit and generates output CMF, which connects to the VSN of Figure 61. The common mode feedback circuit regulates the OUT and NOUT voltage levels by feeding back and adjusting the VSN voltage. VSN is connected to the gate of transistor 611170, which acts like a current source. If changes occur at OUT and NOUT outputs of circuit 611110, the common mode feedback circuit adjusts VSN (i.e., control of the current source) to compensate so the bias voltages at 611143 and 611145 will be centered about the reference voltage R. By using common mode feedback, the digital reference generator will provide a consistent analog output with reference to a reference voltage R.

Common mode feedback circuit 621201 has an OUT and NOUT input that is connected to the OUT and NOUT output of Figure 61. CMF is an output connected to VSN (i.e., the gate of transistor 611170) of Figure 61. In circuit 621201, OUT and NOUT are connected to capacitors 621203 and 621205, respectively. Within an integrated circuit, there are many techniques of implementing a capacitor or a capacitance, and any of those techniques may be used to implement the capacitors or capacitances used in the circuitry of the present invention. Some techniques for implementing capacitors and capacitances include using parasitic capacitances, transistors, oxide capacitors, and diffusion capacitors, just to name a few. In this implementation capacitors 621213 and 621217 are about 0.8 picofarads. Other capacitors sizes may be used. Bigger capacitors sizes than 0.8 picofarads will speed up changes or adjustments in the CMF voltage during operation.

The common mode feedback circuitry further includes transmission gates 621213, 621215, 621217, 621223, 621225, and 621227. These transmission gates are connected to SET, SENS, NSENS, and NSET control inputs. The circuitry includes two more capacitors 621233 and 621235. Capacitors 621233 and 621235 are typically smaller than capacitors 621203 and 621205. For example, capacitors 621213 and 621217 are about 0.2 picofarads. A signal ground SG input is coupled through transmission gates 621223 and 621213 to OUT, and through transmission gates 621227 and 621217 to NOUT. A VBIAS input is connected through transmission gates 621225 and 621215 to CMF.

SG is a signal ground voltage. In an implementation, this is connected to a 1.23-volt bias voltage generated by a bandgap voltage generator. Other voltages may be selected to fit a particular application. SG is the R or center voltage about which bias voltages 611143 and 611145 will be centered. Typically, the same SG voltage is used for other circuits such as the write and read circuits on the integrated circuit to provide a consistent reference. For example, this will allow the digital reference generator to track similarly with the write circuit or level shifter up circuit and with read circuit or level shifter down circuit. The complete circuit system will reliably operate despite variations in operating conditions and process.

VBIAS is be a bias voltage of about VT (above VSSA). This voltage may be generated using a slave bias generator.

In operation, the common mode feedback circuit regulates and adjusts the CMF voltage based on OUT and NOUT inputs. SENS, NSENS, SET, and NSET are switch control inputs connected to clock signals. NSENS is the complementary signal of SENS, and NSET is the complementary signal of NSET. Consequently, transmission gates 621213, 621215, 621217, 621223, 621225, and 621227 are repeatedly switching based on the SENS, NSENS, SET, and NSET clock signals.

For proper operation, clock signals SENS and NSENS are nonoverlapping with respect to SET and NSET, respectively. This will prevent undesirable situations such as shorting of inputs. For example, it is undesirable for the SG input to electrically short to the OUT input. Nonoverlapping means that the clock signals will not be both in a particular logic state (e.g., high or low) at the same time that may short two different inputs. For example, it is desirable for both SENS and SET not to be high at the same time. Similarly, it is desirable for NSENS and NSET not to be low at the same time.

While SENS, NSENS, SET, and NSET are switching, node N2 will be common with N1 and N3. So, N2 will be at the SG voltage. Through switch 621215, N2 and CMF will be equalized. The common mode feedback circuit compensates for changes at OUT and NOUT of circuit 611110 of Figure 61 by adjusting CMF (VSN of Figure 61), which will ultimately adjusts the OUT and NOUT. First bias voltage 611143 and second bias voltage 611145 of bias voltage generator 611160, and in turn, the OUT and NOUT outputs will be centered around the SG voltage. This digital reference generator circuit with common mode feedback is efficient, robust, and reliable.

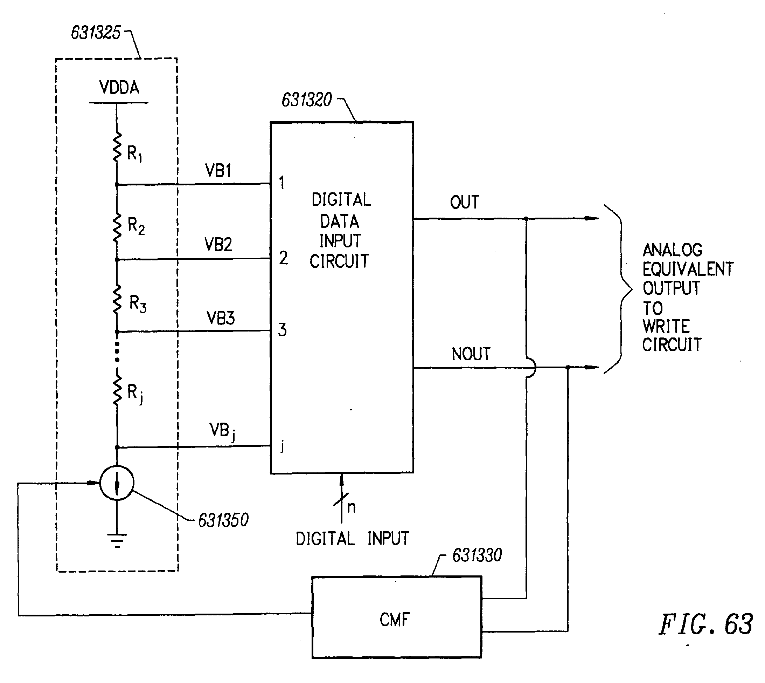

The scheme in Figures 61 and 62 shows the generation of analog equivalent for a single digital bit. Similar techniques are used to generate analog equivalent values for two or more bits of digital values. Figure 63 shows a diagram of circuitry for a digital reference generator with common mode feedback for a generalized number of digital bits n. For n digital bits, there will be 2" different analog equivalents. For example, for two bits, there will be four different analog equivalents that will be stored in a single analog memory cell. For three bits, there will be eight different analog equivalents. For eight bits, there will be 256 different analog equivalents.

The digital reference generator has a digital data input circuit 631320, bias voltage generator circuit 631325, and common mode feedback circuit 631330. Digital data input circuit 631320 receives n digital bits of input and a number of bias voltage inputs. Each of the bias voltage inputs is at a unique voltage level. Digital data input circuit 631320 generates the 2" different analog equivalent outputs at OUT and NOUT.

The number of different bias voltage inputs to circuit 631320 depends on the scheme used. For one scheme, similar to that described above for Figures 61 and 62, the voltages passed to OUT and NOUT will be selected from combinations of the bias voltage inputs 1 to j. For example, for three bits of digital input and j equal to 8, table D summarizes OUT and NOUT outputs and the bias voltage (BV) input at OUT and NOUT.

**Table D**

| Digital Data Input | OUT | NOUT |
|---|---|---|
| 000 | BV Input 4 | BV Input 5 |
| 001 | BV Input 3 | BV Input 6 |
| 010 | BV Input 2 | BV Input 7 |
| 011 | BV Input 1 | BV Input 8 |
| 100 | BV Input 5 | BV Input 4 |
| 101 | BV Input 6 | BV Input 3 |
| 110 | BV Input 7 | BV Input 2 |
| 111 | BV Input 8 | BV Input 1 |

Table D shows only one particular set of combinations of analog voltage equivalents. With eight different bias voltage inputs, many possible unique combinations (i.e., n * (n-1)) of analog equivalent voltages are possible. For three bias voltage inputs, there will be six different combinations. For four bias voltage inputs, there will be twelve different combinations. Although there are many unique combinations of analog voltage equivalents for a number of given bias voltage inputs, it is not necessarily desirable to use circuitry that minimizes the number of bias voltage inputs. It is generally desirable to select analog equivalent voltages to allow the most reliable storage of digital data in the analog memory cell. Therefore, it is desirable to select the analog equivalent voltages so the spacing of the stored threshold voltages for the memory cell will permit other circuitry to distinguish relatively easily between the different stored states. Also, the difference between on analog equivalent levels are spaced sufficiently from each other will maximize the longevity of the stored data in the cells. For example, charge leakage over time may alter the memory contents retrieved from the cells if the analog equivalent levels are spaced too closely together.

The implementation in table D uses analog equivalents where the voltages are the inverse of another. For example, the analog equivalents for digital data input 000 and 100 in table D are inverses of each other. It other implementations of the invention it may be desirable not to use analog equivalent voltages that are the inverse of another.

Bias generator 631325 generates bias voltages VB1 to VBj. The number j of bias voltages will vary depending on which analog equivalent voltage are selected. To generate j bias voltages, impedances R1 to Rj are connected in series with a current source 631350 between the supply voltages. This implementation is similar to the bias voltage generator circuit 611160 in Figure 61. The bias voltages VB1 to VBj are taken at taps between the impedances.

Impedances R1 to Rj can be implemented in one of the many techniques used to provide impedances on an integrated circuit, including the use of transistors, resistors, memory cells, and others. A programmable impedance such as discussed in U.S. patent application number 09/159,848, which is incorporated by reference, may be used. In an embodiment, the sizes of the impedances are the same. In another embodiment, in order to adjust the analog equivalent voltages as desired, the impedances may have different values.

As was discussed above, common mode feedback circuit 631330 is used to adjust the current source 631350 based on the OUT and NOUT voltages in order to keep the OUT and NOUT voltages centered about a signal ground.

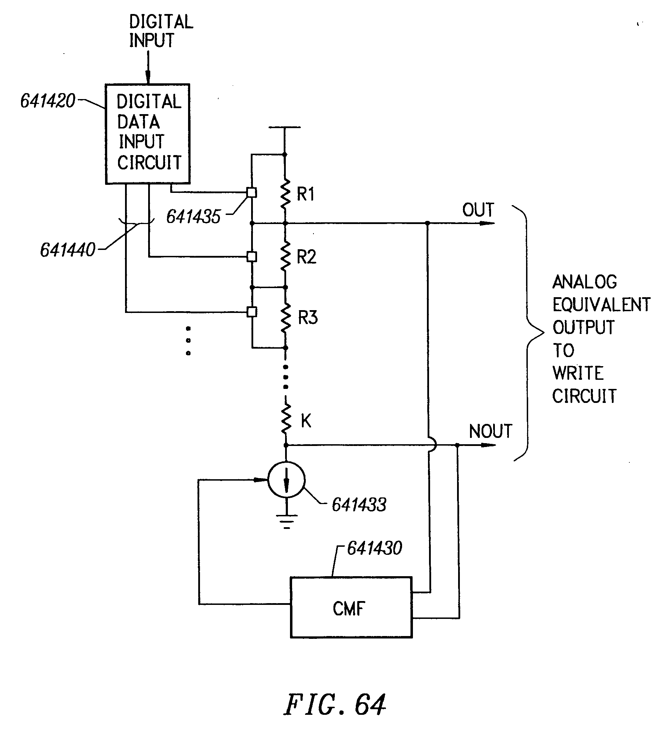

Figure 64 shows another implementation of a digital reference generator. The digital reference generator provides analog equivalent outputs OUT and NOUT that will be used by the write circuitry to store a digital value in the analog cell. This digital reference generator has a digital data input circuit 641420 and common mode feedback circuit 641430. A number of impedances R1 to Rn and a current source 641433 are connected in series between the supply voltages. In parallel with each resistor is a switch 641435. OUT and NOUT are taken from two taps in the impedance chain. There will be any number of impedances and parallel switches between OUT and NOUT. Also there may be impedances between OUT and NOUT without parallel switches, such as impedance K.

Each switch can be connected ("on") or disconnected ("off') depending on a control signal 641440 from a digital data input circuit 641420. When on, the switch shorts the impedance. Digital data input circuit 641420 receives a digital data input and generates an appropriate pattern for the control signals to determine which switches are on or off. Depending on whether particular switches are on or off, the value of the impedance between OUT and NOUT may be varied. Therefore, the voltage between OUT and NOUT is variable based on the digital data input. Using this technique, a number of analog equivalent voltages are generated.

The common mode feedback circuit 641430 operates as described above for the previous described digital reference generator implementation.

Impedances R1 to Rn are implemented using one of the many techniques for making impedances on an integrated circuit. Impedances R1 to Rn may be programmable impedances. In an implementation of the circuitry in Figure 64, the impedances are all the same value. In another implementation, the impedances have different values. The impedance values are weighted such as by using a binary weighting. By using weighted impedances, many different impedance values may be obtained by combining the appropriate impedances R1 to Rn.

Table E below summarizes an implementation of the technique of Figure 64. There are three impedances R1, R2, and R3, and the table shows the various combinations of impedances available to generate the different analog equivalent voltages. In this embodiment, there is a impedance K between the OUT and NOUT nodes. Even when all the impedances R1, R2, and R3 are shorted out, there will be a resistance K between OUT and NOUT.

**Table E**

| Digital Data Input | Impedance Between OUT and NOUT |
|---|---|
| 000 | R1 + K |
| 001 | R2 + K |
| 010 | R3 + K |
| 011 | R1 + R2 + K |
| 100 | R1 + R3 + K |
| 101 | R2 + R3 + K |
| 110 | R1 + R2 + R3 + K |
| 111 | K |

This detailed description of the invention has been presented for the purposes of illustration and description. It is not intended to be exhaustive or to limit the invention to the precise form described, and many modifications and variations are possible in light of the teaching above. The embodiments were chosen and described in order to best explain the principles of the invention and its practical applications. This detailed description will enable others skilled in the art to best utilize and practice the invention in various embodiments and with various modifications as are suited to the particular use contemplated. The scope of the invention is defined by the following claims.

Further preferred embodiments are set out in the following clauses.
1. A method of storing information in a memory comprising:
   providing an analog signal at an analog signal input;
   providing digital data at a digital signal input;
   sampling the analog signal input at a user-selected sampling frequency;
   storing samples of the analog signal in an array of memory cells, wherein a memory cell holds at least one sample of the analog signal; and
   storing the digital data in the array of memory cells, wherein a memory cell holds at least a bit of the digital data.
2. The method of clause 1 wherein each memory cell in the array capable of storing analog data from the analog signal input is capable of storing digital data from the digital signal input.
3. An integrated circuit comprising:
   an array of memory cells;
   a write circuit to store information provided at an analog input and a digital input of the integrated circuit into the memory cells, wherein the information provided at the analog input is in an analog form and at the digital input is in digital form; and
   a multiplexer to selectively couple the analog input to the write circuit or the digital input to the write circuit, wherein information provided at the analog input is sampled at a sampling frequency and each sample is stored in one memory cell.
4. The integrated circuit of clause 3 wherein the memory cells are analog or multilevel memory cells.
5. An integrated circuit comprising:
   a plurality of memory cells;
   a write circuit coupled to the memory cells; and
   a read circuit to determine a threshold voltage stored in individual memory cells, and to provide an analog equivalent of the stored threshold voltage at an analog output or to provide a digital equivalent of the stored threshold voltage at a digital output, wherein individual memory cells are configurable by the write circuit to store more than two different threshold voltage levels.
6. An integrated circuit comprising:
   an array of multilevel memory cells;
   a write circuit coupled to store data in the array of multilevel memory cells;
   a digital reference generator, receiving digital data and converting the digital data into an analog equivalent form, wherein the analog equivalent form is provided to the write circuit, and
   the digital reference generator comprises:
   a bias voltage generator generating a plurality of bias voltages; and
   a digital data input circuit generating the analog equivalent form of the digital data by selecting combinations of the plurality of bias voltages.
7. The method of clause 1 wherein every memory cell in a sector of the array of memory cells is written with a digital value.
8. A method of storing information in a memory comprising:
   providing an analog signal at an analog signal input;
   providing digital data at a digital signal input;
   sampling the analog signal input at a sampling frequency;
   storing samples of the analog signal in an array of memory cells, wherein a memory cell holds at least one sample of the analog signal; and
   storing the digital data in the array of memory cells, wherein a memory cell holds at least a bit of the digital data, wherein storing the digital data comprises:
   erasing a sector of memory cells;
   writing the digital data in the sector of memory cells; and
   writing a digital value in each memory cell of the sector not written with the digital data.
9. The method of clause 8 wherein a memory cell holds at least two bits of the digital data.
10. A method of operating an integrated circuit comprising:
   providing an analog signal input;
   taking a sample of the analog signal input wherein the analog signal is sampled at a user selectable sampling frequency;
   generating a first voltage above the sample input by a first offset value;
   generating a second voltage above the sample by a second offset value;
   pulsing a node of a memory cell using the first voltage;
   evaluating a threshold voltage of the memory cell using the second voltage, wherein the second voltage is coupled to a control electrode of the memory cell;
   pulsing and evaluating the memory cell until the threshold voltage of the memory cell is at a target value.
11. The integrated circuit of clause 10 wherein the first offset value is programmably selectable by configuring trim bit memory cells on the integrated circuit.
12. The integrated circuit of clause 11 wherein the second offset value is programmably selectable by configuring the trim bit memory cells on the integrated circuit.
13. A method of operating an integrated circuit comprising:
   determining a stored threshold voltage of a memory cell by varying a voltage at a control electrode of the memory cell until the memory cell changes from a first state to a second state; and
   using the stored threshold voltage, generating a playback output voltage, below the stored threshold voltage by an offset value.
14. The method of clause 13 wherein the offset value is programmably selectably by configuring a trim bit.
15. An integrated circuit comprising:
   an array of analog memory cells;
   a write circuit to store information into the memory cells;
   a read circuit to retrieve information stored in the memory cells; and
   an internal oscillator capable of generating a clock output of variable frequencies for use by the write circuit, wherein a frequency of the variable clock output depends on an internally stored user value.
16. The integrated circuit of clause 15 further comprising:
   an external clock source input; and
   a selection circuit to select the internal oscillator or external clock source as a sampling frequency source for the write circuit.
17. The integrated circuit of clause 15 wherein the write circuit samples an input signal using a sampling frequency based on the clock output and stores samples of the input signal in the memory array.
18. The integrated circuit of clause 16 wherein the write circuit samples an input signal using a sampling frequency based on the clock output and stores samples of the input signal in the memory array.
19. The integrated circuit of clause 15 further comprising:
   an external clock source input;
   an activity detector circuit to determine whether an external clock signal is being supplied at the external clock source input; and
   a selection circuit to select the internal oscillator or the external clock source input as a sampling frequency for the write circuit, wherein when the activity detector circuit determines an external clock signal is being supplied, the external clock source input is selected.
20. A clock selection circuit for an integrated circuit comprising:
   an external clock input;
   an internal oscillator;
   a prescaler coupled to the external clock input;
   an internal clock divider coupled to the internal oscillator;
   a selection circuit coupled to select one of an output from the prescaler or an output of the internal clock divider; and
   an activity detector to detect a clock signal at the external clock input, and when a clock signal is detected at the external clock input, provide a signal to the selection circuit to select the output from the prescaler.
21. A method of operating an integrated circuit comprising:
   providing an input waveform to the integrated circuit;
   selecting a sampling frequency for sampling the input waveform by storing a user value in the integrated circuit;
   sampling the input waveform;
   sampling the input waveform at the selected sampling frequency; and
   storing samples of the input waveform in memory cells of the integrated circuit.
22. The method of clause 21 wherein the sampling frequency is generated within the integrated circuit.
23. A method of operating an integrated circuit comprising:
   detecting an external voltage to the integrated circuit to determine whether the external voltage is above or below a threshold value;
   when the external voltage is below the threshold value, generating a programming voltage using a first number of charge pump stages; and
   when the external voltage is above the threshold value, generating the programming voltage using a second number of charge pump stages, wherein the second number of charge pump stages is less than the first number of charge pump stages.
24. A method of operating an integrated circuit comprising:
   detecting an external voltage to the integrated circuit to determine whether the external voltage is above or below a first threshold level and above or below a second threshold level, wherein the second threshold level is above the first threshold level;
   when the external voltage is below the first threshold level, generating a programming voltage using a first number of charge pump stages;
   when the external voltage is above the first threshold level and below the second threshold level, generating the programming voltage using a second number of charge pump stages;
   when the external voltage is above the second threshold level, generating the programming voltage using a third number of charge pump stages, wherein the first number of charge pump stages is greater than the second number of charge pump stages, and the second number of charge pump stages is greater than the third number of charge pump stages.
25. An integrated circuit comprising:
   a first voltage detect circuit of a first threshold level;
   a second voltage detect circuit of a second threshold level;
   a third voltage detect circuit of a third threshold level;
   a logic circuit, coupled to outputs of the first, second, and third voltage detect circuits, generating a plurality of enable outputs; and
   a charge pump circuit comprising a plurality of stages, wherein based on the enable outputs, a number of stages of the charge pump are enabled.
26. The integrated circuit of clause 25 wherein the first voltage detect circuit comprises:
   a first transistor coupled between a first voltage detect output node and first terminals of a first and a second capacitor, wherein a control electrode of the first transistor is coupled to a clock signal;
   a second transistor coupled between the first voltage detect output node and the first terminals of the first and second capacitors, wherein a control electrode of the second transistor is coupled to the clock signal;
   a first switch circuit coupled between an external voltage input and a second terminal of the first capacitor; and
   a second switch circuit coupled between a reference voltage input and a second terminal of the second capacitor.
27. The integrated circuit of clause 26 further comprising:
   a third transistor and fourth transistor coupled in series between an external supply voltage and the first voltage detect output node; and
   a fifth transistor coupled between an external reference voltage and the first voltage detect output node.
28. The integrated circuit of clause 26 further comprising:
   a latch coupled to store a signal at the first voltage detect output node.

## Claims

1. An integrated circuit comprising:
a programmable level shifter circuit receiving a sample of an analog signal input to the integrated circuit, wherein the level shifter circuit generates a level shifter voltage output above a voltage of the sample by an offset voltage, wherein the offset voltage is programmably selectable; and
an array of analog memory cells, wherein the level shifter voltage output is coupled to a memory cell to configure the memory cell to store the sample.

2. The integrated circuit of claim 1 wherein the level shifter comprises:
an operational amplifier comprising V_{IN}-and V_{IN+} inputs and a V_{OUT} output, wherein the V_{OUT} output is coupled to the level shifter output;
a first capacitor coupled between a first differential input of the analog signal input and V_{IN-};
a second capacitor coupled between a second differential input of the analog signal input and V_{IN-};
a third capacitor coupled between V_{OUT} and V_{IN-}; and
a fourth capacitor coupled between V_{OUT} and V_{IN-}.

3. The integrated circuit of claim 2 wherein the level shifter further comprises:
a fifth capacitor, programmably coupled between the first differential input of the analog signal input and V_{IN-}.

4. The integrated circuit of claim 3 wherein the fifth capacitor is coupled or decoupled depending on the state of a memory cell.

5. The integrated circuit of claim 2 wherein the level shifter comprises:
a plurality of capacitors programmably coupled in parallel to the first capacitor, each of the capacitors having a different capacitance.

6. An integrated circuit comprising:
a programmable level shifter comprising an operational amplifier generating a level shifter output wherein an offset voltage between the level shifter output and an analog input depends on a value of capacitance coupled between the analog input and an operational amplifier input, wherein the value of the capacitance is programmably selectable;
an array of memory cells, wherein the level shifter output is coupled to configure a memory cell to store the analog input.

7. An integrated circuit comprising:
a first programmable level shifter providing a VPP output voltage that is a first offset voltage above an analog input, wherein the first offset voltage is programmably selectable;
a second programmable level shifter providing a target VT output voltage that is a second offset voltage above the analog input, wherein the second offset voltage is programmably selectable; and
a memory cell to store the analog input, wherein the VPP output voltage and the target VT output voltage are coupled to the memory cell.

8. An integrated circuit comprising:
an analog data differential input;
a preamplifier circuit coupled to amplify an analog signal at the analog data differential input with a first gain, wherein an amplified output signal is provided at a first differential output;
a low pass filter circuit coupled to the preamplifier differential output, wherein the low pass filter circuit provides samples of the analog signal at a second differential output;
a first level shifter circuit coupled to the second differential output, wherein the first level shifter circuit performs a sample and hold operation, an amplification, and a voltage shift, which results in a first level shifter output signal at a first offset voltage above a level of a sample at the second differential output; and
an array of analog memory cells, wherein the first level shifter output is coupled to the array of memory cells.

9. The integrated circuit of claim 8 further comprising:
a second level shifter circuit coupled to the second differential output, wherein a second level shifter circuit performs a sample and hold operation, an amplification, and a voltage shift, which results in a second level shifter output signal at a second offset voltage above the level of the sample at the second differential output, and the second level shifter output is coupled to the array of memory cells.

10. The integrated circuit of claim 8 wherein the low pass filter circuit is a sampled data filter.

11. The integrated circuit of claim 8 wherein the first level shifter circuit comprises:
an operational amplifier comprising a positive input, a negative input, and a positive output;
a first capacitance coupled between the negative input and a first node;
a first switch coupled between the first node and a first output node of the second differential output, wherein the first switch is controlled by a first clock signal;
a second switch coupled between the first node and a signal ground, wherein the second switch is controlled by a second clock signal, and the first and second clock signals are nonoverlapping;
a second capacitance coupled between the positive input and a second node;
a third switch coupled between the second node and a second output node of the second differential output, wherein the third switch is controlled by the first clock signal; and
a fourth switch coupled between the second node and the signal ground, wherein the fourth switch is controlled by the second clock signal.

12. The integrated circuit of claim 11 wherein the first level shifter circuit further comprises:
a fifth switch coupled between the positive output and a third node, wherein the fifth switch is controlled by the second clock signal;
a third capacitance coupled between the third node and the negative input;
a fourth capacitance coupled between the positive output and a fourth node; and
a sixth switch coupled between the negative input and the fourth node, wherein the sixth switch is controlled by the first clock signal.

13. The integrated circuit of claim 12 wherein the first level shifter further comprises:
a seventh switch coupled between the fourth node and the signal ground, wherein the seventh switch is controlled by the second clock signal; and
an eighth switch coupled between the third node and the signal ground, wherein the eighth switch is controlled by the first clock signal.

14. The integrated circuit of claim 8 further comprising:
a programmable internal oscillator coupled to the low pass filter circuit, wherein the programmable internal oscillator generates a sampling clock at a sampling frequency selected by a user of the integrated circuit.

15. An integrated circuit comprising:
an array of analog memory cells;
a ramp circuit coupled to a memory cell of the array, wherein the ramp circuit determines a stored threshold voltage of the memory cell; and
a playback level shifter coupled to a ramp output of the ramp circuit, wherein the playback level shifter provides a first differential output coupled to an output of the integrated circuit.

16. The integrated circuit of claim 15 further comprising:
an output amplifier coupled to the first differential output;
a squelch circuit providing a squelch signal to the output amplifier when the first differential output is below a threshold value, wherein based on the squelch signal, the output amplifier provides an attenuated signal.

17. The integrated circuit of claim 16 wherein the squelch circuit comprises a peak detector circuit, a zero crossing detector circuit, and a comparator circuit.

18. The integrated circuit of claim 8 further comprising:
a master bias generator generating a master bias voltage;
a first slave bias generator generating a first slave bias output coupled to the preamplifier circuit, wherein the master bias voltage is coupled to an input of the first slave bias generator; and
a second slave bias generator generating a second slave bias voltage output coupled to the low pass filter circuit, wherein the master bias voltage is coupled to an input of the second slave bias voltage generator.

19. The integrated circuit of claim 18 wherein the first and second slave bias generator also have enable inputs.

20. The integrated circuit of claim 18 further comprising:
a third slave bias generator generating a third slave bias voltage output coupled to the first level shifter circuit, wherein the master bias voltage is coupled to an input of the third slave bias voltage generator.

21. The integrated circuit of claim 8 wherein the first level shifter output is coupled to a row line of the memory cells.

22. The integrated circuit of claim 9 wherein the second level shifter output is coupled to a row line of the memory cells.

23. An integrated circuit comprising:
a preamplifier circuit;
a low pass filter circuit coupled to the preamplifier circuit;
a first level shifter coupled to the low pass filter;
a second level shifter coupled to the low pass filter;
an array of memory cells coupled to the first and second level shifters;
a master bias generator generating a master bias voltage; and
a plurality of slave bias generators, each coupled to the master bias voltage, wherein a first slave bias generator is coupled to the preamplifier circuit, a second slave bias generator is coupled to the first and second level shifters, and the slave bias generators each have an enable input.

24. The integrated circuit of claim 23 further comprising:
a ramp circuit coupled to the memory cells;
a third level shifter coupled to the ramp circuit;
an output amplifier circuit coupled to the ramp circuit, wherein the plurality of slave bias generators further comprises a third slave bias generator coupled to the ramp circuit and a fourth slave bias circuit coupled to the third level shifter.
